(19) Europäisches Patentamt / European Patent Office / Office européen des brevets

(11) EP 3 189 551 B1

(12) **EUROPÄISCHE PATENTSCHRIFT**

(45) Veröffentlichungstag und Bekanntmachung des Hinweises auf die Patenterteilung:
**27.01.2021 Patentblatt 2021/04**

(21) Anmeldenummer: **15750244.4**

(22) Anmeldetag: **04.08.2015**

(51) Int Cl.:
***H01L 51/54*** *(2006.01)* ***C11D 3/43*** *(2006.01)*

(86) Internationale Anmeldenummer:
**PCT/EP2015/001601**

(87) Internationale Veröffentlichungsnummer:
**WO 2016/034262 (10.03.2016 Gazette 2016/10)**

(54) **FORMULIERUNGEN UND VERFAHREN ZUR HERSTELLUNG EINER ORGANISCHEN ELEKTROLUMINESZENZVORRICHTUNG**

FORMULATIONS AND METHOD OF PRODUCING AN ORGANIC ELECTROLUMINESCENT DEVICE

FORMULATIONS ET PROCÉDÉ DE FABRICATION D'UN DISPOSITIF ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.09.2014 EP 14003076**

(43) Veröffentlichungstag der Anmeldung:
**12.07.2017 Patentblatt 2017/28**

(73) Patentinhaber: **Merck Patent GmbH**
**64293 Darmstadt (DE)**

(72) Erfinder:
- **STOESSEL, Philipp**
  **60389 Frankfurt am Main (DE)**
- **MARTYNOVA, Irina**
  **64347 Griesheim (DE)**
- **LUDEMANN, Aurélie**
  **60322 Frankfurt am Main (DE)**
- **KLUGE, Edgar**
  **64521 Gross-Gerau (DE)**
- **KOENEN, Nils**
  **64347 Griesheim (DE)**

(56) Entgegenhaltungen:
**EP-A1- 3 069 392** **WO-A1-2013/029733**
**WO-A1-2015/070944**

EP 3 189 551 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung betrifft Formulierungen zur Herstellung von organischen Elektrolumineszenzvorrichtungen. Weiterhin betrifft die vorliegende Erfindung Verfahren zur Herstellung von organischen Elektrolumineszenzvorrichtungen.

Elektronische Vorrichtungen, welche organische, metallorganische und/oder polymere Halbleiter enthalten, gewinnen zunehmend an Bedeutung, wobei diese aus Kostengründen und aufgrund ihrer Leistungsfähigkeit in vielen kommerziellen Produkten eingesetzt werden. Als Beispiele seien hier Ladungstransportmaterialien auf organischer Basis (z.B. Lochtransporter auf Triarylamin-Basis) in Kopiergeräten, organischen oder polymeren Leuchtdioden (OLEDs oder PLEDs) und in Anzeige- und Displayvorrichtungen oder organische Photorezeptoren in Kopierern genannt. Organische Solarzellen (O-SC), organische FeldeffektTransistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen.

Viele dieser elektronischen Vorrichtungen weisen unabhängig von dem jeweiligen Verwendungszweck folgenden allgemeinen Schichtaufbau auf, der für die jeweilige Anwendung angepasst werden kann:

(1) Substrat,
(2) Elektrode, häufig metallisch oder anorganisch, aber auch aus organischen bzw. polymeren, leitfähigen Materialien,
(3) Ladungsinjektionsschicht/en bzw. Zwischenschicht/en, beispielsweise zum Ausgleich von Unebenheiten der Elektrode ("planarisation layer"), häufig aus einem leitfähigen, dotierten Polymer,
(4) organische Halbleiter,
(5) evtl. weitere Ladungstransport-, Ladungsinjektions- bzw. Ladungsblockierschichten,
(6) Gegenelektrode, Materialien wie unter (2) genannt,
(7) Verkapselung.

Die obige Anordnung stellt den allgemeinen Aufbau einer organischen, elektronischen Vorrichtung dar, wobei verschiedene Schichten zusammengefasst werden können, so dass im einfachsten Fall eine Anordnung aus zwei Elektroden resultiert, zwischen denen sich eine organische Schicht befindet. Die organische Schicht erfüllt in diesem Fall alle Funktionen, einschließlich der Emission von Licht im Fall von OLEDs. Ein derartiges System wird beispielsweise in der WO 90/13148 A1 auf der Basis von Poly-(p-phenylenen) beschrieben.

Ein Problem, das sich in einem derartigen "Dreischichtsystem" ergibt, ist jedoch die fehlende Steuerung der Ladungstrennung und/oder die fehlende Möglichkeit, die einzelnen Bestandteile in unterschiedlichen Schichten bezüglich ihrer Eigenschaften zu optimieren, wie es beispielsweise bei SMOLEDs ("small-molecule OLEDs") durch einen mehrschichtigen Aufbau einfach gelöst ist.

Eine "small molecule OLED" umfasst vielfach eine oder mehrere organische Lochinjektionsschichten, Lochtransportschichten, Emissionsschichten, Elektronentransportschichten und/oder Elektroneninjektionsschichten sowie eine Anode und eine Kathode, wobei sich das ganze System gewöhnlich auf einem Glassubstrat befindet. Der Vorteil einer solchen Mehrlagenstruktur besteht darin, dass die verschiedenen Funktionen der Ladungsinjektion, des Ladungstransports und der Emission auf die verschiedenen Schichten verteilt und somit die Eigenschaften der jeweiligen Schichten separat modifiziert werden können. Durch diese Modifikation kann die Leistungsfähigkeit der elektronischen Vorrichtungen stark verbessert werden.

Nachteilig an elektronischen Vorrichtungen, die auf den zuvor beschriebenen "small molecules", also niedermolekularen Verbindungen beruhen, ist deren Herstellung. Üblicherweise werden niedermolekulare Verbindungen über Verdampfungstechniken zu elektronischen Vorrichtungen verarbeitet. Dies stellt vor allem für großflächige Vorrichtungen einen großen Kostennachteil dar, da ein mehrstufiger Vakuumprozeß in verschiedenen Kammern sehr kostenintensiv ist und sehr genau gesteuert werden muss. Hier wären kostengünstigere und etablierte Beschichtungsverfahren aus Lösung wie z.B.Tintenstrahldruck, Airbrushverfahren, Rolle-zu-Rolle-Prozesse, usw., von großem Vorteil.

So werden beispielsweise in der WO2009/021107 A1, WO2013/029733 A1, EP3069392 A1 und in der WO 2010/006680 A1 organische Verbindungen beschrieben, die zur Herstellung von elektronischen Vorrichtungen geeignet sind, wobei diese Verbindungen sowohl über Gasphasenabscheidung als auch aus Lösung verarbeitet werden können. Allerdings zeigen die elektronischen Vorrichtungen, die über Gasphasenabscheidung erhalten werden, ein günstigeres Eigenschaftsprofil.

Bekannte Verfahren zur Herstellung von elektronischen Vorrichtungen weisen ein brauchbares Eigenschaftsprofil auf. Allerdings besteht die dauerhafte Notwendigkeit, die Eigenschaften dieser Verfahren zu verbessern.

Insbesondere sollte das Verfahren kostengünstig in der Durchführung sein. Weiterhin sollte das Verfahren zur Herstellung von sehr kleinen Strukturen geeignet sein, so dass hochauflösende Bildschirme durch das Verfahren erhältlich sind. Weiterhin sollte das Verfahren unter Verwendung von gängigen Druckverfahren durchgeführt werden

können.

Diese Vorteile sollten einzeln oder gemeinsam erreicht werden. Ein wesentlicher Gesichtspunkt ist hierbei, dass die durch das Verfahren erhältlichen elektronischen Vorrichtungen ausgezeichnete Eigenschaften aufweisen sollten.

Zu diesen Eigenschaften gehört insbesondere die Lebensdauer der elektronischen Vorrichtungen. Ein weiteres Problem stellt insbesondere die Energieeffizienz dar, mit der eine elektronische Vorrichtung die vorgegebene Aufgabe löst. Bei organischen Leuchtdioden, die sowohl auf niedermolekularen Verbindungen als auch auf polymeren Materialien basieren können, sollte insbesondere die Lichtausbeute hoch sein, so dass zum Erreichen eines bestimmten Lichtflusses möglichst wenig elektrische Leistung aufgebracht werden muss. Weiterhin sollte auch zum Erzielen einer vorgegebenen Leuchtdichte eine möglichst geringe Spannung notwendig sein. Demgemäß sollten diese Eigenschaften durch das Verfahren nicht nachteilig beeinflusst werden.

Weiterhin sollten die elektronischen Vorrichtungen für viele Zwecke eingesetzt und/oder angepasst werden können. Insbesondere sollte die Leistungsfähigkeit der elektronischen Vorrichtungen über einen breiten Temperaturbereich erhalten bleiben.

Eine weitere Aufgabe kann darin gesehen werden, elektronische Vorrichtungen mit einer ausgezeichneten Leistungsfähigkeit möglichst kostengünstig und in konstanter Qualität bereitzustellen.

Überraschenderweise wurde gefunden, dass diese sowie weitere nicht explizit genannte Aufgaben, die jedoch aus den hierin einleitend diskutierten Zusammenhängen ohne Weiteres ableitbar oder erschließbar sind, durch Formulierungen mit allen Merkmalen des Patentanspruchs 1 gelöst werden. Zweckmäßige Abwandlungen der erfindungsgemäßen Formulierungen werden in den auf Anspruch 1 rückbezogenen abhängigen Ansprüchen unter Schutz gestellt.

Gegenstand der vorliegenden Erfindung ist dementsprechend eine Formulierung umfassend mindestens ein niedermolekulares, organisches Matrixmaterial und mindestens einen niedermolekularen Emitter, ausgewählt aus fluoreszierenden und phosphoreszierenden Emittern, welche ein Molekulargewicht von ≤ 3.000 g/mol aufweisen und welche zur Herstellung von emittierenden Schichten organischer Elektrolumineszenzvorrichtungen einsetzbar sind, und mindestens eine aromatische Verbindung als Lösungsmittel mit einer Struktur der Formeln (1) oder (2

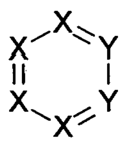

Formel (1)

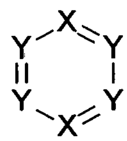

Formel (2)

wobei für die verwendeten Symbole gilt:

X ist bei jedem Auftreten gleich oder verschieden CR oder N, wobei insgesamt höchstens 2 Reste X für N stehen;

R ist bei jedem Auftreten gleich oder verschieden H, D, F, $N(R^1)_2$, CN, $NO_2$, $C(=O)N(R^1)_2$, $Si(R^1)_3$, $C(=O)R^1$, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten $R^1$ substituiert sein kann, wobei eine oder mehrere nicht benachbarte $CH_2$-Gruppen durch $R^1C=CR^1$, C≡C, $Si(R^1)_2$, C=O, $NR^1$, O, S oder $CONR^1$ ersetzt sein können und wobei ein oder mehrere H-Atome durch D, F, $NO_2$ oder CN ersetzt sein können, oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 40 aromatischen Ringatomen, die durch einen oder mehrere Reste $R^1$ substituiert sein kann, oder eine Aralkyl- oder Heteroaralkylgruppe mit 5 bis 40 aromatischen Ringatomen, die durch einen oder mehrere Reste $R^1$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^1$ substituiert sein kann; dabei können zwei benachbarte Reste R auch miteinander ein mono- oder polycyclisches, aliphatisches, aromatisches oder heteroaromatisches Ringsystem bilden;

$R^1$ ist bei jedem Auftreten gleich oder verschieden H, D, F, $N(R^2)_2$, CN, $NO_2$, $Si(R^2)_3$, $C(=O)R^2$, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten $R^2$ substituiert sein kann, wobei eine oder mehrere nicht benachbarte $CH_2$-Gruppen durch $R^2C=CR^2$, C=C, $Si(R^2)_2$, C=O, $NR^2$, O, S oder $CONR^2$ ersetzt sein können und wobei ein

oder mehrere H-Atome durch D, F, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 40 aromatischen Ringatomen, die durch einen oder mehrere Reste $R^2$ substituiert sein kann, oder eine Aralkyl- oder Heteroaralkylgruppe mit 5 bis 40 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann; dabei können zwei oder mehrere benachbarte Reste $R^1$ miteinander oder $R^1$ mit R ein mono- oder polycyclisches, aliphatisches, aromatisches oder heteroaromatisches Ringsystem bilden;

$R^2$ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^2$ auch miteinander ein mono- oder polycyclisches, aliphatisches Ringsystem bilden;

Y ist bei jedem Auftreten gleich oder verschieden eine Gruppe CR,

welche dadurch gekennzeichnet ist, dass
in der Struktur der Formeln (1) oder (2) die benachbarten Gruppen Y zusammen einen Ring gemäß einer der folgenden Formeln (3), (4), (5), (6), (7), (8) oder (9) aufspannen,

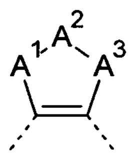

Formel (3)

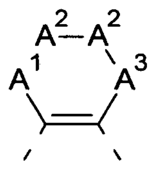

Formel (4)

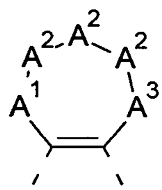

Formel (5)

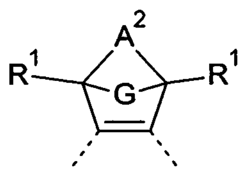

Formel (6)

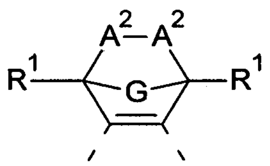

Formel (7)

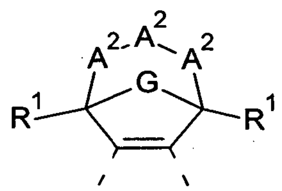

Formel (8)

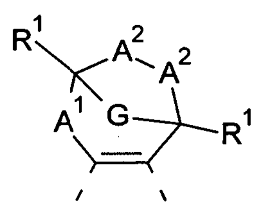

Formel (9)

wobei $R^1$ die zuvor genannte Bedeutung aufweist, die gestrichelten Linien die Bindung der beiden Kohlenstoffatome der Gruppe Y zu den Resten X des aromatischen oder heteroaromatischen Rings in der Struktur gemäß Formel (1) oder Formel (2) darstellen und weiterhin gilt:

$A^1$, $A^3$ ist gleich oder verschieden bei jedem Auftreten $C(R^3)_2$, O, S, $NR^3$ oder C(=O);

$A^2$ ist $C(R^1)_2$, O, S, $NR^3$ oder C(=O);

G ist eine Alkylengruppe mit 1, 2 oder 3 C-Atomen, welche mit einem oder mehreren Resten $R^2$ substituiert sein kann, $-CR^2=CR^2-$ oder eine ortho-verknüpfte Arylen- oder Heteroarylengruppe mit 5 bis 14 aromatischen Ringatomen, welche durch einen oder mehrere Reste $R^2$ substituiert sein kann;

$R^3$ ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils mit einem oder mehreren Resten $R^2$ substituiert sein kann, wobei eine oder mehrere nicht benachbarte $CH_2$-Gruppen durch $R^2C=CR^2$, C=C, $Si(R^2)_2$, C=O, $NR^2$, O, S oder $CONR^2$ ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste $R^2$ substituiert sein kann, oder eine Aryloxy- oder Heteroaryloxygruppe mit 5 bis 24 aromatischen Ringatomen, die durch einen oder mehrere Reste $R^2$ substituiert sein kann, oder eine Aralkyl- oder Heteroaralkylgruppe mit 5 bis 24 aromatischen Ringatomen, die durch einen oder mehrere Reste $R^2$ substituiert sein kann; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden;

mit der Maßgabe, dass in den zuvor genannten Gruppen nicht zwei gleiche Heteroatome direkt aneinander gebunden sind und nicht zwei Gruppen C=O direkt aneinander gebunden sind.

In den oben abgebildeten Strukturen der Formeln (1) oder (2) sowie den weiteren als bevorzugt genannten Ausführungsformen dieser Strukturen wird formal eine Doppelbindung an den Kohlenstoffatomen abgebildet, an die die Reste Y binden. Dies stellt eine Vereinfachung der chemischen Struktur dar, da diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist dem Fachmann offensichtlich, dass hiermit eine aromatische Bindung gemeint ist.

Die Abwesenheit von aziden benzylischen Protonen wird in den Formeln (3) bis (5) dadurch erreicht, dass $A^1$ und $A^3$, wenn diese für $C(R^3)_2$ stehen, so definiert sind, dass $R^3$ ungleich Wasserstoff ist. Die Abwesenheit von aziden benzylischen Protonen ist in den Formeln (6) bis (9) dadurch erreicht, dass es sich dabei um eine bicyclische Struktur handelt. Aufgrund der starren räumlichen Anordnung ist $R^1$, wenn es für H steht, deutlich weniger azide als benzylische Protonen, da das korrespondierende Anion der bicyclischen Struktur nicht mesomeriestabilisiert ist. Auch wenn $R^1$ in Formeln (6) bis (9) für H steht, handelt es sich dabei um ein nicht-azides Proton im Sinne der vorliegenden Anmeldung.

Dabei bedeutet "benachbarte Kohlenstoffatome", dass die Kohlenstoffatome direkt aneinander gebunden sind. Weiterhin bedeutet "benachbarte Reste" in der Definition der Reste, dass diese Reste an dasselbe Kohlenstoffatom oder an benachbarte Kohlenstoffatome gebunden sind. Diese Definitionen gelten entsprechend unter anderem für die Begriffe "benachbarte Gruppen" und "benachbarte Substituenten".

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer $C_1$- bis $C_{40}$-Alkylgruppe, in der auch einzelne H-Atome oder $CH_2$-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl, 1,1-Dimethyl-n-hept-1-yl, 1,1-Dimethyln-oct-1-yl, 1,1-Dimethyl-n-dec-1-yl, 1,1-Dimethyl-n-dodec-1-yl, 1,1-Dimethyl-n-tetradec-1-yl, 1,1-Dimethyl-n-hexadec-1-yl, 1,1-Dimethyl-n-octadec-1-yl, 1,1-Diethyl-n-hex-1-yl, 1,1-Diethyl-n-hept-1-yl, 1,1-Diethyl-n-oct-1-yl, 1,1-Diethyl-n-dec-1-yl, 1,1-Diethyl-n-dodec-1-yl, 1,1-Diethyl-n-tetradec-1-yl, 1,1-Diethyln-n-hexadec-1-yl, 1,1-Diethyl-n-octadec-1-yl, 1-(n-Propyl)-cyclohex-1-yl, 1-(n-Butyl)-cyclohex-1-yl, 1-(n-Hexyl)-cyclohex-1-yl, 1-(n-Octyl)-cyclohex-1-yl und 1-(n-Decyl)-cyclohex-1-yl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl und Cyclooctadienyl verstanden. Unter einer Alkinylgruppe werden beispielsweise Ethinyl, Propinyl, Butinyl, Pentinyl, Hexinyl, Heptinyl und Octinyl verstanden. Unter einer $C_1$- bis $C_{40}$-Alkoxygruppe werden beispielsweise Methoxy, Trifluormethoxy, Ethoxy, n-Propoxy, i-Propoxy, n-Butoxy, i-Butoxy, s-Butoxy, t-Butoxy und 2-Methylbutoxy verstanden.

Unter einem aromatischen oder heteroaromatischen Ringsystem mit 5 bis 60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Weiterhin sind Verbindungen gemäß Formel (1) oder (2) bevorzugt, in denen in deren Ringstrukturen gemäß einer der Formeln (3), (4), (5), (6), (7), (8) oder (9) höchstens zwei, bevorzugt höchstens eine der Gruppen $A^1$, $A^2$ und $A^3$ für O, S oder $NR^3$ steht, besonders bevorzugt keine der Gruppen $A^1$, $A^2$ und $A^3$ für O, S oder $NR^3$ steht.

Darüber hinaus sind Verbindungen bevorzugt, welche sich dadurch auszeichnen, dass in den Ringstrukturen gemäß einer der Formeln (3), (4), (5), (6), (7), (8) oder (9) mindestens eine der Gruppen $A^1$ und $A^3$ gleich oder verschieden für O oder $NR^3$ und $A^2$ für $C(R^1)_2$ steht.

Gemäß einer weiteren Ausgestaltung der vorliegenden Erfindung sind Verbindungen bevorzugt, die dadurch gekennzeichnet sind, dass in den Ringstrukturen gemäß einer der Formeln (3), (4), (5), (6), (7), (8) oder (9) die Gruppen $A^1$ und $A^3$ gleich oder verschieden bei jedem Auftreten für $C(R^3)_2$ stehen und $A^2$ für $C(R^1)_2$, bevorzugt für $C(R^3)_2$ und besonders bevorzugt für $CH_2$ steht.

Weiterhin sind Verbindungen bevorzugt, bei denen in den Ringstrukturen gemäß den Formeln (6), (7), (8) oder (9) die Reste $R^1$, die an den Brückenkopf gebunden sind, für H, D, F oder $CH_3$ stehen.

Ferner kann vorgesehen sein, dass in der Struktur gemäß Formel (1) oder Formel (2) zwei benachbarte Reste Y eine Ringstruktur gemäß einer der folgenden Formeln (3-A) bis (3-F)

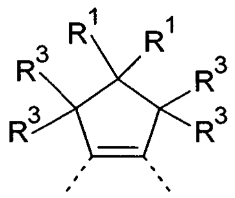

Formel (3-A)

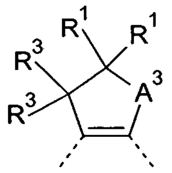

Formel (3-B)

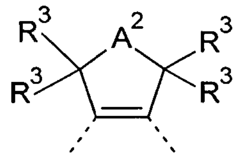

Formel (3-C)

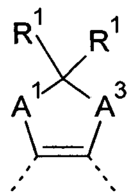

Formel (3-D)

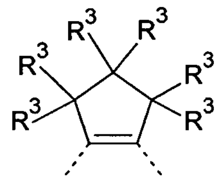

Formel (3-E)

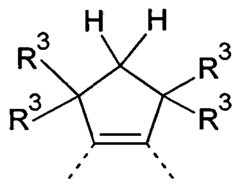

Formel (3-F)

bilden, wobei $A^1$, $A^2$ und $A^3$ gleich oder verschieden bei jedem Auftreten für O oder $NR^3$ stehen, die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen und $R^1$ und $R^3$ die zuvor genannte Bedeutung aufweisen. Von den genannten Verbindungen mit Strukturen gemäß den Formeln (3-A), (3-B), (3-C), (3-D), (3-E) oder (3 F) sind Verbindungen mit Strukturen gemäß den Formeln (3-A), (3-B), (3-C), (3-E) und/oder (3-F) bevorzugt und solche mit Strukturen gemäß den Formeln (3-C) (3-E) und/oder (3-F) besonders bevorzugt.

Gemäß einem besonderen Aspekt der vorliegenden Erfindung kann vorgesehen sein, dass in der Struktur gemäß Formel (1) oder Formel (2) zwei benachbarte Reste Y eine Ringstruktur gemäß einer der folgenden Formeln (4-A) bis (4-F)

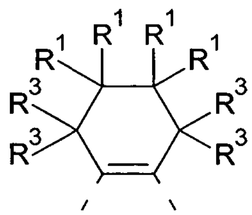

Formel (4-A)

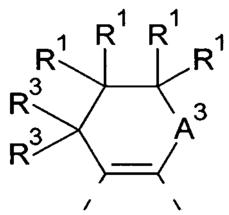

Formel (4-B)

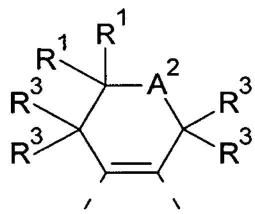

Formel (4-C)

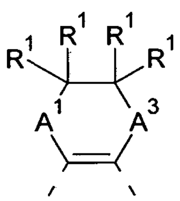

Formel (4-D)

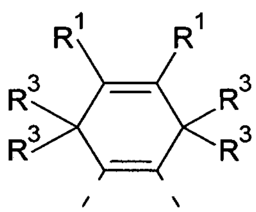

Formel (4-E)

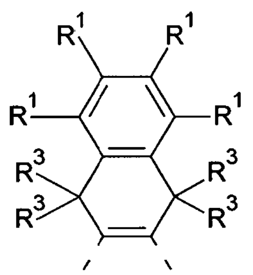

Formel (4-F)

bilden, wobei $A^1$, $A^2$ und $A^3$ gleich oder verschieden bei jedem Auftreten für O oder $NR^3$ stehen, die gestrichelten Linien

die Bindungen der beiden Kohlenstoffatome der Gruppe Y zu den Resten X des aromatischen oder heteroaromatischen Rings in der Struktur gemäß Formel (1) oder Formel (2) darstellen und $R^1$ und $R^3$ die zuvor genannte Bedeutung aufweisen.

Von den genannten Verbindungen mit Strukturen gemäß den Formeln (4-A) bis (4-F) sind Verbindungen mit Strukturen gemäß den Formeln (4-A), (4-B), (4-C), (4-E) und/oder (4-F) bevorzugt und solche mit Strukturen gemäß den Formeln (4-A) und/oder (4-E) besonders bevorzugt.

Vorzugsweise können in der Struktur gemäß Formel (1) oder Formel (2) zwei benachbarte Reste Y eine Ringstruktur gemäß einer der folgenden Formeln (5-A) bis (5-E)

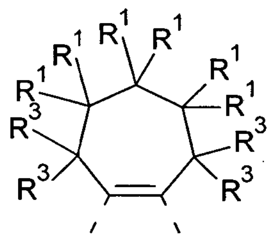

Formel (5-A)

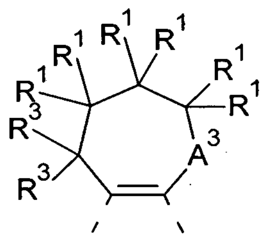

Formel (5-B)

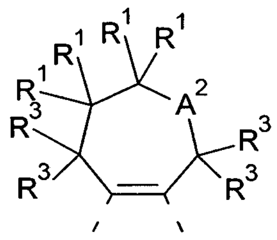

Formel (5-C)

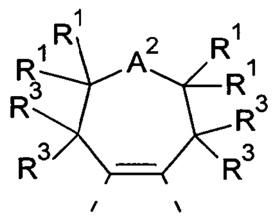

Formel (5-D)

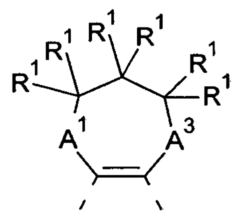

Formel (5-E)

bilden, wobei $A^1$, $A^2$ und $A^3$ gleich oder verschieden bei jedem Auftreten für O oder $NR^3$ stehen, die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen und $R^1$ und $R^3$ die zuvor genannte Bedeutung aufweisen.

Ferner kann vorgesehen sein, dass in der Struktur gemäß Formel (1) oder Formel (2) zwei benachbarte Reste Y eine Ringstruktur gemäß einer der folgenden Formeln (6-A) bis (6-C)

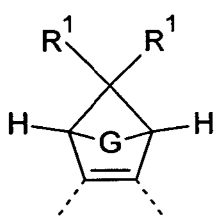

Formel (6-A)

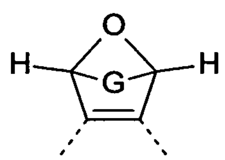

Formel (6-B)

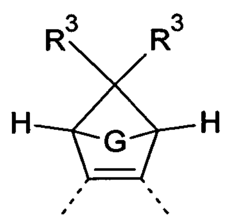

Formel (6-C)

bilden, wobei die verwendeten Symbole die zuvor genannten Bedeutungen haben und die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen. Von den genannten Verbindungen mit Ringstrukturen gemäß (6-A) bis (6-C) sind solche Verbindungen bevorzugt, die Strukturen gemäß Formeln (6-B) oder (6-C) aufweisen, wobei Verbindungen mit Strukturen gemäß Formel (6-C) besonders bevorzugt sind.

Weiterhin sind Verbindungen bevorzugt, bei denen in der Struktur gemäß Formel (1) oder Formel (2) zwei benachbarte Reste Y eine Ringstruktur gemäß einer der folgenden Formeln (7-A), (8-A) oder (9-A)

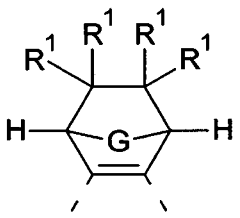

,

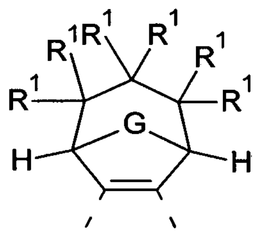

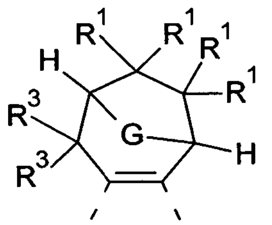

Formel (7-A) Formel (8-A) Formel (9-A)

bilden, wobei die verwendeten Symbole die zuvor genannten Bedeutungen haben und die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen.

Ferner kann vorgesehen sein, dass in der Struktur gemäß den Formeln (6), (6-A), (6-B), (6-C), (7), (7-A), (8), (8-A), (9) und (9-A) die Gruppe G für eine 1,2-Ethylengruppe steht, welche mit einem oder mehreren Resten $R^2$ substituiert sein kann, wobei $R^2$ bevorzugt gleich oder verschieden bei jedem Auftreten für H oder eine Alkylgruppe mit 1 bis 4 C-Atomen steht, oder eine ortho-Arylengruppe mit 6 bis 10 C-Atomen im Ring, welche mit einem oder mehreren Resten $R^2$ substituiert sein kann, bevorzugt aber unsubstituiert ist, insbesondere eine ortho-Phenylengruppe, welche mit einem oder mehreren Resten $R^2$ substituiert sein kann, bevorzugt aber unsubstituiert ist.

Ferner kann vorgesehen sein, dass in der Struktur gemäß den Formeln (3) bis (9) der Rest $R^3$ gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte $CH_2$-Gruppen durch $R^2C=CR^2$ ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste $R^2$ substituiert sein kann, steht; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden.

In Verbindungen mit Strukturen gemäß den Formeln (3) bis (9) und in den bevorzugten Ausführungsformen dieser Formeln kann der Rest $R^3$ vorzugsweise gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste $R^2$ substituiert sein kann, bevorzugt aber unsubstituiert ist, stehen; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden.

Beispiele für besonders bevorzugte Gruppen der Formel (3) sind die im Folgenden aufgeführten Gruppen (3-1) bis (3-69):

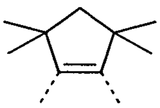
(3-1)

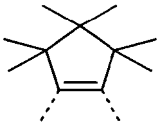
(3-2)

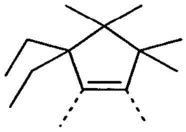
(3-3)

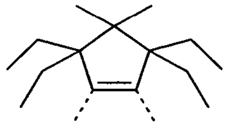
(3-4)

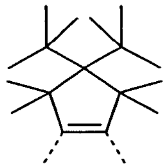
(3-5)

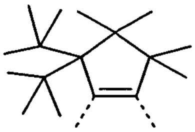
(3-6)

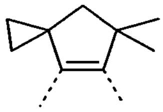
(3-7)

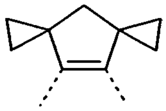
(3-8)

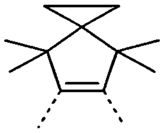
(3-9)

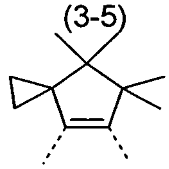
(3-10)

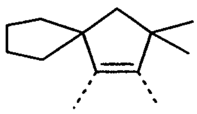
(3-11)

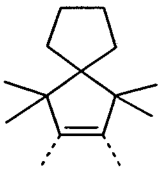
(3-12)

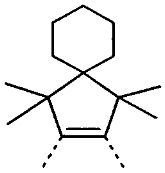
(3-13)

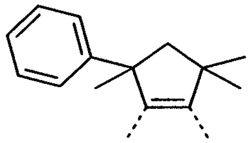
(3-14)

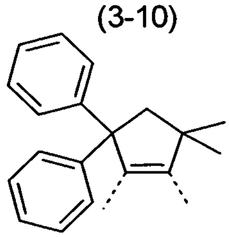
(3-15)

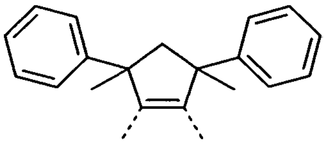
(3-16)

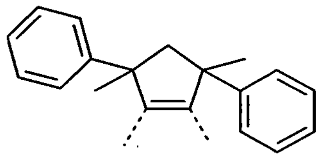
(3-17)

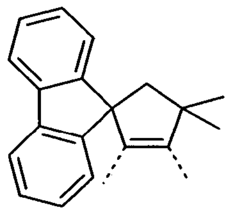
(3-18)

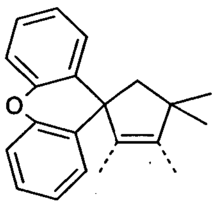
(3-19)

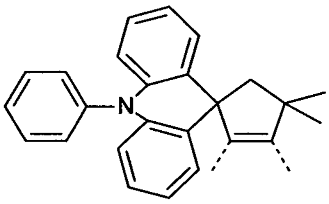
(3-20)

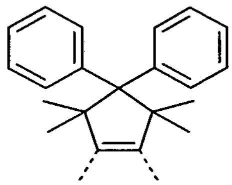
(3-21)

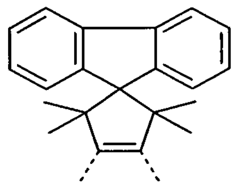
(3-22)

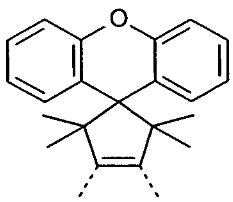
(3-23)

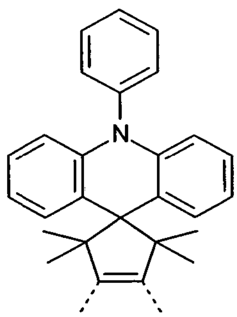
(3-24)

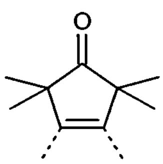
(3-25)

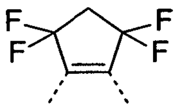
(3-26)

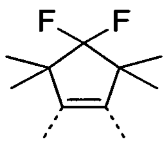
(3-27)

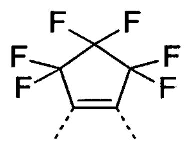
(3-28)

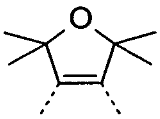
(3-29)

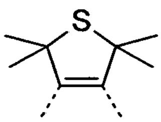
(3-30)

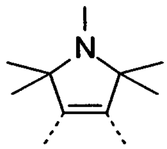
(3-31)

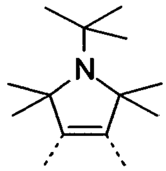
(3-32)

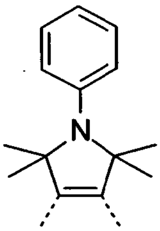
(3-33)

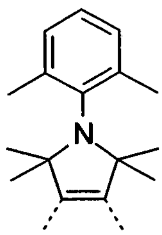
(3-34)

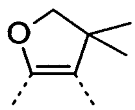
(3-35)

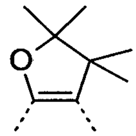
(3-36)

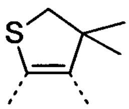
(3-37)

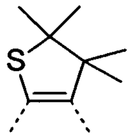
(3-38)

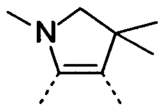
(3-39)

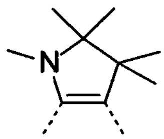
(3-40)

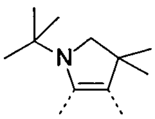
(3-41)

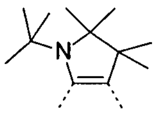
(3-42)

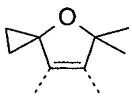
(3-43)

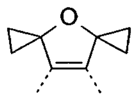
(3-44)

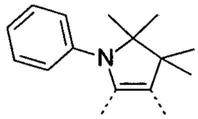
(3-45)

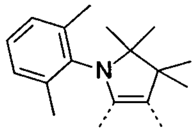
(3-46)

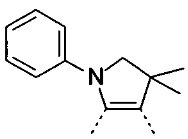
(3-47)

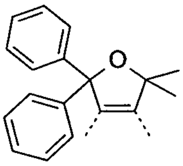
(3-48)

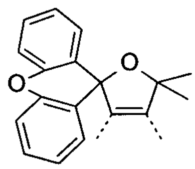
(3-49)

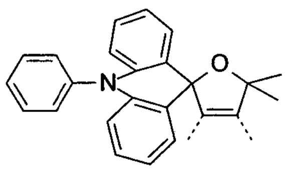
(3-50)

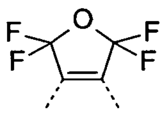
(3-51)
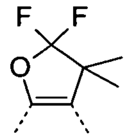
(3-52)
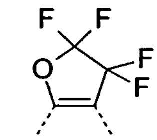
(3-53)
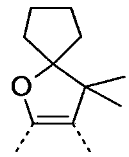
(3-54)
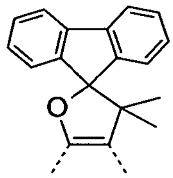
(3-55)

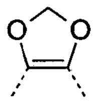
(3-56)
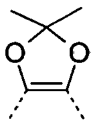
(3-57)
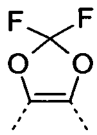
(3-58)
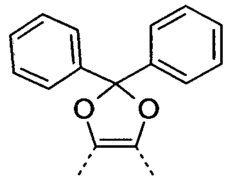
(3-59)
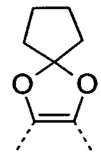
(3-60)

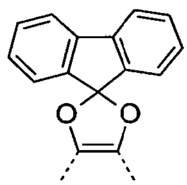
(3-61)
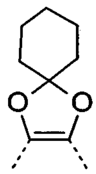
(3-62)
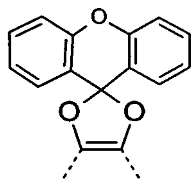
(3-63)
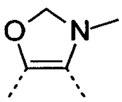
(3-64)
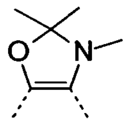
(3-65)

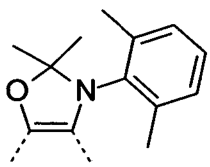
(3-66)
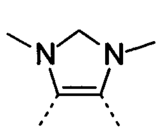
(3-67)
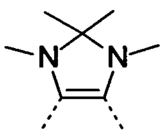
(3-68)
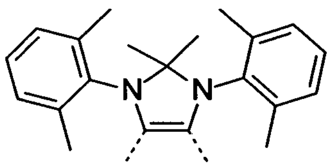
(3-69)

Beispiele für besonders bevorzugte Gruppen der Formel (4) sind die im Folgenden aufgeführten Gruppen (4-1) bis (4-14):

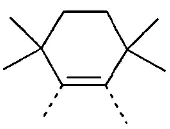
(4-1)
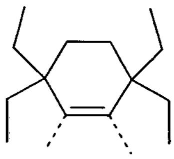
(4-2)
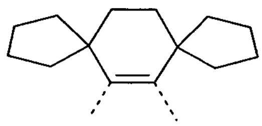
(4-3)
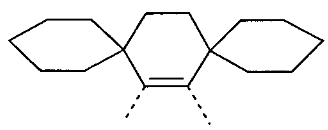
(4-4)

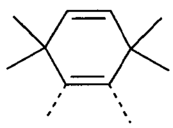
(4-5)
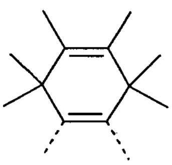
(4-6)
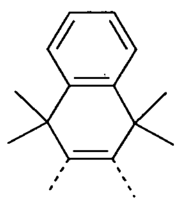
(4-7)
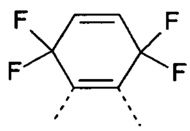
(4-8)
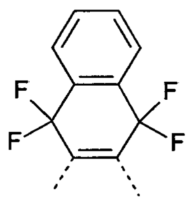
(4-9)

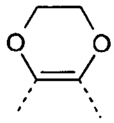
(4-10)

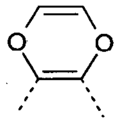
(4-11)

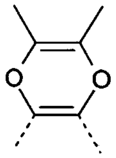
(4-12)

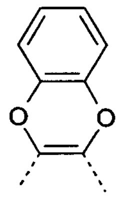
(4-13)

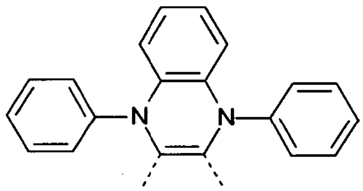
(4-14)

Beispiele für besonders bevorzugte Gruppen der Formel (5), (8) und (9) sind die im Folgenden aufgeführten Gruppen (5-1), (8-1) und (9-1):

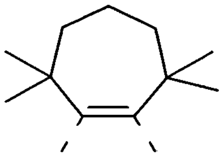
(5-1)

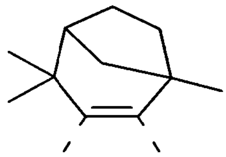
(8-1)

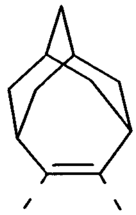
(9-1)

Beispiele für besonders bevorzugte Gruppen der Formel (6) sind die im Folgenden aufgeführten Gruppen (6-1) bis (6-22):

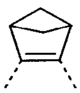
(6-1)

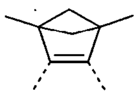
(6-2)

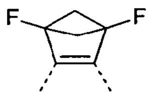
(6-3)

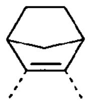
(6-4)

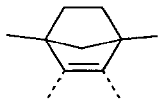
(6-5)

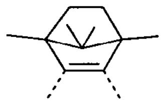
(6-6)

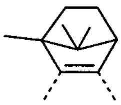
(6-7)

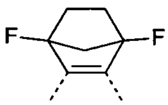
(6-8)

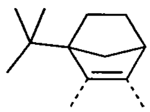
(6-9)

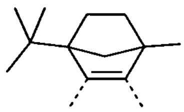
(6-10)

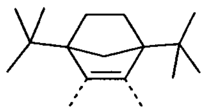
(6-11)

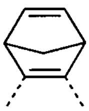
(6-12)

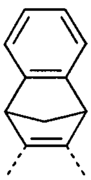
(6-13)

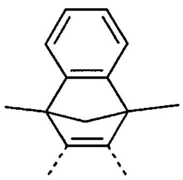
(6-14)

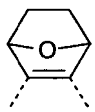
(6-15)

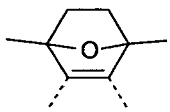
(6-16)

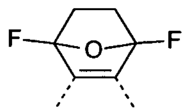
(6-17)

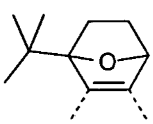
(6-18)

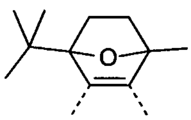
(6-19)

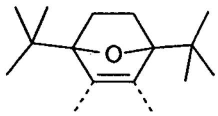
(6-20)

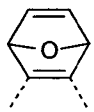
(6-21)

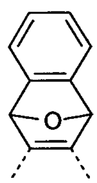
(6-22)

Beispiele für besonders bevorzugte Gruppen der Formel (7) sind die im Folgenden aufgeführten Gruppen (7-1) bis (7-5):

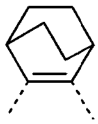
(7-1)

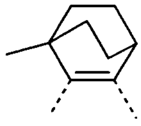
(7-2)

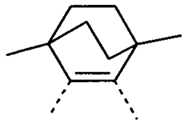
(7-3)

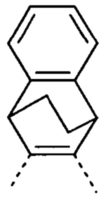
(7-4)

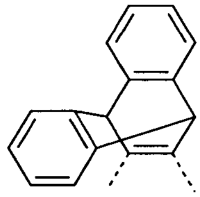
(7-5)

Bevorzugt stehen zwei Symbole X in Formel (1) oder (2) für N, besonders bevorzugt steht maximal ein Symbol X in Formel (1) oder (2) für N. Insbesondere bevorzugt stehen in Strukturen der Formel (1) oder (2) alle Symbole X für CR.

Im Allgemeinen sind Verbindungen der Formel (1) gegenüber den Verbindungen gemäß Formel (2) bevorzugt, so dass besonders bevorzugte Verbindungen eine Ringstruktur gemäß den zuvor dargelegten Formeln (3) bis (9) aufweisen. Hierbei sind Verbindungen der Formel (1) mit Ringstrukturen der Formeln (3) oder (4) besonders bevorzugt. Ferner kann vorgesehen sein, dass die aromatische Verbindung mit einer Struktur der Formel (1) oder (2) ein Molekulargewicht vorzugsweise $\leq$ 2000 g/mol, bevorzugt bevorzugt $\leq$ 1000 g/mol und insbesondere bevorzugt $\leq$ 600 g/mol aufweist.

Bevorzugt kann die aromatische Verbindung mit einer Struktur der Formel (1) oder (2) ausgewählt sein aus Verbindungen der Formeln (10), (11) oder (12), wobei die Verbindung gemäß Formel (10) besonders bevorzugt ist

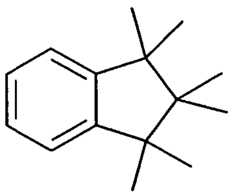
Formel (10)

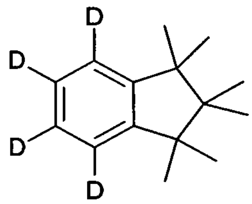
Formel (11)

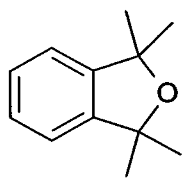
Formel (12)

Verbindungen gemäß den Formeln (1) oder (2) können für vielfache Zwecke als Additive dienen, beispielsweise um die Eigenschaften von Formulierungen wie z.B. die Oberflächenspannung und/oder die rheologischen Eigenschaften, wie z.B. die Viskosität, einzustellen.

Gemäß der vorliegenden Erfindung werden die Verbindungen gemäß Formeln (1) oder (2) als Lösungsmittel eingesetzt. Hierdurch können die zuvor und nachfolgend dargelegten organisch funktionellen Materialien, welche zur Herstellung von Funktionsschichten elektronischer Vorrichtungen einsetzbar sind, mit einer überraschend hohen Qualität unter Verwendung von bekannten und in dieser Anmeldung näher ausgeführten Beschichtungsverfahren auf Substrate oder Funktionsschichten aufgetragen werden.

Gemäß einem besonderen Aspekt der vorliegenden Erfindung kann der Anteil der aromatischen Verbindung mit einer Struktur der Formeln (1) oder (2) in der Formulierung mindestens 0,1 Gew.-%, vorzugsweise mindestens 1 Gew.-%, besonders bevorzugt mindestens 5 Gew.-% und insbesondere bevorzugt mindestens 10 Gew.-%, oder vorzugsweise mindestens 20 Gew.-%, besonders bevorzugt mindestens 40 Gew.-% und insbesondere bevorzugt mindestens 80 Gew.-% betragen, wobei die aromatische Verbindung mit einer Struktur der Formeln (1) oder (2) ab einem Anteil von mindestens 20 Gew.-% vorzugsweise als Lösungsmittel eingesetzt wird.

Bevorzugt kann die aromatische Verbindung mit einer Struktur der Formeln (1) oder (2) eine Oberflächenspannung von höchstens 40 mN/m, vorzugsweise höchstens 35 mN/m und besonders bevorzugt höchstens 30 mN/m aufweisen, wobei die aromatische Verbindung mit einer Struktur der Formeln (1) oder (2) vorzugsweise als Lösungsmittel eingesetzt wird.

Eine weitere bevorzugte Ausführungsform der vorliegenden Erfindung ist dadurch gekennzeichnet, dass die aromatische Verbindung mit einer Struktur der Formeln (1) oder (2) vorzugsweise einen Siedepunkt von höchstens 300°C, besonders bevorzugt höchstens 280°C aufweist, wobei die aromatische Verbindung mit einer Struktur der Formeln (1) oder (2) vorzugsweise als Lösungsmittel eingesetzt wird.

Ferner kann vorgesehen sein, dass die aromatische Verbindung mit einer Struktur der Formeln (1) oder (2) vorzugsweise eine Viskosität von mindestens 3 mPas, besonders bevorzugt mindestens 5 mPas aufweist, wobei die aromatische Verbindung mit einer Struktur der Formeln (1) oder (2) vorzugsweise als Lösungsmittel eingesetzt wird.

Die erfindungsgemäße Formulierung umfasst mindestens ein niedermolekulares, organisches Matrixmaterial und mindestens einen niedermolekularen Emitter, ausgewählt aus fluoreszierenden und phosphoreszierenden Emittern.

Organisch funktionelle Materialen werden vielfach über die Eigenschaften der Grenzorbitale beschrieben, die nachfolgend näher dargelegt werden. Molekülorbitale, insbesondere auch das highest occupied molecular orbital (HOMO) und das lowest unoccupied molecular orbital (LUMO), deren Energieniveaus sowie die Energie des niedrigsten Triplettzustands $T_1$ bzw. des niedrigsten angeregten Singulettzustands $S_1$ der Materialien werden über quantenchemische Rechnungen bestimmt. Zur Berechnung organischer Substanzen ohne Metalle wird zuerst eine Geometrieoptimierung mit der Methode "Ground State/Semi-empirical/Default Spin/AM1/Charge O/Spin Singlet" durchgeführt. Im Anschluss erfolgt auf Grundlage der optimierten Geometrie eine Energierechnung. Hierbei wird die Methode "TD-SCF/DFT/Default Spin/B3PW91" mit dem Basissatz "6-31 G(d)" verwendet (Charge 0, Spin Singlet). Für metallhaltige Verbindungen wird die Geometrie über die Methode "Ground State/ Hartree-Fock/Default Spin/LanL2MB/Charge O/Spin Singlet" optimiert. Die Energierechnung erfolgt analog zu der oben beschriebenen Methode für die organischen Substanzen mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

Die hierin beschriebene Methode ist unabhängig von dem verwendeten Softwarepaket und liefert immer dieselben Ergebnisse. Beispiele oft benutzter Programme für diesen Zweck sind "Gaussian09W" (Gaussian Inc.) und Q-Chem 4.1 (Q-Chem, Inc.).

Verbindungen mit Lochinjektionseigenschaften, hierin auch Lochinjektionsmaterialien genannt, erleichtern oder ermöglichen die Übertragung von Löchern, d.h. positive Ladungen, aus der Anode in eine organische Schicht. Im Allgemeinen weist ein Lochinjektionsmaterial ein HOMO-Niveau auf, das im Bereich des Niveaus der Anode ist oder darüber liegt, d.h. im Allgemeinen mindestens -5,3 eV beträgt.

Verbindungen mit Lochtransporteigenschaften, hierin auch Lochtransportmaterialien genannt, sind in der Lage Löcher, d.h. positive Ladungen, zu transportieren, die im Allgemeinen aus der Anode oder einer angrenzenden Schicht, beispielsweise einer Lochinjektionsschicht injiziert werden. Ein Lochtransportmaterial weist im Allgemeinen ein hohes HOMO-Niveau von vorzugsweise mindestens -5.4 eV auf. Je nach Aufbau einer elektronischen Vorrichtung kann ein Lochtransportmaterial auch als Lochinjektionsmaterial eingesetzt werden.

Zu den bevorzugten Verbindungen, die Lochinjektions- und/oder Lochtransporteigenschaften aufweisen, gehören beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-paradioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital).

Insbesondere zu nennen sind als Verbindungen, die Lochinjektions- und/oder Lochtransporteigenschaften aufweisen, Phenylendiamin-Derivate (US 3615404), Arylamin-Derivate (US 3567450), Amino-substituierte Chalcon-Derivate (US 3526501), Styrylanthracen-Derivate (JP-A-56-46234), Polyzyklische aromatische Verbindungen (EP 1009041), Polyarylalkan-Derivate (US 3615402), Fluorenon-Derivate (JP-A-54-110837), Hydrazon-Derivate (US 3717462), Acylhydrazone, Stilben-Derivate (JP-A-61-210363), Silazan-Derivate (US 4950950), Polysilane (JP-A-2-204996), Anilin-Copolymere (JP-A-2-282263), Thiophen-Oligomere (JP Heisei 1 (1989) 211399), Polythiophene, Poly(N-vinylcarbazol) (PVK), Polypyrrole, Polyaniline und andere elektrisch leitende Makromoleküle, Porphyrin-Verbindungen (JP-A-63-2956965, US 4720432), aromatische Dimethyliden-Typ-Verbindungen, Carbazol-Verbindungen wie z.B. CDBP, CBP, mCP, aromatische tertiäre Amin- und Styrylamin-Verbindungen (US 4127412) wie z.B. Triphenylamine vom Benzidin-Typ, Triphenylamine vom Styrylamin-Typ und Triphenylamine vom Diamin-Typ. Auch Arylamin-Dendrimere können verwendet werden (JP Heisei 8 (1996) 193191), monomere Triarylamine (US 3180730), Triarylamine mit

einem oder mehreren Vinylradikalen und/oder mindestens einer funktionellen Gruppe mit aktivem Wasserstoff (US 3567450 und US 3658520) oder Tetraaryldiamine (die zwei Tertiäramineinheiten sind über eine Arylgruppe verbunden). Es können auch noch mehr Triarylaminogruppen im Molekül vorhanden sein. Auch Phthalocyanin-Derivate, Naphthalocyanin-Derivate, Butadien-Derivate und Chinolinderivate wie z.B. Dipyrazino[2,3-f:2',3'-h]quinoxalinhexacarbonitril sind geeignet.

Bevorzugt sind aromatische tertiäre Amine mit mindestens zwei Tertiäramin-Einheiten (US 2008/0102311 A1, US 4720432 und US 5061569), wie z.B. NPD ($\alpha$-NPD = 4,4'-bis[N-(1-naphthyl)-N-phenylamino]biphenyl) (US 5061569), TPD 232 (= N,N'-Bis-(N,N'-diphenyl-4-aminophenyl)-N,N-diphenyl-4,4'-diamino-1,1'-biphenyl) oder MTDATA (MTDATA oder m-MTDATA= 4,4',4"-Tris[3-methylphenyl)phenyl-amino]triphenylamin) (JP-A-4-308688), TBDB (= N,N,N',N'-Tetra(4-biphenyl)diaminobiphenylen), TAPC (= 1,1-Bis(4-di-p-tolylaminophenyl)-cyclohexan), TAPPP (= 1,1-Bis(4-di-p-tolylaminophenyl)-3-phenylpropan), BDTAPVB (= 1,4-Bis[2-[4-[N,N-di(p-tolyl)amino]phenyl]vinyl]benzol), TTB (= N,N,N',N'-Tetra-p-tolyl-4,4'-diaminobiphenyl), TPD (= 4,4'-Bis[N-3-methylphenyl]-N-phenylamino)biphenyl), N,N,N',N'-Tetraphenyl-4,4'''-diamino-1,1',4',1",4",1'''-quaterphenyl, ebenso tertiäre Amine mit Carbazol-Einheiten wie z.B. TCTA (= 4-(9H-Carbazol-9-yl)-N,N-bis[4-(9H-carbazol-9-yl)phenyl]benzolamin). Ebenfalls bevorzugt sind Hexaaza-Triphenylen-Verbindungen gemäß US 2007/0092755 A1 sowie Phthalocyanin-Derivate (z.B. $H_2Pc$, CuPc (= Kupfer-Phthalocyanin), CoPc, NiPc, ZnPc, PdPc, FePc, MnPc, ClAlPc, ClGaPc, ClInPc, ClSnPc, $Cl_2SiPc$, (HO)AlPc, (HO)GaPc, VOPc, TiOPc, MoOPc, GaPc-O-GaPc).

Besonders bevorzugt sind folgende Triarylamin-Verbindungen gemäß den Formeln (TA-1) bis (TA-12), die in den Dokumenten EP 1162193 B1, EP 650 955 B1, Synth.Metals 1997, 91(1-3), 209, DE 19646119 A1, WO 2006/122630 A1, EP 1 860 097 A1, EP 1834945 A1, JP 08053397 A, US 6251531 B1, US 2005/0221124, JP 08292586 A, US 7399537 B2, US 2006/0061265 A1, EP 1 661 888 und WO 2009/041635 offenbart werden. Die genannten Verbindungen gemäß den Formeln (TA-1) bis (TA-12) können auch substituiert sein:

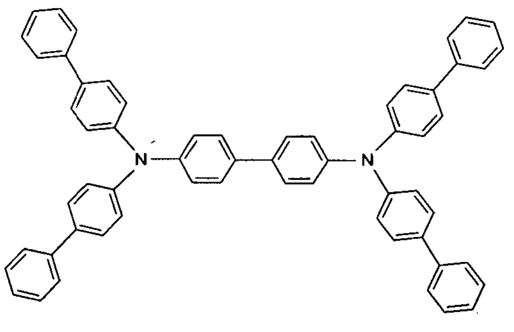

Formel TA-1

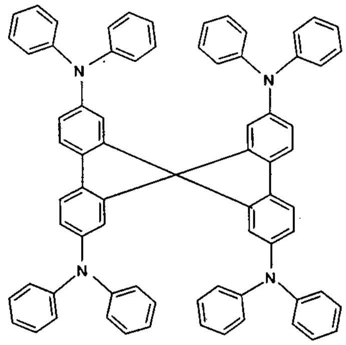

Formel TA-2

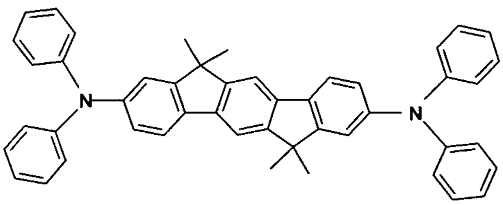

Formel TA-3

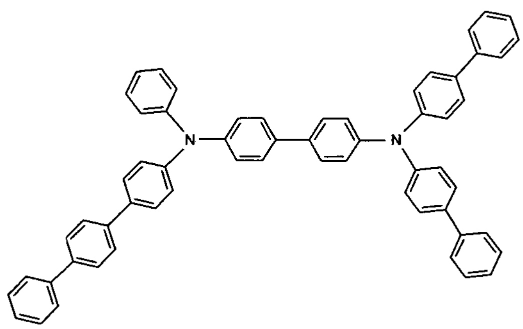

Formel TA-4

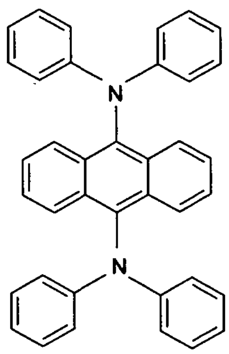

Formel TA-5

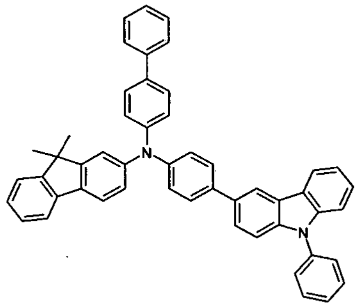

Formel TA-6

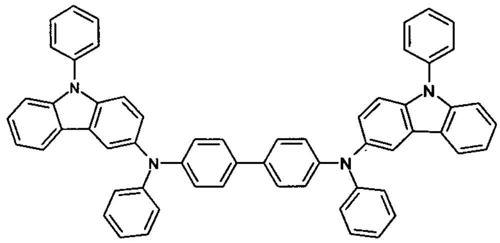

Formel TA-7

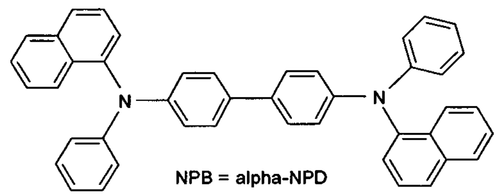

NPB = alpha-NPD

Formel TA-8

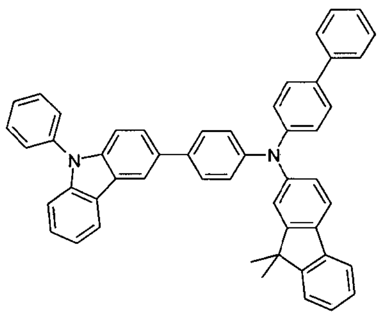

Formel TA-9

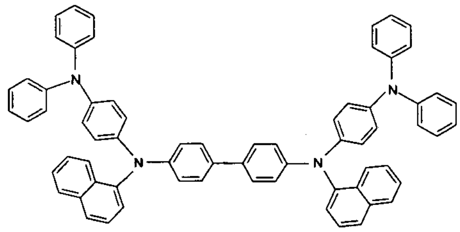

Formel TA-10

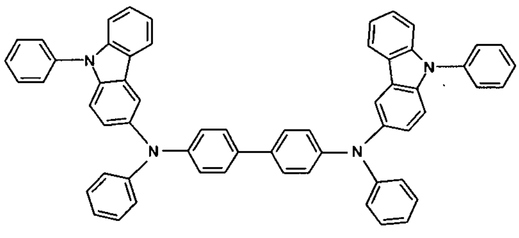

Formel TA-11

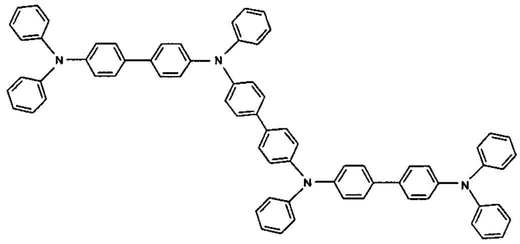

Formel TA-12

Weitere Verbindungen, die als Lochinjektionsmaterialien eingesetzt werden können, sind beschrieben in der EP 0891121 A1 und der EP 1029909 A1, Injektionsschichten allgemein in der US 2004/0174116 A1.

Vorzugsweise führen diese Arylamine und Heterocyclen, die im allgemeinen als Lochinjektions- und/oder Lochtransportmaterialien eingesetzt werden, zu einem HOMO von mehr als -5,8 eV (gegen Vakuumlevel), besonders bevorzugt von mehr als -5,5 eV.

Verbindungen, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital).

Besonders geeignete Verbindungen für elektronentransportierende und elektroneninjizierende Schichten sind Metallchelate von 8-Hydroxychinolin (z.B. LiQ, $AlQ_3$, $GaQ_3$, $MgQ_2$, $ZnQ_2$, $InQ_3$, $ZrQ_4$), BAlQ, Ga-Oxinoid-Komplexe, 4-Azaphenanthren-5-ol-Be-Komplexe (US 5529853 A, vgl. Formel ET-1), Butadienderivate (US 4356429), heterozyklische optische Aufheller (US 4539507), Benzimidazol-Derivate (US 2007/0273272 A1), wie z.B. TPBI (US 5766779, vgl. Formel ET-2), 1,3,5-Triazine, z.B. Spirobifluoren-Triazin-Derivate (z.B. gemäß der DE 102008064200), Pyrene, Anthracene, Tetracene, Fluorene, Spirofluorene, Dendrimere, Tetracene (z.B. Rubren-Derivate), 1,10-Phenanthrolin-Derivate (JP 2003-115387, JP 2004-311184, JP-2001-267080, WO 02/043449), SilaCyclopentadien-Derivate (EP 1480280, EP 1478032, EP 1469533), Boran-Derivate wie z.B. Triarylboranderivate mit Si (US 2007/0087219 A1, vgl. Formel ET-3), Pyridin-Derivate (JP 2004-200162), Phenanthroline, vor allem 1,10-Phenanthrolinderivate, wie z.B. BCP und Bphen, auch mehrere über Biphenyl oder andere aromatische Gruppen verbundene Phenanthroline (US-2007-0252517 A1) oder mit Anthracen verbundene Phenanthroline (US 2007-0122656 A1, vgl. Formeln ET-4 und ET-5).

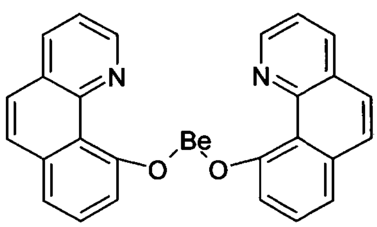

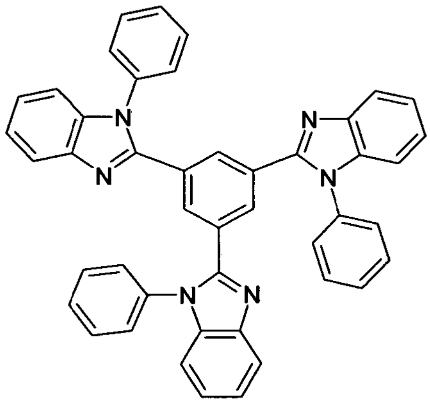

TPBI

2,2',2"-(1,3,5-benzenetriyl)tris(1-phenyl-1H-benzim

Formel ET-1

Formel ET-2

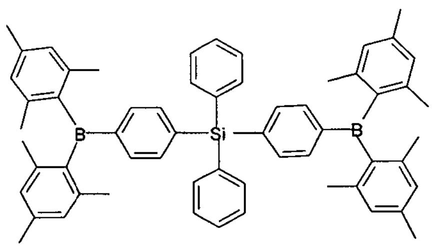

Formel ET-3

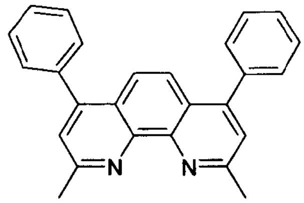

Formel ET-4

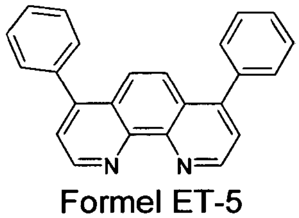

Formel ET-5

Ebenfalls geeignet sind heterozyklische, organische Verbindungen wie z.B. Thiopyrandioxide, Oxazole, Triazole, Imidazole oder Oxadiazole. Beispiele für die Verwendung von Fünfringen mit N wie z.B. Oxazole, vorzugsweise 1,3,4-Oxadiazole, beispielsweise Verbindungen gemäß Formeln ET-6, ET-7, ET-8 und ET-9, die unter anderem in der US 2007/0273272 A1 offenbart sind; Thiazole, Oxadiazole, Thiadiazole, Triazole, u.a. siehe US 2008/0102311 A1 und Y.A. Levin, M.S. Skorobogatova, Khimiya Geterotsiklicheskikh Soedinenii 1967 (2), 339-341, vorzugsweise Verbindungen gemäß der Formel ET-10, Silacyclopentadien-Derivate. Bevorzugte Verbindungen sind folgende gemäß den

Formeln (ET-6) bis (ET-10):

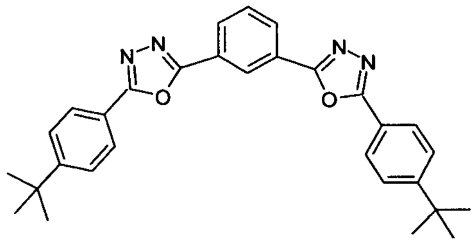

Formel ET-6

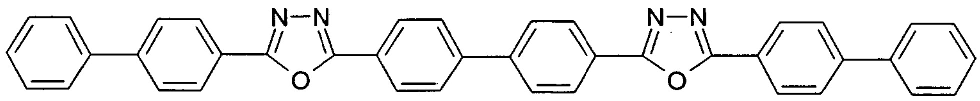

Formel ET-7

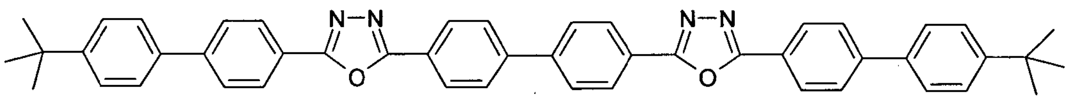

Formel ET-8

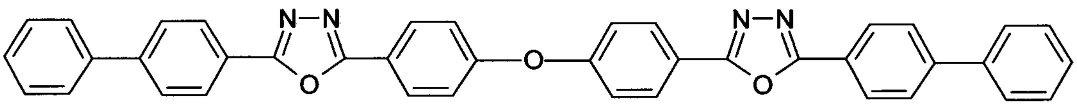

Formel ET-9

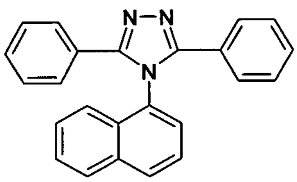

Formel ET-10

Auch organische Verbindungen wie Derivate von Fluorenon, Fluorenylidenmethan, Perylentetrakohlensäure, Anthrachinondimethan, Diphenochinon, Anthron und Anthrachinondiethylendiamin können eingesetzt werden.

Bevorzugt sind 2,9,10-substituierte Anthracene (mit 1- oder 2-Naphthyl und 4- oder 3-Biphenyl) oder Moleküle, die zwei Anthraceneinheiten enthalten (US2008/0193796 A1, vgl. Formel ET-11). Sehr vorteilhaft ist auch die Verbindung von 9,10-substituierten Anthracen-Einheiten mit Benzimidazol-Derivaten (US 2006 147747 A und EP 1551206 A1, vgl. Formeln ET-12 und ET-13).

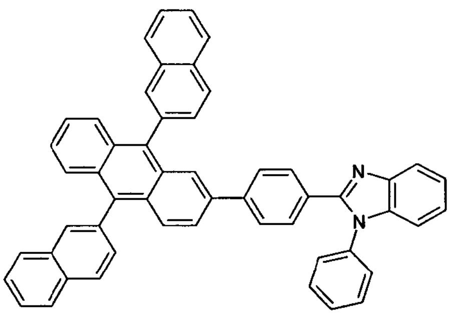

Formel ET-11

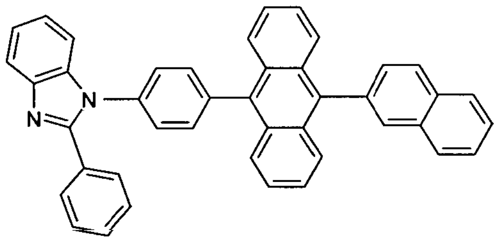

Formel ET-12

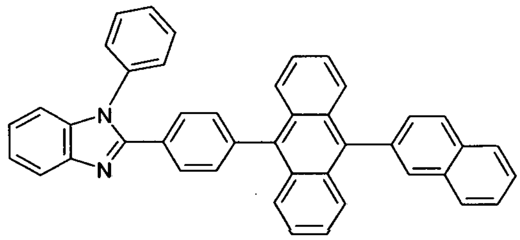

Formel ET-13

Vorzugsweise führen die Verbindungen, die die Elektroneninjektions- und/oder Elektronentransporteigenschaften erzeugen können, zu einem LUMO von weniger als -2,5 eV (gegen Vakuumlevel), besonders bevorzugt von weniger als -2,7 eV.

Die vorliegenden Formulierungen umfassen mindestens einen niedermolekularen Emitter. Der Begriff Emitter bezeichnet ein Material, welches, nach einer Anregung, die durch Übertragung jeder Art von Energie erfolgen kann, einen strahlungsbehafteten Übergang unter Emission von Licht in einen Grundzustand erlaubt. Im Allgemeinen sind zwei Klassen von Emittern bekannt, nämlich fluoreszierende und phosphoreszierende Emitter. Der Begriff fluoreszierender Emitter bezeichnet Materialien oder Verbindungen, bei welchen ein strahlungsbehafteter Übergang von einem angeregten Singulettzustand in den Grundzustand erfolgt. Der Begriff phosphoreszierender Emitter bezeichnet vorzugsweise lumineszierende Materialien oder Verbindungen, die Übergangsmetalle umfassen.

Emitter werden häufig auch als Dotanden bezeichnet, falls die Dotanden die zuvor dargelegten Eigenschaften in einem System hervorufen. Unter einem Dotanden wird in einem System enthaltend ein Matrixmaterial und einen Dotanden diejenige Komponente verstanden, deren Anteil in der Mischung der kleinere ist. Entsprechend wird unter einem Matrixmaterial in einem System enthaltend ein Matrixmaterial und einen Dotanden diejenige Komponente verstanden, deren Anteil in der Mischung der größere ist. Unter dem Begriff phosphoreszierende Emitter können demgemäß beispielsweise auch phosphoreszierende Dotanden verstanden werden.

Verbindungen, welche Licht emittieren können, umfassen unter anderem fluoreszierende Emitter und phosphoreszierende Emitter. Hierzu gehören unter anderem Verbindungen mit Stilben-, Stilbenamin-, Styrylamin-, Coumarin-, Rubren-, Rhodamin-, Thiazol-, Thiadiazol-, Cyanin-, Thiophen-, Paraphenylen-, Perylen-, Phatolocyanin-, Porphyrin-, Keton-, Chinolin-, Imin-, Anthracen- und/oder Pyren-Strukturen. Besonders bevorzugt sind Verbindungen, die auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Verbindungen, welche Elemente der Gruppe 8 bis 10 (Ru, Os, Rh, Ir, Pd, Pt) enthalten. Als funktionelle Verbindungen kommen hier z.B. verschiedene Komplexe in Frage, wie sie z.B. in der WO 02/068435 A1, der WO 02/081488 A1, der EP 1239526 A2 und der WO 2004/026886 A2 beschrieben werden.

Nachfolgend werden beispielhaft bevorzugte Verbindungen dargelegt, die als fluoreszierende Emitter dienen können. Bevorzugte fluoreszierende Emitter sind ausgewählt aus der Klasse der Monostyrylamine, der Distyrylamine, der Tristyrylamine, der Tetrastyrylamine, der Styrylphosphine, der Styrylether und der Arylamine.

Unter einem Monostyrylamin wird eine Verbindung verstanden, die eine substituierte oder unsubstituierte Styrylgruppe und mindestens ein, bevorzugt aromatisches, Amin enthält. Unter einem Distyrylamin wird eine Verbindung verstanden, die zwei substituierte oder unsubstituierte Styrylgruppen und mindestens ein, bevorzugt aromatisches, Amin enthält. Unter einem Tristyrylamin wird eine Verbindung verstanden, die drei substituierte oder unsubstituierte Styrylgruppen und mindestens ein, bevorzugt aromatisches, Amin enthält. Unter einem Tetrastyrylamin wird eine Verbindung

verstanden, die vier substituierte oder unsubstituierte Styrylgruppen und mindestens ein, bevorzugt aromatisches, Amin enthält. Die Styrylgruppen sind besonders bevorzugt Stilbene, die auch noch weiter substituiert sein können. Entsprechende Phosphine und Ether sind in Analogie zu den Aminen definiert. Unter einem Arylamin bzw. einem aromatischen Amin im Sinne der vorliegenden Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, vorzugsweise mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 2,6- oder 9,10-Position. Aromatische Pyrenamine, Pyrendiamine, Chrysenamine und Chrysendiamine sind analog dazu definiert, wobei die Diarylaminogruppen am Pyren vorzugsweise in 1-Position bzw. in 1,6-Position gebunden sind.

Weitere bevorzugte fluoreszierende Emitter sind ausgewählt aus Indenofluorenaminen bzw. -diaminen, die unter anderem in der WO 2006/122630 dargelegt sind; Benzoindenofluorenaminen bzw. -diaminen, die unter anderem in der WO 2008/006449 dargelegt sind; und Dibenzoindenofluorenaminen bzw. -diaminen, die unter anderem in der WO 2007/140847 offenbart sind.

Beispiele für Verbindungen, die als fluoreszierende Emitter eingesetzt werden können, aus der Klasse der Styrylamine sind substituierte oder unsubstituierte Tristilbenamine oder die Dotanden, die in der WO 2006/000388, der WO 2006/058737, der WO 2006/000389, der WO 2007/065549 und der WO 2007/115610 beschrieben sind. Distyrylbenzol- und Distyrylbiphenyl-Derivate sind beschrieben in der US 5121029. Weitere Styrylamine sind in der US 2007/0122656 A1 zu finden.

Besonders bevorzugte Styrylamin-Verbindungen sind die in der US 7250532 B2 beschriebenen Verbindungen der Formel EM-1 und die in der DE 10 2005 058557 A1 offenbarten Verbindungen der Formel EM-2:

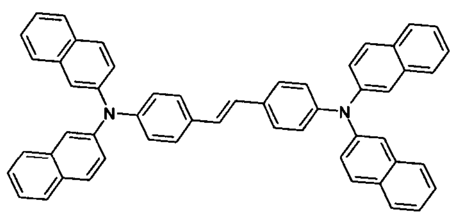

Formel EM-1

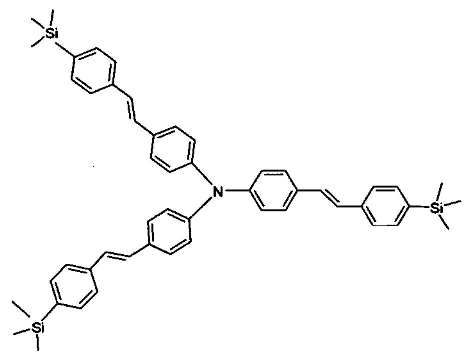

Formel EM-2

Besonders bevorzugte Triarylamin-Verbindungen sind die in der CN 1583691 A, der JP 08/053397 A und der US 6251531 B1, der EP 1957606 A1, der US 2008/0113101 A1, der US 2006/210830 A , der WO 2008/006449 und der DE 102008035413 offenbarten Verbindungen der Formeln EM-3 bis EM-15 und deren Derivate:

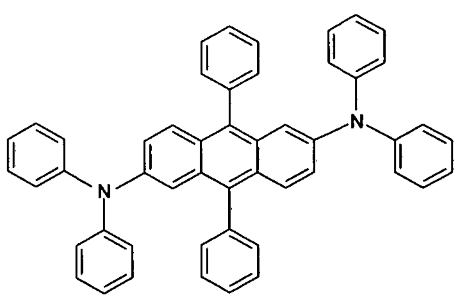

Formel EM-3

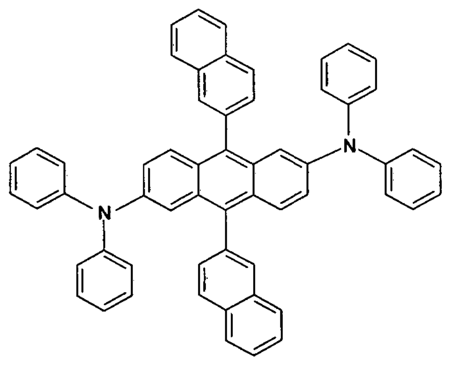

Formel EM-4

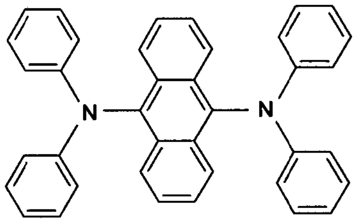

Formel EM-5

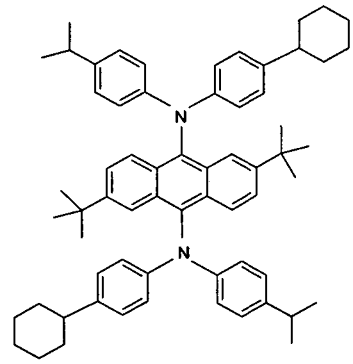

Formel EM-6

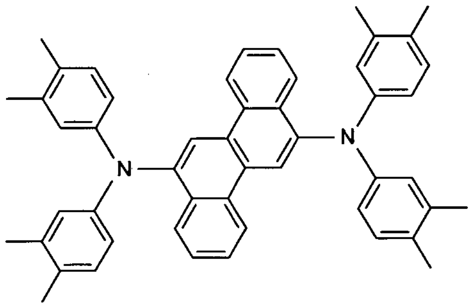

Formel EM-7

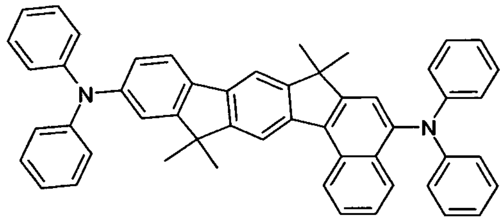

Formel EM-8

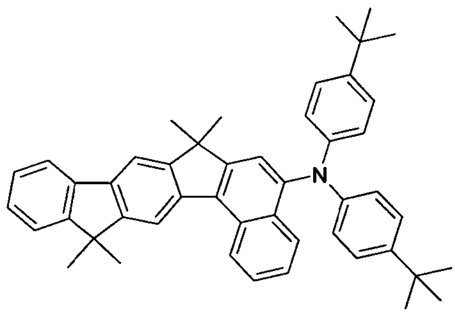

Formel EM-9

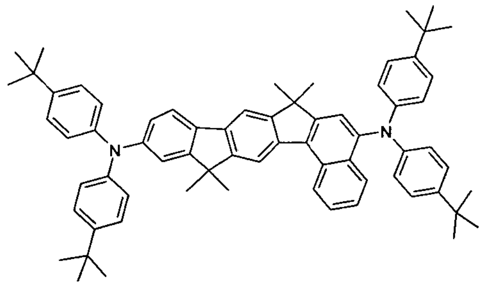

Formel EM-10

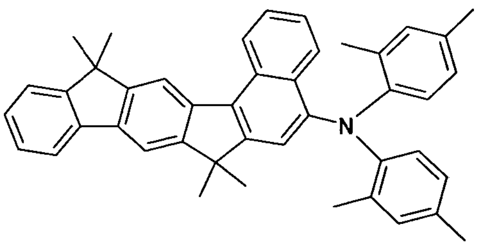

Formel EM-11

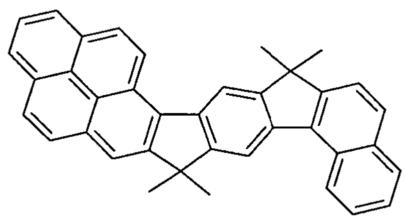

Formel EM-12

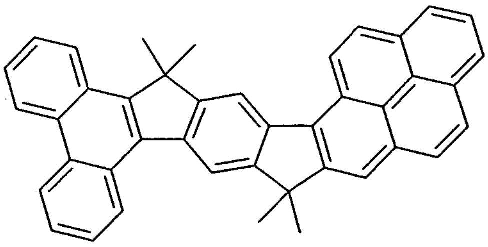

Formel EM-13

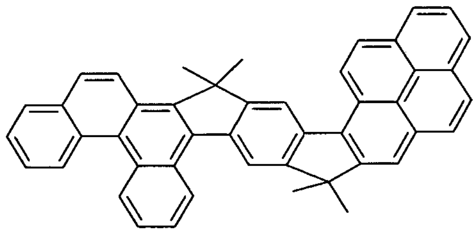

Formel EM-14

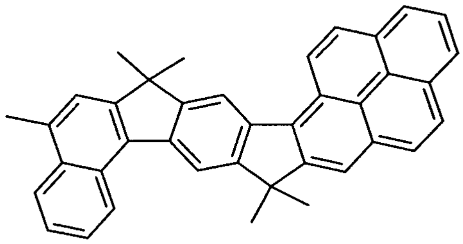

Formel EM-15

Weitere bevorzugte Verbindungen, die als fluoreszierende Emitter eingesetzt werden können, sind ausgewählt aus Derivaten von Naphthalin, Anthracen, Tetracen, Benzanthracen, Benzphenanthren (DE 10 2009 005746), Fluoren, Fluoranthen, Periflanthen, Indenoperylen, Phenanthren, Perylen (US 2007/0252517 A1), Pyren, Chrysen, Decacyclen, Coronen, Tetraphenylcyclopentadien, Pentaphenylcyclopentadien, Fluoren, Spirofluoren, Rubren, Cumarin (US 4769292, US 6020078, US 2007/0252517 A1), Pyran, Oxazol, Benzoxazol, Benzothiazol, Benzimidazol, Pyrazin, Zimtsäureestern, Diketopyrrolopyrrol, Acridon und Chinacridon (US 2007/0252517 A1).

Von den Anthracenverbindungen sind besonders bevorzugt in 9,10-Position substituierte Anthracene wie z.B. 9,10-Diphenylanthracen und 9,10-Bis(phenylethynyl)anthracen. Auch 1,4-Bis(9'-ethynylanthracenyl)-benzol ist ein bevorzugter Dotand.

Ebenfalls bevorzugt sind Derivate von Rubren, Cumarin, Rhodamin, Chinacridon wie z.B. DMQA (= N,N'-dimethylchinacridon), Dicyanomethylenpyran wie z.B. DCM (= 4-(dicyanoethylen)-6-(4-dimethylaminostyryl-2-methyl)-4H-pyran), Thiopyran, Polymethin, Pyrylium- und Thiapyryliumsalzen, Periflanthen und Indenoperylen.

Blaue Fluoreszenzemitter sind vorzugsweise Polyaromaten wie z.B. 9,10-Di(2-naphthylanthracen) und andere Anthracen-Derivate, Derivate von Tetracen, Xanthen, Perylen wie z.B. 2,5,8,11-Tetra-t-butyl-perylen, Phenylen, z.B. 4,4'-(Bis(9-ethyl-3-carbazovinylen)-1,1'-biphenyl, Fluoren, Fluoranthen, Arylpyrene (US 2006/0222886 A1), Arylenvinylene (US 5121029, US 5130603), Bis(azinyl)imin-Bor-Verbindungen (US 2007/0092753 A1), Bis(azinyl)methenverbindungen und Carbostyryl-Verbindungen.

Weitere bevorzugte blaue Fluoreszenzemitter sind in C.H.Chen et al.: "Recent developments in organic electroluminescent materials" Macromol. Symp. 125, (1997) 1-48 und "Recent progress of molecular organic electroluminescent materials and devices" Mat. Sci. and Eng. R, 39 (2002), 143-222 beschrieben.

Weitere bevorzugte blau fluoreszierende Emitter sind die in der DE 102008035413 offenbarten Kohlenwasserstoffe.

Nachfolgend werden beispielhaft bevorzugte Verbindungen dargelegt, die als phosphoreszierende Emitter dienen können.

Beispiele für phosphoreszierende Emitter können der WO 00/70655, der WO 01/41512, der WO 02/02714, der WO 02/15645, der EP 1191613, der EP 1191612, der EP 1191614 und der WO 2005/033244 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Phosphoreszierende Metallkomplexe enthalten vorzugsweise Ir, Ru, Pd, Pt, Os oder Re.

Bevorzugte Liganden sind 2-Phenylpyridin-Derivate, 7,8-Benzochinolin-Derivate, 2-(2-Thienyl)pyridin-Derivate, 2-(1-Naphthyl)pyridin-Derivate, 1-Phenylisochinolin-Derivate, 3-Phenylisochinolin-Derivate oder 2-Phenylchinolin-Derivate. Alle diese Verbindungen können substituiert sein, z.B. für Blau mit Fluor-, Cyano- und/oder Trifluormethylsubstituenten. Auxiliäre Liganden sind vorzugsweise Acetylacetonat oder Picolinsäure.

Insbesondere sind Komplexe von Pt oder Pd mit tetradentaten Liganden gemäß Formel EM-16 als Emitter

geeignet.

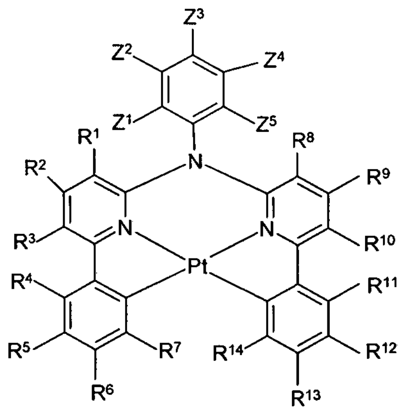

Formel EM-16

Die Verbindungen gemäß der Formel EM-16 sind detaillierter in der US 2007/0087219 A1 dargelegt, wobei zur Erläuterung der Substituenten und Indices in der obigen Formel zu Offenbarungszwecken auf diese Druckschrift verwiesen wird. Weiterhin sind Pt-Porphyrinkomplexe mit vergrößertem Ringsystem (US 2009/0061681 A1) und Ir-Komplexe geeignet, z.B. 2,3,7,8,12,13,17,18-Octaethyl-21H, 23H-porphyrin-Pt(II), Tetraphenyl-Pt(II)-tetrabenzoporphyrin (US 2009/0061681 A1), cis-Bis(2-phenylpyridinato-N,C2')Pt(II), *cis*-Bis(2-(2'-thienyl)pyridinato-N,C3')Pt(II), *cis*-Bis-(2-(2'-thienyl)chinolinato-N,C5')Pt(II), (2-(4,6-Difluorophenyl)pyridinato-N,C2')Pt(II)(acetylacetonat), oder Tris(2-phenylpyridinato-N,C2')Ir(III) (= $Ir(ppy)_3$, grün), Bis(2-phenyl-pyridinato-N,C2)Ir(III)(acetylacetonat) (= $Ir(ppy)_2$acetylacetonat, grün, US 2001/0053462 A1, Baldo, Thompson et al. Nature 403, (2000), 750-753), Bis(1-phenylisochinolinato-N,C2')(2-phenylpyridinato-N,C2')Iridium(III), Bis(2-phenylpyridinato-N,C2')(1-phenylisochinolinato-N,C2')Iridium(III), Bis(2-(2'-benzothienyl)pyridinato-N,C3')Iridium(III)(acetylacetonat), Bis(2-(4',6'-difluorophenyl)pyridinato-N,C2')Iridium(III)(piccolinat) (FIrpic, blau), Bis(2-(4',6'-difluorophenyl)-pyridinato-N,C2')Ir(III)(tetrakis(1-pyrazolyl)borat), Tris(2-(biphenyl-3-yl)-4-tertbutylpyridin)iridium(III), $(ppz)_2$Ir(5phdpym) (US 2009/0061681 A1), $(45ooppz)_2$Ir(5phdpym) (US 2009/0061681 A1), Derivate von 2-Phenylpyridin-Ir-Komplexen, wie z.B. PQIr (= Iridium(III)-bis(2-phenyl-quinolyl-N,C2')acetylacetonat), Tris(2-phenylisochinolinato-N,C)Ir(III) (rot), Bis(2-(2'-benzo[4,5-a]thienyl)pyridinato-N,C3)Ir(acetyl-acetonat) ( [$Btp_2$Ir(acac)], rot, Adachi et al. Appl. Phys. Lett. 78 (2001), 1622-1624).

Ebenfalls geeignet sind Komplexe von trivalenten Lanthaniden wie z.B. $Tb^{3+}$ und $Eu^{3+}$ (J.Kido et al. Appl. Phys. Lett. 65 (1994), 2124, Kido et al. Chem. Lett. 657, 1990, US 2007/0252517 A1) oder phosphoreszente Komplexe von Pt(II), Ir(I), Rh(I) mit Maleonitrildithiolat (Johnson et al., JACS 105, 1983, 1795), Re(I)-Tricarbonyl-diimin-Komplexe (Wrighton, JACS 96, 1974, 998 u.a.), Os(II)-Komplexe mit Cyanoliganden und Bipyridyl- oder Phenanthrolin-Liganden (Ma et al., Synth. Metals 94, 1998, 245).

Weitere phosphoreszierende Emitter mit tridentaten Liganden werden beschrieben in der US 6824895 und der US 10/729238. Rot emittierende phosphoreszente Komplexe findet man in der US 6835469 und der US 6830828.

Besonders bevorzugte Verbindungen, die als phosphoreszierende Dotanden Verwendung finden, sind unter anderem die in der US 2001/0053462 A1 und Inorg. Chem. 2001, 40(7), 1704-1711, JACS 2001, 123(18), 4304-4312 beschriebenen Verbindungen gemäß der Formel EM-17 sowie Derivate hiervon.

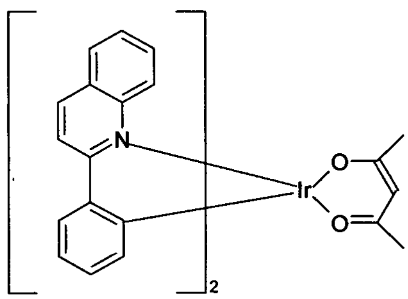

Formel EM-17

Derivate sind beschrieben in der US 7378162 B2, der US 6835469 B2 und der JP 2003/253145 A.

Ferner können die in der US 7238437 B2, der US 2009/008607 A1 und der EP 1348711 beschriebenen Verbindungen gemäß den Formeln EM-18 bis EM-21 sowie deren Derivate als Emitter eingesetzt werden.

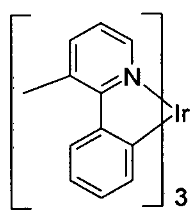

Formel EM-18

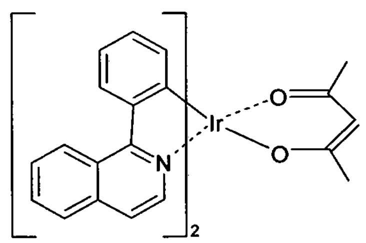

Formel EM-19

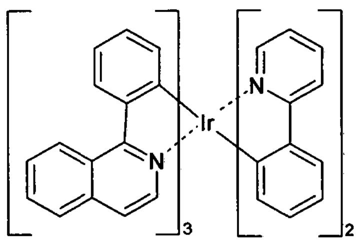

Formel EM-20

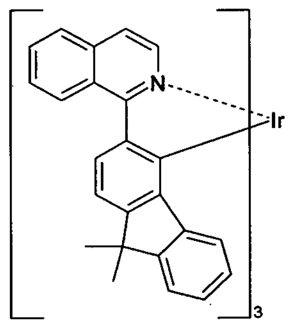

Formel EM-21

Quantum Dots können ebenfalls als Emitter eingesetzt werden, wobei diese Materialien ausführlich in der WO 2011/076314 A1 offenbart werden.

Verbindungen, die als Hostmaterialien, insbesondere zusammen mit emittierenden Verbindungen eingesetzt werden, umfassen Materialien verschiedener Stoffklassen.

Hostmaterialien weisen im Allgemeinen größere Bandlücken zwischen HOMO und LUMO auf, als die eingesetzten Emittermaterialien. Zusätzlich zeigen bevorzugte Hostmaterialien entweder Eigenschaften eines Loch- oder Elektronentransportmaterials. Weiterhin können Hostmaterialien sowohl Elektronen- als auch Lochtransporteigenschaften aufweisen.

Hostmaterialien werden zum Teil auch als Matrixmaterial bezeichnet, insbesondere falls das Hostmaterial in Kombination mit einem phosphoreszierenden Emitter in einer OLED eingesetzt wird.

Bevorzugte Host-Materialien oder Co-Host-Materialien, die insbesondere zusammen mit fluoreszierenden Dotanden eingesetzt werden, sind ausgewählt aus den Klassen der Oligoarylene (z.B. 2,2',7,7'-Tetraphenylspirobifluoren gemäß der EP 676461 oder Dinaphthylanthracen), insbesondere der Oligoarylene enthaltend kondensierte aromatische Gruppen wie z.B. Anthracen, Benzanthracen, Benzphenanthren (DE 10 2009 005746, WO 2009/069566), Phenanthren, Tetracen, Coronen, Chrysen, Fluoren, Spirobifluoren, Perylen, Phthaloperylen, Naphthaloperylen, Decacyclen, Rubren, der Oligoarylenvinylene (z.B. DPVBi = 4,4'-Bis(2,2-diphenyl-ethenyl)-1,1'-biphenyl) oder Spiro-DPVBi gemäß der EP 676461), der polypodalen Metallkomplexe (z.B. gemäß der WO 2004/081017), insbesondere Metallkomplexe von 8-Hydroxychinolin, z.B. $AlQ_3$ (= Aluminium(III)tris(8-hydroxychinolin)) oder Bis(2-methyl-8-chinolinolato)-4-(phenylphenolino-lato)aluminium, auch mit Imidazol-Chelat (US 2007/0092753 A1) sowie der Chinolin-Metallkomplexe, Aminochinolin-Metallkomplexe, Benzochinolin-Metallkomplexe, der lochleitenden Verbindungen (z.B. gemäß der WO 2004/058911), der elektronenleitenden Verbindungen, insbesondere Ketone, Phosphinoxide, Sulfoxide, etc. (z.B. gemäß der WO 2005/084081 und der WO 2005/084082), der Atropisomere (z.B. gemäß der WO 2006/048268), der Boronsäurederivate (z.B. gemäß der WO 2006/117052) oder der Benzanthracene (z.B. gemäß der WO 2008/145239).

Besonders bevorzugte Verbindungen, die als Host-Materialien oder Co-Host-Materialien dienen können, sind ausgewählt aus den Klassen der Oligoarylene, enthaltend Anthracen, Benzanthracen und/oder Pyren oder Atropisomere dieser Verbindungen. Unter einem Oligoarylen im Sinne der vorliegenden Erfindung soll eine Verbindung verstanden werden, in der mindestens drei Aryl- bzw. Arylengruppen aneinander gebunden sind.

Bevorzugte Hostmaterialien sind insbesondere ausgewählt aus Verbindungen der Formel (H-1),

$Ar^4$-($Ar^5$)p-$Ar^6$ (H-1)

wobei $Ar^4$, $Ar^5$, $Ar^6$ bei jedem Auftreten gleich oder verschieden eine Aryl- oder Heteroarylgruppe mit 5 bis 30 aromatischen Ringatomen ist, die gegebenenfalls substituiert sein kann, und p eine ganze Zahl im Bereich von 1 bis 5 darstellt; dabei gilt, dass die Summe der -$\pi$-Elektronen in $Ar^4$, $Ar^5$ und $Ar^6$ mindestens 30 beträgt, wenn p = 1 ist, und mindestens 36 beträgt, wenn p = 2 ist, und mindestens 42 beträgt, wenn p = 3 ist.

Besonders bevorzugt steht in den Verbindungen der Formel (H-1) die Gruppe $Ar^5$ für Anthracen und die Gruppen $Ar^4$ und $Ar^6$ sind in 9- und 10-Position gebunden, wobei diese Gruppen gegebenenfalls substituiert sein können. Ganz besonders bevorzugt ist mindestens eine der Gruppen $Ar^4$ und/oder $Ar^6$ eine kondensierte Arylgruppe, ausgewählt aus 1- oder 2-Naphthyl, 2-, 3- oder 9-Phenanthrenyl oder 2-, 3-, 4-, 5-, 6- oder 7-Benzanthracenyl. Anthracen-basierte Verbindungen werden beschrieben in der US 2007/0092753 A1 und der US 2007/0252517 A1, z.B. 2-(4-Methylphenyl)-9,10-di-(2-naphthyl)anthracen, 9-(2-Naphthyl)-10-(1,1'-biphenyl)anthracen und 9,10-Bis[4-(2,2-diphenylethenyl)phenyl]anthracen, 9,10-Diphenylanthracen, 9,10-Bis(phenylethynyl)anthracen und 1,4-Bis(9'-ethynylanthracenyl)benzol. Bevorzugt sind auch Verbindungen mit zwei Anthraceneinheiten (US 2008/0193796 A1), z.B. 10,10'-Bis[1,1',4', 1"]terphenyl-2-yl-9,9'-bisanthracenyl.

Weitere bevorzugte Verbindungen sind Derivate von Arylamin, Styrylamin, Fluorescein, Diphenylbutadien, Tetraphenylbutadien, Cyclopentadien, Tetraphenylcyclopentadien, Pentaphenylcyclopentadien, Cumarin, Oxadiazol, Bisbenzoxazolin, Oxazol, Pyridin, Pyrazin, Imin, Benzothiazol, Benzoxazol, Benzimidazol (US 2007/0092753 A1), z.B. 2,2',2"-(1,3,5-Phenylen)tris[1-phenyl-1H-benzimidazol], Aldazin, Stilben, Styrylarylenderivate, z.B. 9,10-Bis[4-(2,2-diphenylethenyl)phenyl]anthracen und Distyrylarylen-Derivate (US 5121029), Diphenylethylen, Vinylanthracen, Diaminocarbazol, Pyran, Thiopyran, Diketopyrrolopyrrol, Polymethin, Zimtsäureestern und Fluoreszenzfarbstoffen.

Besonders bevorzugt sind Derivate von Arylamin und Styrylamin, z.B. TNB (=4,4'-Bis[N-(1-naphthyl)-N-(2-naphthyl)amino]biphenyl). Metall-Oxinoid-Komplexe wie LiQ oder $AlQ_3$ können als Co-Hosts verwendet werden.

Bevorzugte Verbindungen mit Oligoarylen als Matrix werden in der US 2003/0027016 A1, der US 7326371 B2, der US 2006/043858 A, der WO 2007/114358, der WO 2008/145239, der JP 3148176 B2, der EP 1009044, der US 2004/018383, der WO 2005/061656 A1, der EP 0681019B1, der WO 2004/013073A1, der US 5077142, der WO 2007/065678 und der DE 102009005746 offenbart, wobei besonders bevorzugte Verbindungen durch die Formeln H-2 bis H-8 beschrieben sind.

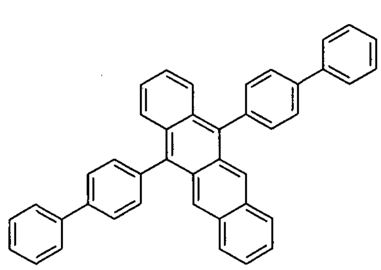

Formel H-2

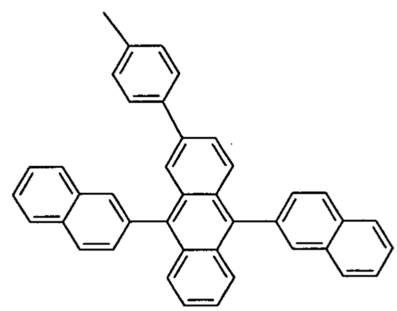

Formel H-3

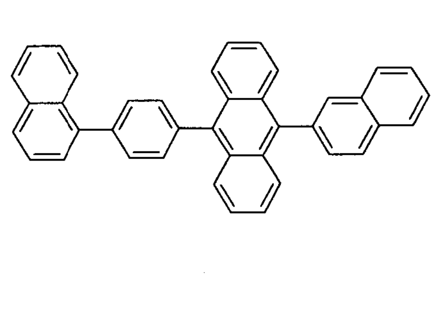

Formel H-4

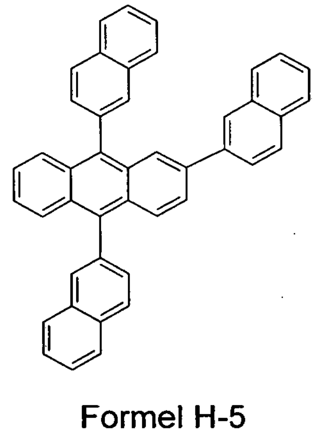

Formel H-5

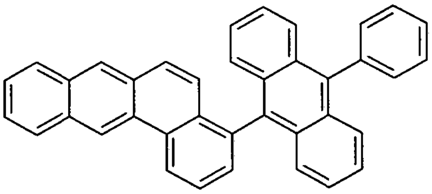

Formel H-6

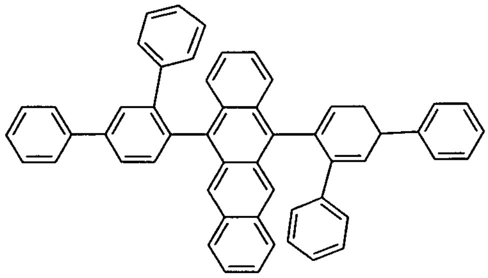

Formel H-7

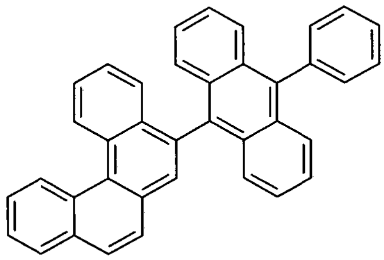

Formel H-8

Weiterhin umfassen Verbindungen, die als Host oder Matrix eingesetzt werden können, Materialien, die zusammen mit phosphoreszierenden Emittern eingesetzt werden. Zu diesen Verbindungen, die auch als Strukturelemente in Polymeren eingesetzt werden können, gehören CBP (N,N-Biscarbazolylbiphenyl), Carbazolderivate (z.B. gemäß der WO 2005/039246, der US 2005/0069729, der JP 2004/288381, der EP 1205527 oder der WO 2008/086851), Azacarbazole (z.B. gemäß der EP 1617710, der EP 1617711, der EP 1731584 oder der JP 2005/347160), Ketone (z.B. gemäß der WO 2004/093207 oder gemäß der DE 102008033943), Phosphinoxide, Sulfoxide und Sulfone (z.B. gemäß der WO 2005/003253), Oligophenylene, aromatische Amine (z.B. gemäß der US 2005/0069729), bipolare Matrixmaterialien (z.B. gemäß der WO 2007/137725), Silane (z.B. gemäß der WO 2005/111172), 9,9-Diarylfluorenderivate (z.B. gemäß der DE 102008017591), Azaborole oder Boronester (z.B. gemäß der WO 2006/117052), Triazin-Derivate (z.B. gemäß der DE 102008036982), Indolocarbazolderivate (z.B. gemäß der WO 2007/063754 oder der WO 2008/056746), Indenocarbazolderivate (z.B. gemäß der DE 102009023155 und der DE 102009031021), Diazaphosphol-derivate (z.B. gemäß der DE 102009022858), Triazol-Derivate, Oxazole und Oxazol-Derivate, Imidazol-Derivate, Polyarylalkan-Derivate, Pyrazolin-Derivate, Pyrazolon-Derivate, Distyrylpyrazin-Derivate, Thiopyrandioxid-Derivate, Phenylendiamin-Derivate, tertiäre aromatische Amine, Styrylamine, Amino-substituierte Chalcon-Derivate, Indole, Hydrazon-Derivate, Stilben-Derivate, Silazan-Derivate, aromatische Dimethyliden-Verbindungen, Carbodiimid-Derivate, Metallkomplexe von 8-Hydroxy-chinolin-Derivaten wie z.B. $AlQ_3$, die 8-Hydroxychinolin-Komplexe können auch Triarylaminophenol-Liganden enthalten (US 2007/0134514 A1), Metallkomplex-Polysilan-Verbindungen sowie Thiophen-, Benzothiophen- und Dibenzothiophen-Derivate.

Beispiele für bevorzugte Carbazol-Derivate sind mCP (= 1,3-N,N-dicarbazol-benzol (= 9,9'-(1,3-Phenylen)bis-9H-carbazol)) (Formel H-9), CDBP (= 9,9'-(2,2'-Dimethyl[1,1'-biphenyl]-4,4'-diyl)bis-9H-carbazol), 1,3-Bis(N,N'-dicarbazol)benzol (= 1,3-Bis(carbazol-9-yl)benzol), PVK (Polyvinylcarbazol), 3,5-Di(9H-carbazol-9-yl)biphenyl sowie CMTTP (Formel H10). Besonders bevorzugte Verbindungen werden in der US 2007/0128467 A1 und der US 2005/0249976 A1 offenbart (Formeln H-11 bis H-13).

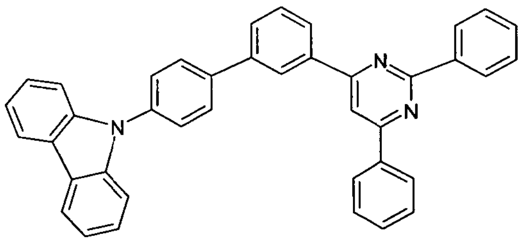

Formel H-9

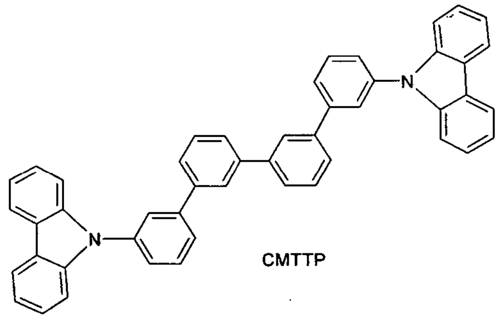

CMTTP

Formel H-10

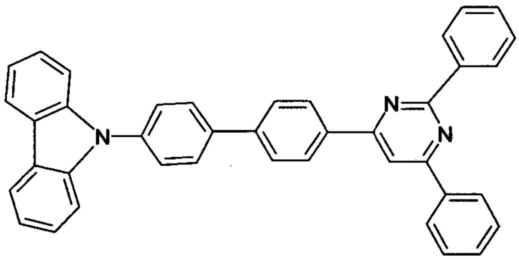

Formel H-11

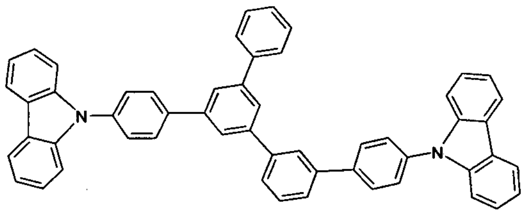

Formel H-12

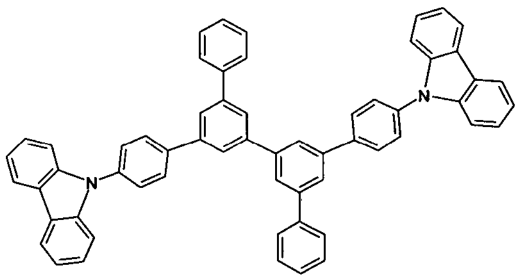

Formel H-13

Bevorzugte Si-Tetraaryle werden z.B. in der US 2004/0209115, der US 2004/0209116, der US 2007/0087219 A1 und in H. Gilman, E.A. Zuech, Chemistry & Industry (London, United Kingdom), 1960, 120 offenbart.

Besonders bevorzugte Si-Tetraaryle werden durch die Formeln H-14 bis H-21 beschrieben.

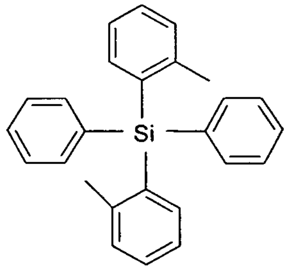

UGH1

Formel H-14

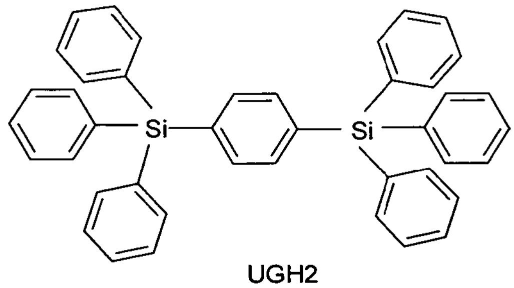

UGH2

Formel H-15

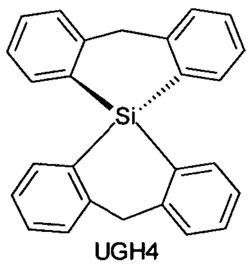

UGH4

Formel H-16

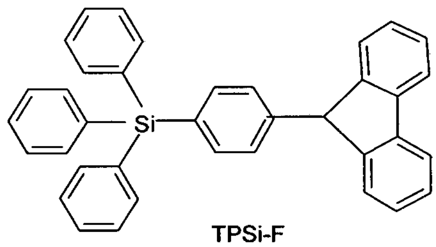

TPSi-F

Triphenyl-[4-(9-phenyl-9H-fluoren-9-yl)phenyl]silane

Formel H-17

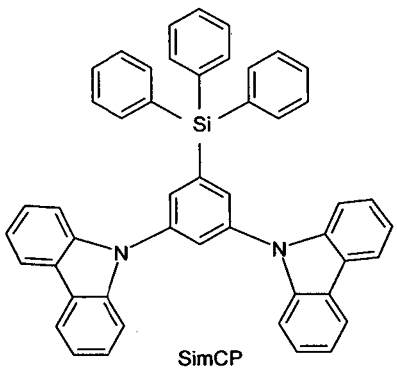

SimCP

Formel H-18

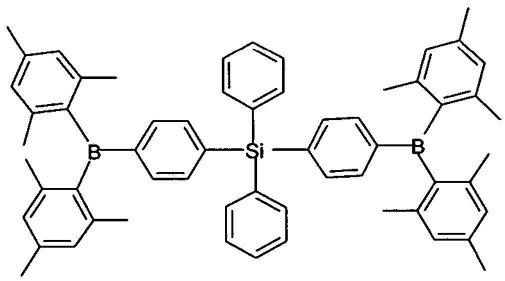

Formel H-19

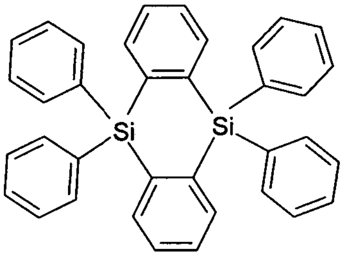

Formel H-20

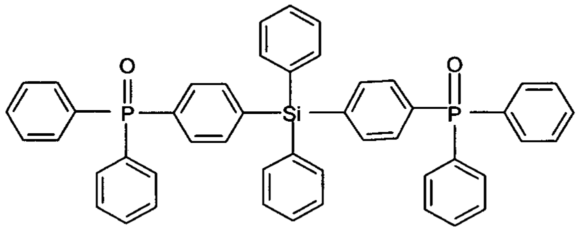

Formel H-21

Besonders bevorzugte Verbindungen gemäß Gruppe 4 zur Herstellung der Matrix für phosphoreszierende

Dotanden werden unter anderem in der DE 102009022858, der DE 102009023155, der EP 652273 B1, der WO 2007/063754 und der WO 2008/056746 offenbart, wobei besonders bevorzugte Verbindungen durch die Formeln H-22 bis H-25 beschrieben werden.

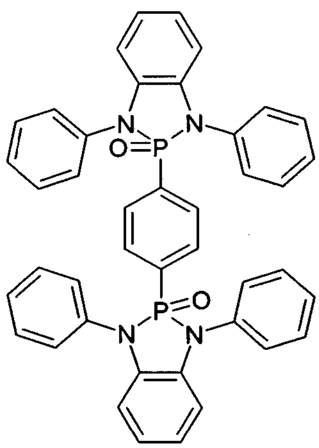

Formel H-22

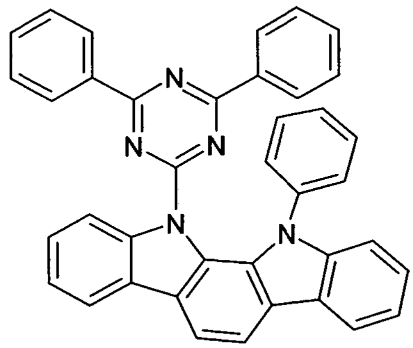

Formel H-23

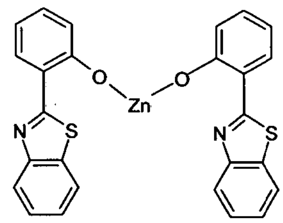

Formel H-24

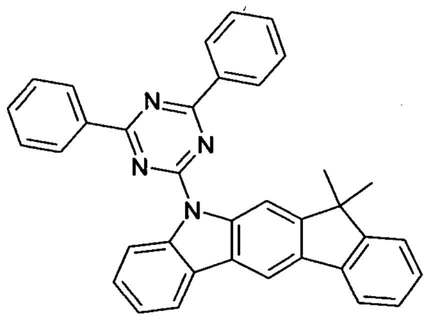

Formel H-25

Verbindungen, die als Hostmaterial dienen können, sind insbesondere Stoffe bevorzugt, die mindestens ein Stickstoffatom aufweisen. Hierzu gehören vorzugsweise aromatische Amine, Triazin- und Carbazol-Derivate. So zeigen insbesondere Carbazol-Derivate eine überraschend hohe Effizienz. Triazin-Derivate führen zu unerwartet hohen Lebensdauern der elektronischen Vorrichtungen.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z.B. in der WO 2010/108579 beschrieben.

Weiterhin können Verbindungen eingesetzt werden, welche den Übergang vom Singulett- zum Triplettzustand verbessern und welche, unterstützend zu den funktionellen Verbindungenn mit Emittereigenschaften eingesetzt, die Phosphoreszenzeigenschaften dieser Verbindungen verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 beschrieben werden.

Unter n-Dotanden werden hierin Reduktionsmittel, d.h. Elektronendonatoren verstanden. Bevorzugte Beispiele für n-Dotanden sind W(hpp)4 und weitere elektronenreiche Metallkomplexe gemäß der WO 2005/086251 A2, P=N-Verbindungen (z.B. WO 2012/175535 A1, WO 2012/175219 A1), Naphthylencarbodiimide (z.B. WO 2012/168358 A1), Fluorene (z.B. WO 2012/031735 A1), Radikale und Diradikale (z.B. EP 1837926 A1, WO 2007/107306 A1), Pyridine (z.B. EP 2452946 A1, EP 2463927 A1), N-heterocyclische Verbindungen (z.B. WO 2009/000237 A1) und Acridine sowie Phenazine (z.B. US 2007/145355 A1).

Die iedermolekulare Verbindungen haben ein Molekulargewicht von ≤ 3.000 g/mol, besonders bevorzugt von ≤ 2.000 g/mol und insbesondere bevorzugt von ≤ 1.000 g/mol.

Von besonderem Interesse sind des Weiteren funktionelle Verbindungen, die sich durch eine hohe Glasübergangstemperatur auszeichnen. In diesem Zusammenhang sind insbesondere funktionelle Verbindungen, die in den Formulierungen als organisch funktionelles Material eingesetzt werden können, bevorzugt, die eine Glasübergangstemperatur von ≥ 70°C, bevorzugt von ≥ 100°C, besonders bevorzugt von ≥ 125°C und insbesondere bevorzugt von ≥ 150°C aufweisen, bestimmt nach DIN 51005.

enthalten mindestens Die erfindungsgemäßen Formulierungen ein niedermolekulares, organisches Matrixmaterial und mindestens einen niedermolekularen Emitter, ausgewählt aus fluoreszierenden und phosphoreszierenden Emittern, welche zur Herstellung von emittierenden Schichten organischer Elektrolumineszenzvorrichtungen einsetzbar sind.

**Der Anteil an** organisch, niedermolekularem Matrixmaterial und niedermolekularem Emitter, welche zur Herstellung von emittierenden Schichten organischer Elektrolumineszenzvorrichtungen einsetzbar sind, in der Formulierung liegt vorzugsweise im Bereich von 0,1 bis 20 Gew.-%, besonders bevorzugt im Bereich von 0,3 bis 10 Gew.-%, und insbesondere bevorzugt im Bereich von 0,5 bis 5 Gew.-%, bezogen auf das Gesamtgewicht der Formulierung.

Neben den genannten Komponenten kann die erfindungsgemäße Formulierung weitere Additive und Verarbeitungshilfsmittel umfassen. Hierzu gehören unter anderem oberflächenaktive Stoffe, Tenside, Gleit- und Schmiermittel, Additive, die die Leitfähigkeit erhöhen, Dispergiermittel, Hydrophobisierungsmittel, Haftvermittler, Fließverbesserer, Entschäumer, Entlüfter, Verdünnungsmittel, die reaktiv oder unreaktiv sein können, Füllstoffe, Hilfsstoffe, Verarbeitungshilfsmittel, Farbstoffe, Pigmente, Stabilisatoren, Sensibilisatoren, Nanopartikel und Inhibitoren.

In einer besonderen Ausführungsform der vorliegenden Erfindung können die Formulierungen Lösungsmitteln enthalten, die sich von den Verbindungen gemäß den Formeln (1) oder (2) unterscheiden. Diese Lösungsmittel können auch als Colösungsmittel zusammen mit den Verbindungen gemäß den Formeln (1) oder (2) eingesetzt werden.

Geeignete Lösungsmittel, vorzugsweise organische Lösungsmittel, umfassen unter anderem Ketone, Ester, Amide, Schwefelverbindungen, Nitroverbindungen, halogenierte Kohlenwasserstoffe und Kohlenwasserstoffe.

Aromatische und heteroaromatische Kohlenwasserstoffe, Di-$C_{1-2}$-alkyl formamide, und chlorierte Kohlenwasserstoffe sind bevorzugte organische Lösungsmittel.

Besonders bevorzugte organische Lösungsmittel sind beispielsweise 1,2,3,4-Tetramethylbenzol, 1,2,3,5-Tetramethylbenzol, 1,2,3-Trimethylbenzol, 1,2,4,5-Tetramethylbenzol, 1,2,4-Trichlorbenzol, 1,2,4-Trimethylbenzol, 1,2-Dihydronaphthalin, 1,2-Dimethylnaphthalin, 1,3-Benzodioxolan, 1,3-Diisopropylbenzol, 1,3-Dimethylnaphthalin, 1,4-Benzodioxan, 1,4-Diisopropylbenzol, 1,4-Dimethylnaphthalin, 1,5-Dimethyltetralin, 1-Benzothiophen, Thianaphthalin, 1-Bromnaphthalin, 1-Chlormethyl-Naphthalin, 1-Ethyl-Naphthalin, 1-Methoxy-Naphthalin, 1-Methylnaphthalin, 1-Methylindol, 2,3-Benzofuran, 2,3-Dihydrobenzofuran, 2,3-Dimethylanisol, 2,4-Dimethylanisol, 2,5-Dimethylanisol, 2,6-Dimethylanisol, 2,6-Dimethylnaphthalin, 2-Brom-3-Brommethylnaphthalin, 2-Brommethylnaphthalin, 2-Bromnaphthalin, 2-Ethoxynaphthalin, 2-Ethylnaphthalin, 2-Isopropylanisol, 2-Methylanisol, 2-Methyl-indol, 3,4-Dimethylanisol, 3,5-Dimethylanisol, 3-Bromchinolin, 3-Methylanisol, 4-Methylanisol, 5-Decanolide, 5-Methoxyindan, 5-Methoxyindole, 5-tert-Butylm-Xylol, 6-Methylchinolin, 8-Methylchinolin, Acetophenon, Anisol, Benzonitril, Benzothiazol, Benzylacetat, Brombenzol, Butylbenzoat, Butylphenylether, Cyclohexylbenzol, Decahydronaphthol, Dimethoxytoluol, Diphenylether, Propiophenon, Ethylbenzol, Ethylbenzoat, γ-Terpinen, Hexylbenzol, Indan, Inden, Isochroman, Cumol, m-Cymol, Mesitylen, Methylbenzoat, o-, m-, p-Xylol, Propylbenzoat, Propylbenzol, o-Dichlorbenzol, Pentylbenzol, Phenetol, Ethoxybenzol, Phenylacetat, p-Cymol, Propiophenon, sec-Butylbenzol, t-Butylbenzol, Thiophen, Toluol, Veratrol, Monochlorbenzol, o-Dichlorbenzol, Pyridine, Pyrazine, Pyrimidine, Pyrrolidinone, Morpholin, Dimethylacetamid, Dimethylsulfoxid, Decalin und/oder Mischungen dieser Verbindungen.

Die Lösungsmittel können einzeln oder als Mischung von zwei, drei oder mehreren Verbindungen eingesetzt werden.

Ein weiterer Gegenstand der vorliegenden Erfindung ist ein Verfahren zur Herstellung einer erfindungsgemäßen Formulierung durch Mischen einer Verbindung gemäß einer der Formeln (1) oder (2) mit einem niedermolekularen organischen Matrixmaterial und mit einem niedermolekularen Emitter, welche zur Herstellung von emittierenden Schichten organischer Elektrolumineszenzvorrichtungen einsetzbar sind.

Eine Formulierung gemäß der vorliegenden Erfindung kann zur Herstellung einer Schicht oder Mehrschichtstruktur eingesetzt werden, in der das Matrixmaterial und der Emitter lagenweise vorhanden sind, wie diese für die Herstellung von OLEDs benötigt werden.

Die Formulierung der vorliegenden Erfindung kann vorzugsweise zur Bildung von emittierenden Schichten auf einem Substrat oder eine der auf das Substrat aufgetragenen Schichten eingesetzt werden.

Ein Verfahren zur Herstellung einer organischen Elektrolumineszenzvorrichtung, bei dem eine erfindungsgemäße Formulierung auf ein Substrat aufgetragen und getrocknet wird, ist ebenfalls Gegenstand der vorliegenden Erfindung.

Die Erzeugung der emittierenden Schichten kann beispielsweise durch Flutbeschichtung, Tauchbeschichtung, Sprühbeschichtung, Spincoating, Siebdruck, Hochdruck, Tiefdruck, Rotationsdruck, Walzenbeschichtung, Flexodruck, Offsetdruck oder Nozzle-Printing, vorzugsweise Ink-Jet-Druck auf ein Substrat oder eine der auf das Substrat aufgetragenen Schichten erfolgen.

Nach dem Auftragen einer erfindungsgemäßen Formulierung auf ein Substrat oder eine bereits aufgebrachte Funktionsschicht kann ein Trocknungsschritt erfolgen, um das Lösungsmittel der zuvor dargelegten kontinuierlichen Phase zu entfernen. Bevorzugt kann die Trocknung bei relativ geringer Temperatur und über einen relativ großen Zeitraum erfolgen, um eine Blasenbildung zu vermeiden und eine gleichmäßige Beschichtung zu erhalten. Vorzugsweise kann die Trocknung bei einer Temperatur im Bereich von 80 bis 300°C, besonders bevorzugt von 150 bis 250°C und insbesondere bevorzugt von 180 bis 200°C durchgeführt werden. Hierbei kann die Trocknung vorzugsweise bei einem Druck im Bereich von $10^{-6}$ mbar bis 2 bar, besonders bevorzugt im Bereich von $10^{-2}$ mbar bis 1 bar und insbesondere bevorzugt im Bereich von $10^{-1}$ mbar bis 100 mbar erfolgen. Die Dauer der Trocknung richtet sich nach dem zu erreichenden Trocknungsgrad, wobei geringe Mengen an Wasser gegebenenfalls bei höherer Temperatur und in Zusammenhang mit einer vorzugsweise durchzuführenden Sinterung entfernt werden können. Ferner kann vorgesehen sein, dass das Verfahren mehrfach wiederholt wird, wobei verschiedene oder gleiche emittierenden Schichten gebildet werden. Hierbei kann eine Vernetzung der gebildeten Schichten erfolgen, um ein Lösen derselben zu verhindern, wie dies z.B. in der EP 0 637 899 A1 offenbart wird.

Die organische Elektrolumineszenzvorrichtung der vorliegenden Erfindung enthält Kathode, Anode und mindestens eine emittierende Schicht.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum.

Der Anteil des Matrixmaterials in der emittierenden Schicht liegt in diesem Fall vorzugsweise zwischen 50 und 99,9 Vol.-%, besonders bevorzugt zwischen 80 und 99,5 Vol.-% und insbesondere bevorzugt für fluoreszierende emittierende Schichten zwischen 92 und 99,5 Vol.-% sowie für phosphoreszierende emittierende Schichten zwischen 85 und 97 Vol.-%.

Entsprechend liegt der Anteil des Dotanden vorzugsweise zwischen 0,1 und 50 Vol.-%, besonders bevorzugt zwischen 0,5 und 20 Vol.-% und insbesondere bevorzugt für fluoreszierende emittierende Schichten zwischen 0,5 und 8 Vol.-% sowie für phosphoreszierende emittierende Schichten zwischen 3 und 15 Vol.-%.

Eine emittierende Schicht einer organischen Elektrolumineszenzvorrichtung kann auch Systeme umfassen, die mehrere Matrixmaterialien (Mixed-Matrix-Systeme) und/oder mehrere Dotanden enthalten. Auch in diesem Fall sind die Dotanden im Allgemeinen diejenigen Materialien, deren Anteil im System der kleinere ist und die Matrixmaterialien sind diejenigen Materialien, deren Anteil im System der größere ist. In Einzelfällen kann jedoch der Anteil eines einzelnen Matrixmaterials im System kleiner sein als der Anteil eines einzelnen Dotanden.

Die Mixed-Matrix-Systeme umfassen bevorzugt zwei oder drei verschiedene Matrixmaterialien, besonders bevorzugt zwei verschiedene Matrixmaterialien. Bevorzugt stellt dabei eines der beiden Materialien ein Material mit lochtransportierenden Eigenschaften und das andere Material ein Material mit elektronentransportierenden Eigenschaften dar. Die gewünschten elektronentransportierenden und lochtransportierenden Eigenschaften der Mixed-Matrix-Komponenten können jedoch auch hauptsächlich oder vollständig in einer einzigen Mixed-Matrix-Komponente vereinigt sein, wobei die weitere bzw. die weiteren Mixed-Matrix-Komponenten andere Funktionen erfüllen. Die beiden unterschiedlichen Matrixmaterialien können dabei in einem Verhältnis von 1:50 bis 1:1, bevorzugt von 1:20 bis 1:1, besonders bevorzugt von 1:10 bis 1:1 und insbesondere bevorzugt von 1:4 bis 1:1 vorliegen. Bevorzugt werden Mixed-Matrix-Systeme in phosphoreszierenden organischen Elektrolumineszenzvorrichtungen eingesetzt. Detailliertere Angaben zu Mixed-Matrix-Systemen finden sich z.B. in der WO 2010/108579.

Außer diesen Schichten kann eine organische Elektrolumineszenzvorrichtung noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten (Charge-Generation Layers, IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer) und/oder organische oder anorganische p/n-Übergänge. Dabei ist es möglich, dass eine oder mehrere Lochtransportschichten p-dotiert sind, beispielsweise mit Metalloxiden, wie $MoO_3$ oder $WO_3$ oder mit (per)fluorierten elektronenarmen Aromaten, und/oder dass eine oder mehrere Elektronentransportschichten n-dotiert sind. Ebenso können zwischen zwei emittierende Schichten Interlayer eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss. Diese Schichten können ebenfalls unter Verwendung der erfindungsgemäßen Formulierungen, wie oben definiert, enthalten werden.

Gegenstand der vorliegenden Erfindung ist somit auch eine Schicht, insbesondere eine organische Schicht, enthaltend eine oder mehrere grenzflächenaktive Polymere, wie oben definiert.

In einer weiteren Ausführungsform der vorliegenden Erfindung umfasst die Vorrichtung mehrere Schichten. Die erfindungsgemäße Formulierung wird zur Herstellung einer Emissionsschicht eingesetzt.

Gegenstand der vorliegenden Erfindung ist dementsprechend auch eine Elektrolumineszenzvorrichtung, die mindestens drei, in einer bevorzugten Ausführungsform aber alle genannten Schichten aus Lochinjektions-, Lochtransport-, Emissions-, Elektronentransport-, Elektroneninjektions-, Ladungsblockier- und/oder Ladungserzeugungsschicht enthält und in der mindestens eine Emissionsschicht durch eine erfindungsgemäß einzusetzende Formulierung erhalten wurde. Die Dicke der Schichten, beispielsweise der Lochtransport- und/oder Lochinjektionsschicht kann vorzugsweise im Bereich von 1 bis 500 nm, besonders bevorzugt im Bereich von 2 bis 200 nm liegen.

Die Vorrichtung kann ferner Schichten enthalten, welche aus weiteren niedermolekularen Verbindungen oder Polymeren aufgebaut sind, die nicht durch die Verwendung von erfindungsgemäßen Formulierungen aufgebracht wurden. Diese können auch durch Verdampfen von niedermolekularen Verbindungen im Hochvakuum erzeugt werden.

Es kann außerdem bevorzugt sein, die einzusetzenden Verbindungen nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren.

In der vorliegenden Erfindung umfassen die erfindungsgemäßen Formulierungen, organisch niedermolekulare Materialien, die als Hostmaterialien oder Matrixmaterialien in einer emittierenden Schicht eingesetzt werden. Hierbei umfasst die Formulierung zusätzlich zu den Hostmaterialien oder Matrixmaterialien die zuvor dargelegten Emitter. Dabei kann die organische Elektrolumineszenzvorrichtung eine oder mehrere emittierende Schichten enthalten. Wenn mehrere Emissionsschichten vorhanden sind, weisen diese vorzugsweise mehrere Emissionsmaxima zwischen 380 nm und 750 nm auf, so dass insgesamt weiße Emission resultiert, d.h. in den emittierenden Schichten werden verschiedene emittierende Verbindungen verwendet, die fluoreszieren oder phosphoreszieren können. Ganz besonders bevorzugt sind Dreischichtsysteme, wobei die drei Schichten blaue, grüne und orange oder rote Emission zeigen (für den prinzipiellen Aufbau siehe z.B. WO 2005/011013). Weiß emittierende Vorrichtungen eignen sich z.B. als Hintergrundbeleuchtung von LCD-Displays oder für generelle Beleuchtungsanwendungen.

Möglich ist auch, dass mehrere OLEDs übereinander angeordnet werden, wodurch eine weitere Effizienzsteigerung hinsichtlich der Lichtausbeute erreicht werden kann.

Zur Verbesserung der Lichtauskopplung kann die letzte organische Schicht auf der Lichtaustrittseite bei OLEDs z.B. auch als Nanoschaum ausgeführt sein, wodurch der Anteil der Totalreflexion verringert wird.

Weiterhin bevorzugt ist eine organische Elektrolumineszenzvorrichtung, wobei eine oder mehrere Schichten mit einem Sublimationsverfahren aufgebracht werden. Dabei werden die Materialien in Vakuum-Sublimationsanlagen bei einem Druck kleiner $10^{-5}$ mbar, vorzugsweise kleiner $10^{-6}$ mbar, besonders bevorzugt kleiner $10^{-7}$ mbar aufgedampft. Ferner kann vorgesehen sind, dass eine oder mehrere Schichten einer erfindungsgemäßen elektronischen Vorrichtung mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ferner kann vorgesehen sind, dass eine oder mehrere Schichten einer emittierenden Vorrichtung erfindungsgemäßen aus Lösung, wie z.B. durch Spincoating, oder mit einem beliebigen Druckverfahren, wie z.B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden.

Hierbei können diese Schichten auch durch Verfahren aufgetragen werden, bei denen keine Verbindung gemäß den Formeln (1) oder (2) eingesetzt werden. Vorzugsweise kann hierbei ein orthogonales Lösungsmittel verwendet werden, welches zwar das Funktionsmaterial einer aufzutragenden Schicht löst, nicht jedoch die Schicht, auf die das Funktionsmaterial aufgetragen wird.

Die Vorrichtung enthält gewöhnlich eine Kathode und eine Anode (Elektroden). Die Elektroden (Kathode, Anode) werden im Sinne der vorliegenden Erfindung so gewählt, dass ihre Bandenergien möglichst gut mit denen der angrenzenden, organischen Schichten übereinstimmen, um eine möglichst effiziente Elektronen- bzw. Lochinjektion zu gewährleisten.

Als Kathode sind Metallkomplexe, Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z.B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z.B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide in Frage (z.B. LiF, $Li_2O$, $BaF_2$, MgO, NaF, etc.). Die Schichtdicke dieser Schicht liegt vorzugsweise zwischen 0,1 und 10 nm, besonders bevorzugt zwischen 0,2 und 8 nm, insbesondere bevorzugt zwischen 0,5 und 5 nm.

Als Anode sind Materialien mit hoher Austrittsarbeit bevorzugt. Vorzugsweise weist die Anode ein Potential größer 4,5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z.B. Al/Ni/$NiO_x$, Al/$PtO_x$) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter

Aufbau verwendet eine transparente Anode. Bevorzugte Anodenmaterialien sind hier leitfähige, gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere, wie z.B Poly(ethylendioxy-thiophen) (PEDOT) und Polyanilin (PANI) oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise $MoO_3$ oder $WO_3$, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird in an sich bekannter Weise je nach Anwendung entsprechend strukturiert, kontaktiert und schließlich hermetisch versiegelt, da sich die Lebensdauer derartiger Vorrichtungen bei Anwesenheit von Wasser und/oder Luft drastisch verkürzt.

Die erfindungsgemäßen Formulierungen, die hieraus erhältlichen organischen Elektrolumineszenzvorrichtungen, zeichnen sich durch einen oder mehrere der folgenden überraschenden Vorteile gegenüber dem Stand der Technik aus:

1. Die mit den erfindungsgemäßen Formulierungen erhältlichen Elektrolumineszenzvorrichtungen zeigen eine sehr hohe Stabilität und eine sehr hohe Lebensdauer im Vergleich zu Elektrolumineszenzvorrichtungen, die mit konventionellen Methoden erhalten werden.

2. Die erfindungsgemäßen Formulierungen können mit konventionellen Verfahren verarbeitet werden, so dass auch hierdurch Kostenvorteile erzielt werden können.

3. Die in den erfindungsgemäßen Formulierungen eingesetzten niedermolekularen Materialien unterliegen keinen besonderen Begrenzungen, so dass das Verfahren der vorliegenden Erfindung umfassend eingesetzt werden kann.

4. Die mit den Formulierungen der vorliegenden Erfindung erhältlichen Beschichtungen zeigen eine ausgezeichnete Qualität, insbesondere im Hinblick auf die Gleichmäßigkeit der Beschichtung.

Diese oben genannten Vorteile gehen nicht mit einer Verschlechterung der weiteren elektronischen Eigenschaften einher.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbarte Merkmal, sofern nichts anderes gesagt wird, als Beispiel einer generischen Reihe oder als äquivalentes oder ähnliches Merkmal zu betrachten.

Alle Merkmale der vorliegenden Erfindung können in jeder Art miteinander kombiniert werden, es sei denn, dass sich bestimmte Merkmale und/oder Schritte gegenseitig ausschließen. Dies gilt insbesondere für bevorzugte Merkmale der vorliegenden Erfindung. Gleichermaßen können Merkmale nicht wesentlicher Kombinationen separat verwendet werden (und nicht in Kombination).

Es sei ferner darauf hingewiesen, dass viele der Merkmale, und insbesondere die der bevorzugten Ausführungsformen der vorliegenden Erfindung selbst erfinderisch und nicht lediglich als Teil der Ausführungsformen der vorliegenden Erfindung zu betrachten sind. Für diese Merkmale kann ein unabhängiger Schutz zusätzlich oder alternativ zu jeder gegenwärtig beanspruchten Erfindung begehrt werden.

Die mit der vorliegenden Erfindung offengelegte Lehre zum technischen Handeln kann abstrahiert und mit anderen Beispielen kombiniert werden.

Die Erfindung wird im Folgenden anhand von Ausführungsbeispielen näher erläutert, ohne dadurch jedoch beschränkt zu werden.

Der Fachmann kann aus den Schilderungen ohne erfinderisches Zutun weitere erfindungsgemäße elektronische Vorrichtungen herstellen und somit die Erfindung im gesamten beanspruchten Bereich ausführen.

## Ausführungsbeispiele

Für die Tests werden fünf OLED-Bauteile mit der in Figur 1 beschriebenen Schichtabfolge hergestellt. Dabei wird das Lösungsmittel der Formulierung für die Emitterschicht (G-EML) variiert. Für das Referenzbauteil wird 3-Phenoxytoluol verwendet, für Beispiel 1 eine Mischung aus Hexamethylindan (HMI) und Butylbenzoat (BB) im Mischungsverhältnis 60:40 (Gewichtsverhältnis), für Beispiel 2 eine Mischung aus HMI und BB im Verhältnis 50:50, für Beispiel 3 eine Mischung aus HMI und Cyclohexylbenzol (CHB) im Verhältnis 50:50 und für Beispiel 4 eine Mischung aus HMI und CHB im Verhältnis 60:40. Tabelle 1 fasst Konzentration, Viskosität und Oberflächenspannung der verwendeten Formulierungen zusammen.

**Tabelle 1**

| **Messwerte der für die Emitterschicht verwendeten Formulierungen** | | | | |
|---|---|---|---|---|
| Schicht | Formulierung | Konz. (g/l) | Viskosität (mPas) | Oberflächenspannung (mN/m) |
| G-EML | Referenz | 14 | 4,8 | 37,6 |
| G-EML | Beispiel 1 | 14 | 5,7 | 30,6 |
| G-EML | Beispiel 2 | 14 | 5,5 | 30,9 |
| G-EML | Beispiel 3 | 14 | 4,7 | 31,5 |
| G-EML | Beispiel 4 | 14 | 5,5 | 31,4 |

**Messung der Viskosität und der Oberflächenspannung**

Die Viskosität der verwendeten Formulierungen wird mit einem Rheometer mit Kegel/Platte-Messgeometrie gemessen. Die in Tabelle 1 angegebenen Viskositäten werden bei einer Temperatur von 23,4°C und einer Scherrate von 500 $s^{-1}$ ermittelt.

Die Oberflächenspannung wird mittels einem optischen Verfahren (Pendant Drop = hängender Tropfen) ermittelt. Bei diesem Messverfahren wird aus der Deformation eines hängenden Tropfens durch die Schwerkraft die Oberflächenspannung der Flüssigkeit berechnet. Die Oberflächenspannung wird bei Raumtemperatur, üblicherweise im Bereich von 22°C bis 24°C, gemessen.

**Herstellung der Testbauteile:**

Mit ITO und einer Bankstruktur beschichtete Glassubstrate werden im Reinraum im Ultraschallbad unter Verwendung von DI-Wasser gereinigt, getrocknet und anschließend einer Plasmabehandlung unterzogen (5 s Sauerstoffplasma, gefolgt von 40 s $CF_4$-Plasma). Danach wird ebenfalls im Reinraum eine 80 nm Schicht PEDOT (PEDOT ist ein Polythiophen-Derivat (Baytron PJET HC V2) von H. C. Starck, Goslar, das als wässrige Dispersion geliefert wird) durch Tintenstrahldruck aufgebracht. Um Restwasser aus der Schicht zu entfernen, werden die Substrate für 10 Minuten bei 180°C auf einer Heizplatte ausgeheizt. Danach wird unter Inertgasatmosphäre (Stickstoff bzw. Argon) 20 nm einer Interlayer (typischerweise ein lochdominiertes Polymer, hier HL-X026 von Merck) aus Mesitylenlösung (Konzentration 5 g/l) aufgebracht. Die Schicht wird bei 180°C mindestens 60 Minuten ausgeheizt. Anschließend wird die Emissionsschicht (G-EML) auf die Lochtransportschicht mittels Tintenstrahldruck aufgebracht, im Vakuum getrocknet und anschließend für 10 Minuten bei 160°C auf einer Heizplatte ausgeheizt.

Die Emissionsschicht besteht dabei aus den folgenden drei Materialien TH-1, TH-2 und TE-1, die im Verhältnis 40:40:20 eingesetzt werden, und zwar in einer Konzentration von 14 g/l, bezogen auf das jeweilige Lösungsmittelgemisch. Die Dicke der Emissionsschicht beträgt 60 nm.

| | |
|---|---|
| TH-1 | 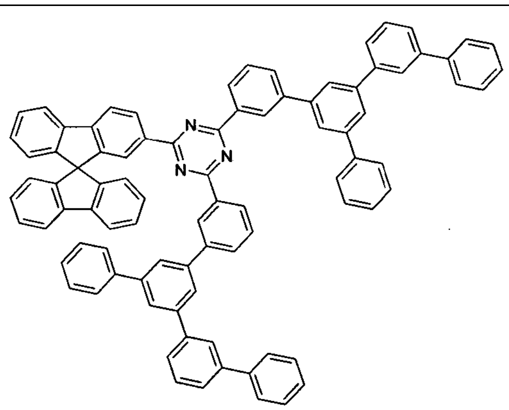 |

(fortgesetzt)

| | |
|---|---|
| TH-2 | 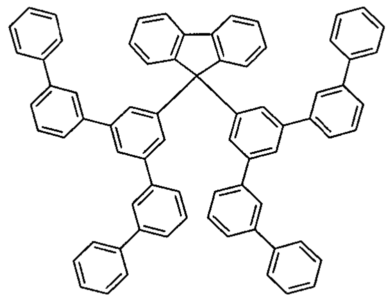 |
| TE-1 | 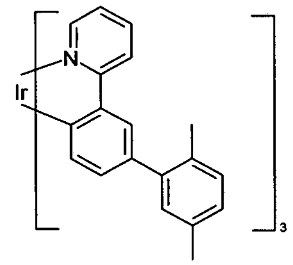 |

Alle Tintenstrahl-Druckvorgänge werden an Luft durchgeführt, ebenso wie das Ausheizen der Lochinjektionsschicht. Das Ausheizen der Lochtransportschicht und der Emitterschicht erfolgt unter Inertgas ($N_2$) in einer Glovebox.

Die so bedruckten Substrate werden dann in eine Vakuum-Bedampfungskammer transferiert, wo eine 20 nm dicke Elektronen-Transportschicht (ETL) aus den beiden folgenden Materialien ETM-1 und ETM-2 im Verhältnis 50:50 durch thermische Coverdampfung aufgebracht wird.

| | |
|---|---|
| 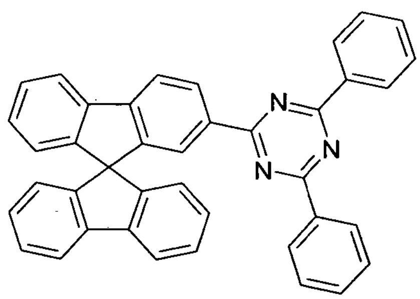 | 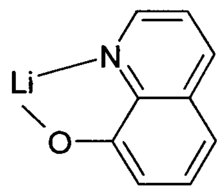 |
| ETM-1 | ETM-2 |

Danach wird die Al-Kathode durch eine Aufdampfmaske aufgedampft; Aufdampfanlagen von Lesker o.a., typischer Vakuumlevel 5 x $10^{-6}$ mbar). Um vor allem die Kathode vor Luft und Luftfeuchtigkeit zu schützen, wird die Device abschließend verkapselt und dann charakterisiert.

**Messergebnisse und Diskussion:**

Tabelle 2 zeigt in der Spalte 'Effizienz', dass für das Referenzbauteil bei einer Helligkeit von 1000 cd/$m^2$ eine Effizienz von 46,9 cd/A, für das Bauteil gemäß Beispiel 1 eine Effizienz von 48,0 cd/A, für das Bauteil gemäß Beispiel 2 eine Effizienz von 48,1 cd/A, für das Bauteil gemäß Beispiel 3 eine Effizienz von 47,5 cd/A und für das Bauteil gemäß Beispiel 4 eine Effizienz von 48,1 cd/A erreicht wird.

Tabelle 2 zeigt in der Spalte ‚EQE', dass für das Referenzbauteil bei einer Helligkeit von 1000 cd/$m^2$ eine externe Quanteneffizienz (EQE = External Quantum Efficiency) von 12,7 %, für das Bauteil gemäß Beispiel 1 eine EQE von 13,2 %, für das Bauteil gemäß Beispiel 2 eine EQE von 13,3 %, für das Bauteil gemäß Beispiel 3 eine EQE von 12,8 % und für das Bauteil gemäß Beispiel 4 eine EQE von 13,3 % erzielt wird.

Aus Tabelle 2, Spalte 'U', wird ersichtlich, dass das Referenzbauteil bei einer Helligkeit von 1000 cd/$m^2$ eine Betriebsspannung von 7,2 V, das Bauteil gemäß Beispiel 1 eine Betriebsspannung von 6,8 V, das Bauteil gemäß Beispiel

2 eine Betriebsspannung von 6,5 V, das Bauteil gemäß Beispiel 3 eine Betriebsspannung von 6,9 V und das Bauteil gemäß Beispiel 4 eine Betriebsspannung von 6,9 V benötigt.

Die Lebensdauer-Daten für die hergestellten Bauteile zeigt Tabelle 2, Spalte ‚LT80'. In den Lebensdauer-Kennlinien ist kein signifikanter Unterschied zwischen dem Referenzbauteil und den gemäß den Beispielen 1 bis 4 hergestellten Bauteilen erkennbar. Hieraus kann abgeleitet werden, dass durch die Verwendung des erfindungsgemäßen Lösungsmittel-Systems keine Beeinträchtigung der Bauteile erfolgt und die Verwendung des erfindungsgemäßen Lösungsmittel-Systems keinen negativen Einfluss auf die elektrooptische Leistung der hergestellten Bauteile und deren Lebensdauer hat. Durch das erfindungsgemäße Lösungsmittel-System wird jedoch eine größere Flexibilität in Bezug auf die Viskosität und die Oberflächenspannung der zu verwendenden Formulierungen erreicht, woraus sich ein größeres Prozessfenster zur Erfüllung der Anforderungen unterschiedlicher Tintenstrahl-Druckmaschinen eröffnet.

**Tabelle 2**

| **Messwerte der hergestellten Testbauteile** | | | | |
|---|---|---|---|---|
| Formulierung | Effizienz (cd/A) | EQE (%) | U (V) | $LT_{80}$ (h) |
| | bei 1000 cd/m$^2$ | | | bei 8000 cd/m$^2$ |
| Referenz | 46,9 | 12,7 | 7,2 | 59 |
| Beispiel 1 | 48,0 | 13,2 | 6,8 | 53 |
| Beispiel 2 | 48,1 | 13,3 | 6,5 | 52 |
| Beispiel 3 | 47,5 | 12,8 | 6,9 | 39 |
| Beispiel 4 | 48,1 | 13,0 | 6,9 | 46 |

In einer weiteren Testreihe wird der Einfluss der Verwendung von Isobenzofuran als Additiv auf die Eigenschaften von Formulierungen, wie z.B. die Oberflächenspannung und die Viskosität untersucht. Dazu werden zwei Formulierungen mit unterschiedlichen Anteilen an Additiv hergestellt. Die Formulierung gemäß Beispiel 5 enthält einen Anteil von 5 Gew.-% Isobenzofuran in 3-PT als Lösungsmittel, die Formulierung gemäß Beispiel 6 enthält einen Anteil von 10 Gew.-% Isobenzofuran in 3-PT als Lösungsmittel.

**Tabelle 3**

| **Messwerte der Testformulierungen** | | | | | |
|---|---|---|---|---|---|
| Schicht | Formulierung | Anteil Additiv (Gew.-%) | Konz. (g/l) | Viskosität (mPas) | Oberflächenspannung (mN/m) |
| G-EML | Referenz | 0 | 14 | 4,8 | 37,6 |
| G-EML | Beispiel 5 | 5 | 14 | 4,8 | 36,9 |
| G-EML | Beispiel 6 | 10 | 14 | 4,8 | 36,4 |

Aus der Tabelle 3, Spalte 'Viskosität', wird ersichtlich, dass die Viskosität der Formulierung durch Zugabe unterschiedlicher Anteile an Isobenzofuran nicht beeinflusst wird. Aus Tabelle 3, Spalte 'Oberflächenspannung', wird jedoch ersichtlich, dass die Oberflächenspannung der hergestellten Formulierung durch die Zugabe unterschiedlicher Anteile an Additiv beeinflusst werden kann. Hiermit ergibt sich durch die Verwendung von Isobenzofuran als Additiv in einer Formulierung die Möglichkeit, die Benetzungsfähigkeit der Formulierung gemäß den Anforderungen des gewählten Beschichtungsverfahrens zu beeinflussen, ohne die rheologischen Eigenschaften der Formulierung zu verändern.

## Patentansprüche

1. Formulierung umfassend mindestens ein niedermolekulares, organisches Matrixmaterial und mindestens einen niedermolekularen Emitter, ausgewählt aus fluoreszierenden und phosphoreszierenden Emittern, welche ein Molekulargewicht von ≤ 3.000 g/mol aufweisen und welche zur Herstellung von emittierenden Schichten organischer Elektrolumineszenzvorrichtungen einsetzbar sind, und mindestens eine aromatische Verbindung mit einer Struktur der Formeln (1) oder (2) als Lösungsmittel

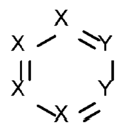

Formel (1)

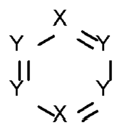

Formel (2)

wobei für die verwendeten Symbole gilt:

X ist bei jedem Auftreten gleich oder verschieden CR oder N, wobei insgesamt höchstens 2 Reste X für N stehen;
R ist bei jedem Auftreten gleich oder verschieden H, D, F, $N(R^1)_2$, CN, $NO_2$, $C(=O)N(R^1)_2$, $Si(R^1)_3$, $C(=O)R^1$, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten $R^1$ substituiert sein kann, wobei eine oder mehrere nicht benachbarte $CH_2$-Gruppen durch $R^1C=CR^1$, C≡C, $Si(R^1)_2$, C=O, $NR^1$, O, S oder $CONR^1$ ersetzt sein können und wobei ein oder mehrere H-Atome durch D, F, $NO_2$ oder CN ersetzt sein können, oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 40 aromatischen Ringatomen, die durch einen oder mehrere Reste $R^1$ substituiert sein kann, oder eine Aralkyl- oder Heteroaralkylgruppe mit 5 bis 40 aromatischen Ringatomen, die durch einen oder mehrere Reste $R^1$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^1$ substituiert sein kann; dabei können zwei benachbarte Reste R auch miteinander ein mono- oder polycyclisches, aliphatisches, aromatisches oder heteroaromatisches Ringsystem bilden;
$R^1$ ist bei jedem Auftreten gleich oder verschieden H, D, F, $N(R^2)_2$, CN, $NO_2$, $Si(R^2)_3$, $C(=O)R^2$, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten $R^2$ substituiert sein kann, wobei eine oder mehrere nicht benachbarte $CH_2$-Gruppen durch $R^2C=CR^2$, C=C, $Si(R^2)_2$, C=O, $NR^2$, O, S oder $CONR^2$ ersetzt sein können und wobei ein oder mehrere H-Atome durch D, F, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 40 aromatischen Ringatomen, die durch einen oder mehrere Reste $R^2$ substituiert sein kann, oder eine Aralkyl- oder Heteroaralkylgruppe mit 5 bis 40 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann; dabei können zwei oder mehrere benachbarte Reste $R^1$ miteinander oder $R^1$ mit R ein mono- oder polycyclisches, aliphatisches, aromatisches oder heteroaromatisches Ringsystem bilden;
$R^2$ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^2$ auch miteinander ein mono- oder polycyclisches, aliphatisches Ringsystem bilden;
Y ist bei jedem Auftreten gleich oder verschieden eine Gruppe CR,

**dadurch gekennzeichnet, dass**
in der Struktur der Formeln (1) oder (2) die benachbarten Gruppen Y zusammen einen Ring gemäß einer der folgenden Formeln (3), (4), (5), (6), (7), (8) oder (9) aufspannen,

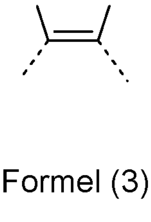

Formel (3)

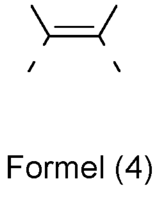

Formel (4)

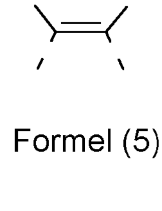

Formel (5)

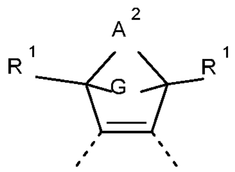

Formel (6)

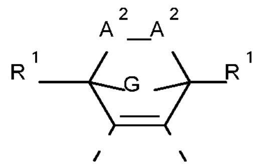

Formel (7)

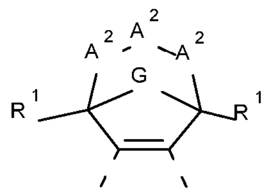

Formel (8)

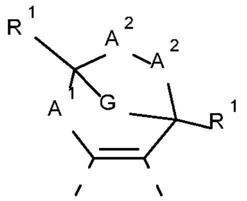

Formel (9)

wobei $R^1$ die zuvor genannte Bedeutung aufweist, die gestrichelten Linien die Bindung der beiden Kohlenstoffatome der Gruppe Y zu den Resten X des aromatischen oder heteroaromatischen Rings in der Struktur gemäß Formel (1) oder Formel (2) darstellen und weiterhin gilt:

$A^1$, $A^3$ ist gleich oder verschieden bei jedem Auftreten $C(R^3)_2$, O, S, $NR^3$ oder C(=O);
$A^2$ ist $C(R^1)_2$, O, S, $NR^3$ oder C(=O);
G ist eine Alkylengruppe mit 1, 2 oder 3 C-Atomen, welche mit einem oder mehreren Resten $R^2$ substituiert sein kann, $-CR^2=CR^{2-}$ oder eine ortho-verknüpfte Arylen- oder Heteroarylengruppe mit 5 bis 14 aromatischen Ringatomen, welche durch einen oder mehrere Reste $R^2$ substituiert sein kann;
$R^3$ ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils mit einem oder mehreren Resten $R^2$ substituiert sein kann, wobei eine oder mehrere nicht benachbarte $CH_2$-Gruppen durch $R^2C=CR^2$, C=C, $Si(R^2)_2$, C=O, $NR^2$, O, S oder $CONR^2$ ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste $R^2$ substituiert sein kann, oder eine Aryloxy- oder Heteroaryloxygruppe mit 5 bis 24 aromatischen Ringatomen, die durch einen oder mehrere Reste $R^2$ substituiert sein kann, oder eine Aralkyl- oder Heteroaralkylgruppe mit 5 bis 24 aromatischen Ringatomen, die durch einen oder mehrere Reste $R^2$ substituiert sein kann; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden;

mit der Maßgabe, dass in den zuvor genannten Gruppen nicht zwei gleiche Heteroatome direkt aneinander gebunden sind und nicht zwei Gruppen C=O direkt aneinander gebunden sind.

**2.** Formulierung nach Anspruch 1, **dadurch gekennzeichnet, dass** der Anteil der aromatischen Verbindung mit einer Struktur der Formeln (1) oder (2) in der Formulierung mindestens 0,1 Gew. %, vorzugsweise mindestens 1 Gew. %, besonders bevorzugt mindestens 5 Gew. %, und insbesondere bevorzugt mindestens 10 Gew. %, bezogen auf die Formulierung beträgt.

**3.** Formulierung nach Anspruch 1, daduch gekennzeichnet, dass der Anteil der aromatischen Verbindung mit einer Struktur der Formeln (1) oder (2) in der Formulierung mindestens 20 Gew. %, vorzugsweise mindestens 40 Gew. % und besonders bevorzugt mindestens 80 Gew. %, bezogen auf die Formulierung, beträgt.

**4.** Formulierung nach einem oder mehreren der vorhergehenden Ansprüche 1 bis 3, **dadurch gekennzeichnet, dass** die aromatische Verbindung mit einer Struktur der Formeln (1) oder (2) eine Oberflächenspannung von höchstens 40 mN/m, vorzugsweise höchstens 35 mN/m und besonders bevorzugt höchstens 30 mN/m aufweist.

5. Formulierung nach einem oder mehreren der vorhergehenden Ansprüche 1 bis 4, **dadurch gekennzeichnet, dass** die aromatische Verbindung mit einer Struktur der Formeln (1) oder (2) einen Siedepunkt von höchstens 300°C, vorzugsweise höchstens 280°C, aufweist.

6. Formulierung nach einem oder mehreren der vorhergehenden Ansprüche 1 bis 5, **dadurch gekennzeichnet, dass** die aromatische Verbindung mit einer Struktur der Formeln (1) oder (2) eine Viskosität von mindestens 3 mPas, vorzugsweise mindestens 5 mPas, aufweist.

7. Formulierung nach einem oder mehreren der vorhergehenden Ansprüche 1 bis 6, **dadurch gekennzeichnet, dass** in den Ringstrukturen gemäß einer der Formeln (3), (4), (5), (6), (7), (8) oder (9) mindestens eine der Gruppen $A^1$ und $A^3$ gleich oder verschieden für O oder $NR^3$ und $A^2$ für $C(R^1)_2$ steht.

8. Formulierung nach einem oder mehreren der vorhergehenden Ansprüche 1 bis 6, **dadurch gekennzeichnet, dass** in den Ringstrukturen gemäß einer der Formeln (3), (4), (5), (6), (7), (8) oder (9) die Gruppen $A^1$ und $A^3$ gleich oder verschieden bei jedem Auftreten für $C(R^3)_2$ stehen und $A^2$ für $C(R^1)_2$, vorzugsweise für $C(R^3)_2$ und besonders bevorzugt für $CH_2$ steht.

9. Formulierung nach einem oder mehreren der vorhergehenden Ansprüche 1 bis 8, **dadurch gekennzeichnet, dass** in der Struktur gemäß Formel (1) oder Formel (2) zwei benachbarte Reste Y eine Ringstruktur gemäß einer der folgenden Formeln (3-A) bis (3-F) bilden,

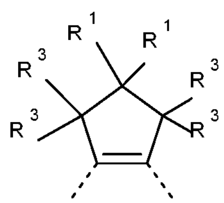

Formel (3-A)

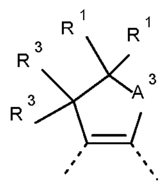

Formel (3-B)

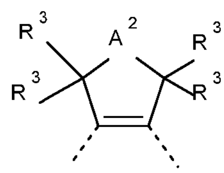

Formel (3-C)

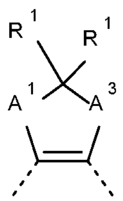

Formel (3-D)

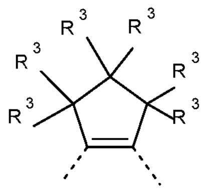

Formel (3-E)

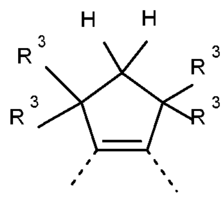

Formel (3-F)

wobei $A^1$, $A^2$ und $A^3$ gleich oder verschieden bei jedem Auftreten für O oder $NR^3$ stehen, die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen und $R^1$ und $R^3$ die in Anspruch 1 angegebene Bedeutung aufweisen.

10. Formulierung nach einem oder mehreren vorhergehenden Ansprüche 1 bis 8, **dadurch gekennzeichnet, dass** in der Struktur gemäß Formel (1) oder Formel (2) zwei benachbarte Reste Y eine Ringstruktur gemäß einer der folgenden Formeln (4-A) bis (4-F) bilden,

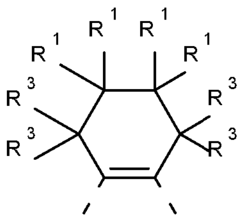
Formel (4-A)

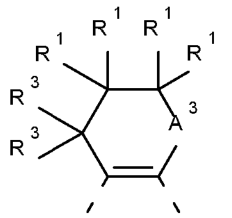
Formel (4-B)

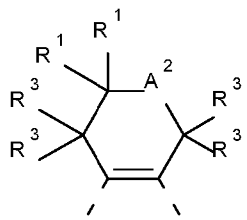
Formel (4-C)

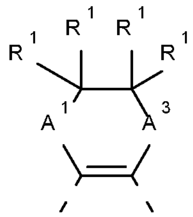
Formel (4-D)

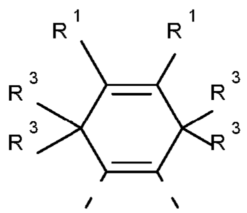
Formel (4-E)

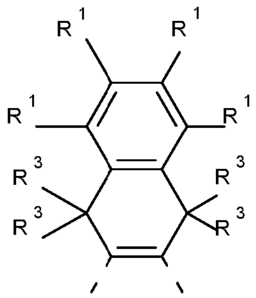
Formel (4-F)

wobei $A^1$, $A^2$ und $A^3$ gleich oder verschieden bei jedem Auftreten für O oder $NR^3$ stehen, die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen und $R^1$ und $R^3$ die in Anspruch 1 angegebene Bedeutung aufweisen.

**11.** Formulierung nach einem oder mehreren der vorhergehenden Ansprüche 1 bis 8, **dadurch gekennzeichnet, dass** in der Struktur gemäß Formel (1) oder Formel (2) zwei benachbarte Reste Y eine Ringstruktur gemäß einer der folgenden Formeln (5-A) bis (5-E) bilden,

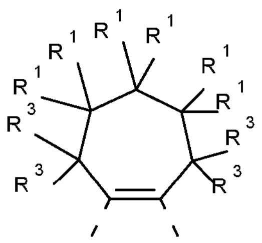
Formel (5-A)

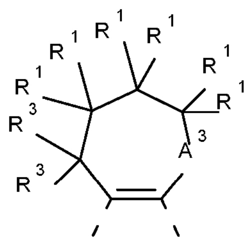
Formel (5-B)

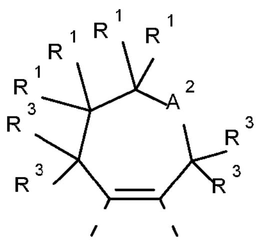
Formel (5-C)

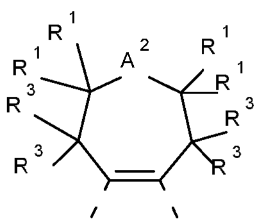
Formel (5-D)

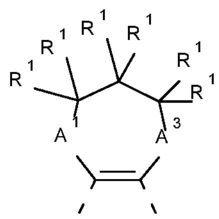
Formel (5-E)

wobei $A^1$, $A^2$ und $A^3$ gleich oder verschieden bei jedem Auftreten für O oder $NR^3$ stehen, die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen und $R^1$ und $R^3$ die in Anspruch 1 angegebene Bedeutung aufweisen.

12. Formulierung nach einem oder mehreren der vorhergehenden Ansprüche 1 bis 8, **dadurch gekennzeichnet, dass** in der Struktur gemäß Formel (1) oder Formel (2) zwei benachbarte Reste Y eine Ringstruktur gemäß einer der folgenden Formeln (6-A) bis (6-C) bilden,

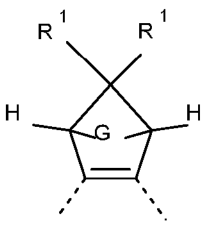

Formel (6-A)

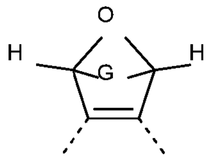

Formel (6-B)

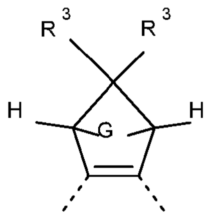

Formel (6-C)

wobei die verwendeten Symbole die in Anspruch 1 angegebenen Bedeutungen aufweisen und die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen.

13. Formulierung nach einem oder mehreren der vorhergehenden Ansprüche 1 bis 8, **dadurch gekennzeichnet, dass** in der Struktur gemäß Formel (1) oder Formel (2) zwei benachbarte Reste Y eine Ringstruktur gemäß einer der folgenden Formeln (7-A), (8-A) oder (9-A) bilden,

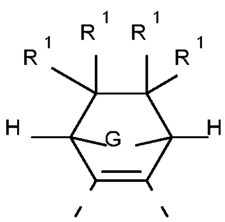

Formel (7-A)

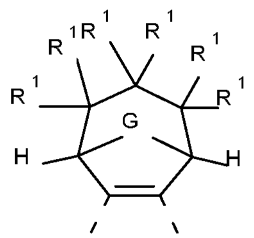

Formel (8-A)

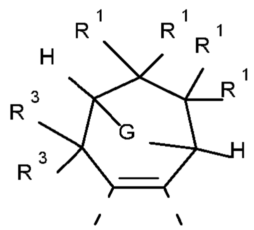

Formel (9-A)

wobei die verwendeten Symbole die in Anspruch 1 oder 2 angegebenen Bedeutungen aufweisen und die gestrichelten Linien die Bindungen der beiden Kohlenstoffatome der Gruppe Y zu den Resten X des aromatischen oder heteroaromatischen Rings in der Struktur gemäß Formel (1) oder Formel (2) darstellen.

14. Formulierung nach einem oder mehreren der vorhergehenden Ansprüche 1 bis 9, **dadurch gekennzeichnet, dass** die aromatische Verbindung mit einer Struktur der Formeln (1) oder (2) ausgewählt ist aus Verbindungen der Formeln (10), (11) oder (12),

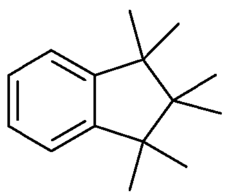

Formel (10)

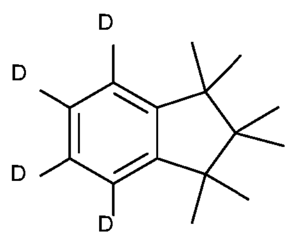

Formel (11)

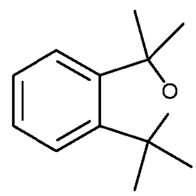

Formel (12)

wobei die Verbindung gemäß Formel (10) besonders bevorzugt ist.

**15.** Verfahren zur Herstellung einer organischen Elektrolumineszenzvorrichtung, umfassend das Aufbringen einer Formulierung gemäß einem oder mehreren der Ansprüche 1 bis 14 auf ein Substrat und/oder auf eine auf ein Substrat mittelbar oder unmittelbar aufgetragene Schicht.

**16.** Verfahren nach Anspruch 15, **dadurch gekennzeichnet, dass** die Formulierung durch Flutbeschichtung, Tauchbeschichtung, Sprühbeschichtung, Spincoating, Siebdruck, Hochdruck, Tiefdruck, Rotationsdruck, Walzenbeschichtung, Flexodruck, Offsetdruck oder Nozzle-Printing, vorzugsweise Ink-Jet-Druck auf ein Substrat oder eine der auf das Substrat aufgetragenen Schichten aufgebracht wird.

## Claims

**1.** Formulation comprising at least one low-molecular-weight, organic matrix material and at least one low-molecular-weight emitter, selected from fluorescent and phosphorescent emitters which have a molecular weight of ≤ 3000 g/mol and which can be employed for the production of emitting layers of organic electroluminescent devices, and at least one aromatic compound having a structure of the formula (1) or (2) as solvent,

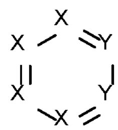
formula (1)

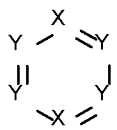
formula (2)

where the following applies to the symbols used:

X is on each occurrence, identically or differently, CR or N, where in total at most 2 radicals X stand for N;
R is on each occurrence, identically or differently, H, D, F, $N(R^1)_2$, CN, $NO_2$, $C(=O)N(R^1)_2$, $Si(R^1)_3$, $C(=O)R^1$, a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, which may in each case be substituted by one or more radicals $R^1$, where one or more non-adjacent $CH_2$ groups may be replaced by $R^1C=CR^1$, C≡C, $Si(R^1)_2$, C=O, $NR^1$, O, S or $CONR^1$ and where one or more H atoms may be replaced by D, F, $NO_2$ or CN, or an aromatic or heteroaromatic ring system having 5 to 60 aromatic ring atoms, which may in each case be substituted by one or more radicals $R^1$, or an aryloxy or heteroaryloxy group having 5 to 40 aromatic ring atoms, which may be substituted by one or more radicals $R^1$, or an aralkyl or heteroaralkyl group having 5 to 40 aromatic ring atoms, which may be substituted by one or more radicals $R^1$, or a diarylamino group, diheteroarylamino group or arylheteroarylamino group having 10 to 40 aromatic ring atoms, which may be substituted by one or more radicals $R^1$; two adjacent radicals R may also form a mono- or polycyclic, aliphatic, aromatic or heteroaromatic ring system with one another;
$R^1$ is on each occurrence, identically or differently, H, D, F, $N(R^2)_2$, CN, $NO_2$, $Si(R^2)_3$, $C(=O)R^2$, a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, which may in each case be substituted by one or more radicals $R^2$, where one or more non-adjacent $CH_2$ groups may be replaced by $R^2C=CR^2$, C=C, $Si(R^2)_2$, C=O, $NR^2$, O, S or $CONR^2$ and where one or more H atoms may be replaced by D, F, CN or $NO_2$, or an aromatic or heteroaromatic ring system having 5 to 60 aromatic ring atoms, which may in each case be substituted by one or more radicals $R^2$, or an aryloxy or heteroaryloxy group having 5 to 40 aromatic ring atoms, which may be substituted by one or more radicals $R^2$, or an aralkyl or heteroaralkyl group having 5 to 40 aromatic ring atoms, which may be substituted by one or more radicals $R^2$, or a diarylamino group, diheteroarylamino group or arylheteroarylamino group having 10 to 40 aromatic ring atoms, which may be substituted by one or more radicals $R^2$; two or more adjacent radicals $R^1$ with one another or $R^1$ with R may form a mono- or polycyclic, aliphatic, aromatic or heteroaromatic ring system;
$R^2$ is on each occurrence, identically or differently, H, D, F or an aliphatic, aromatic and/or heteroaromatic hydrocarbon radical having 1 to 20 C atoms, in which, in addition, one or more H atoms may be replaced by F; two or more substituents $R^2$ may also form a mono- or polycyclic, aliphatic ring system with one another;
Y is on each occurrence, identically or differently, a group CR,

**characterised in that**

the adjacent groups Y in the structure of the formula (1) or (2) together form a ring of one of the following formulae (3), (4), (5), (6), (7), (8) and (9):

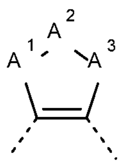

formula (3)

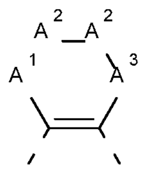

formula (4)

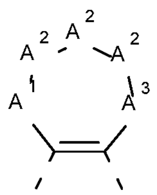

formula (5)

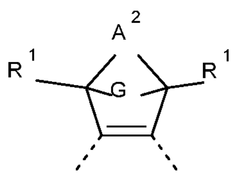

formula (6)

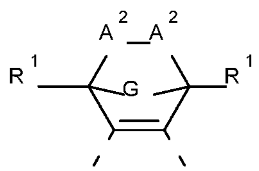

formula (7)

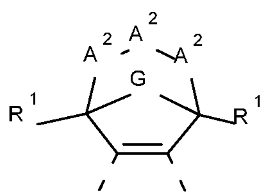

formula (8)

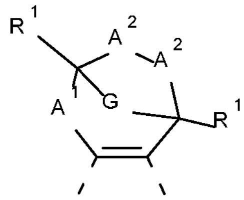

formula (9)

where $R^1$ has the meaning given above, the dashed lines represent the bonds from the two carbon atoms of group Y to the radicals X of the aromatic or heteroaromatic ring in the structure of the formula (1) or formula (2), and furthermore:

$A^1$, $A^3$ are, identically or differently on each occurrence, $C(R^3)_2$, O, S, $NR^3$ or C(=O);
$A^2$ is $C(R^1)_2$, O, S, $NR^3$ or C(=O);
G is an alkylene group having 1, 2 or 3 C atoms, which may be substituted by one or more radicals $R^2$, or is $-CR^2=CR^2-$ or an ortho-linked arylene or heteroarylene group having 5 to 14 aromatic ring atoms, which may be substituted by one or more radicals $R^2$;
$R^3$ is, identically or differently on each occurrence, F, a straight-chain alkyl or alkoxy group having 1 to 10 C atoms, a branched or cyclic alkyl or alkoxy group having 3 to 10 C atoms, which may in each case be substituted by one or more radicals $R^2$, where one or more non-adjacent $CH_2$ groups may be replaced by $R^2C=CR^2$, C≡C, $Si(R^2)_2$, C=O, $NR^2$, O, S or $CONR^2$ and where one or more H atoms may be replaced by D or F, or an aromatic or heteroaromatic ring system having 5 to 24 aromatic ring atoms, which may in each case be substituted by one or more radicals $R^2$, or an aryloxy or heteroaryloxy group having 5 to 24 aromatic ring atoms, which may be substituted by one or more radicals $R^2$, or an aralkyl or heteroaralkyl group having 5 to 24 aromatic ring atoms, which may be substituted by one or more radicals $R^2$; two radicals $R^3$ which are bonded to the same carbon atom may form an aliphatic or aromatic ring system with one another and thus form a spiro system; furthermore, $R^3$ may form an aliphatic ring system with an adjacent radical R or $R^1$;

with the proviso that two identical heteroatoms in the above-mentioned groups are not bonded directly to one another and two groups C=O are not bonded directly to one another.

2. Formulation according to Claim 1, **characterised in that** the proportion of the aromatic compound having a structure

of the formula (1) or (2) in the formulation is at least 0.1% by weight, preferably at least 1% by weight, particularly preferably at least 5% by weight and especially preferably at least 10% by weight, based on the formulation.

**3.** Formulation according to Claim 1, **characterised in that** the proportion of the aromatic compound having a structure of the formula (1) or (2) in the formulation is at least 20% by weight, preferably at least 40% by weight and particularly preferably at least 80% by weight, based on the formulation.

**4.** Formulation according to one or more of the preceding Claims 1 to 3, **characterised in that** the aromatic compound having a structure of the formula (1) or (2) has a surface tension of at most 40 mN/m, preferably at most 35 mN/m and particularly preferably at most 30 mN/m.

**5.** Formulation according to one or more of the preceding Claims 1 to 4, **characterised in that** the aromatic compound having a structure of the formula (1) or (2) has a boiling point of at most 300°C, preferably at most 280°C.

**6.** Formulation according to one or more of the preceding Claims 1 to 5, **characterised in that** the aromatic compound having a structure of the formula (1) or (2) has a viscosity of at least 3 mPas, preferably at least 5 mPas.

**7.** Formulation according to one or more of the preceding Claims 1 to 6, **characterised in that**, in the ring structures of one of the formulae (3), (4), (5), (6), (7), (8) and (9), at least one of the groups $A^1$ and $A^3$ stands, identically or differently, for O or $NR^3$ and $A^2$ stands for $C(R^1)_2$.

**8.** Formulation according to one or more of the preceding Claims 1 to 6, **characterised in that**, in the ring structures of one of the formulae (3), (4), (5), (6), (7), (8) and (9), the groups $A^1$ and $A^3$ stand, identically or differently on each occurrence, for $C(R^3)_2$ and $A^2$ stands for $C(R^1)_2$, preferably for $C(R^3)_2$ and particularly preferably for $CH_2$.

**9.** Formulation according to one or more of the preceding Claims 1 to 8, **characterised in that** two adjacent radicals Y in the structure of the formula (1) or formula (2) form a ring structure of one of the following formulae (3-A) to (3-F):

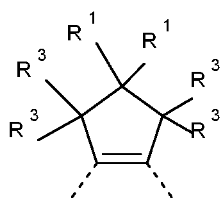

formula (3-A)

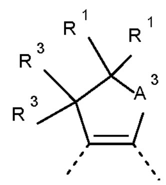

formula (3-B)

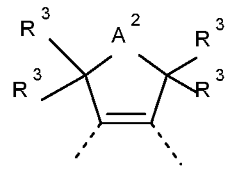

formula (3-C)

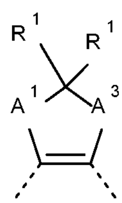

formula (3-D)

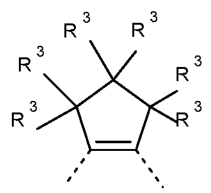

formula (3-E)

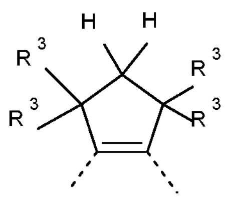

formula (3-F),

where $A^1$, $A^2$ and $A^3$ stand, identically or differently on each occurrence, for O or $NR^3$, the dashed lines represent the bonds from the two carbon atoms of group Y to the radicals X of the aromatic or heteroaromatic ring in the structure of the formula (1) or formula (2), and $R^1$ and $R^3$ have the meaning indicated in Claim 1.

**10.** Formulation according to one or more of the preceding Claims 1 to 8, **characterised in that** two adjacent radicals Y in the structure of the formula (1) or formula (2) form a ring structure of one of the following formulae (4-A) to (4-F):

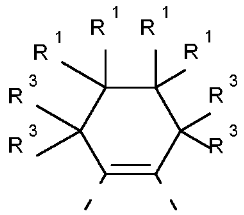

formula (4-A)

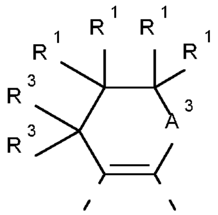

formula (4-B)

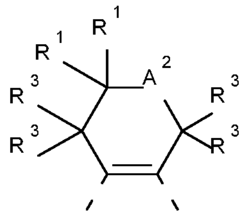

formula (4-C)

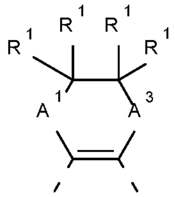

formula (4-D)

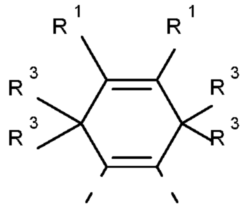

formula (4-E)

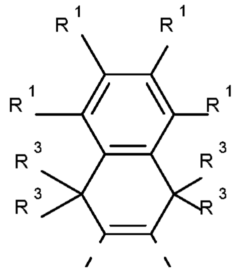

formula (4-F),

where $A^1$, $A^2$ and $A^3$ stand, identically or differently on each occurrence, for O or $NR^3$, the dashed lines represent the bonds from the two carbon atoms of group Y to the radicals X of the aromatic or heteroaromatic ring in the structure of the formula (1) or formula (2), and $R^1$ and $R^3$ have the meaning indicated in Claim 1.

**11.** Formulation according to one or more of the preceding Claims 1 to 8, **characterised in that** two adjacent radicals Y in the structure of the formula (1) or formula (2) form a ring structure of one of the following formulae (5-A) to (5-E):

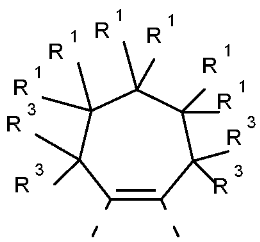

formula (5-A)

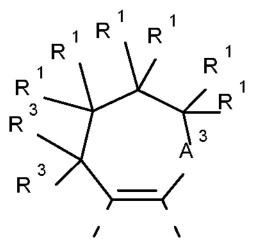

formula (5-B)

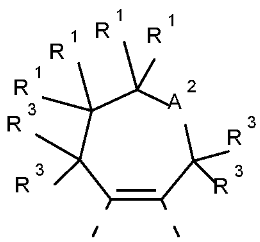

formula (5-C)

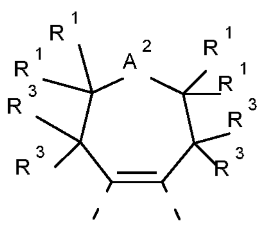

formula (5-D)

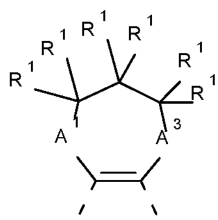

formula (5-E)

where $A^1$, $A^2$ and $A^3$ stand, identically or differently on each occurrence, for O or $NR^3$, the dashed lines represent the bonds from the two carbon atoms of group Y to the radicals X of the aromatic or heteroaromatic ring in the structure of the formula (1) or formula (2), and $R^1$ and $R^3$ have the meaning indicated in Claim 1.

**12.** Formulation according to one or more of the preceding Claims 1 to 8, **characterised in that** two adjacent radicals Y in the structure of the formula (1) or formula (2) form a ring structure of one of the following formulae (6-A) to (6-C):

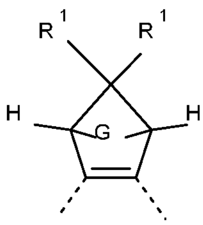

formula (6-A)

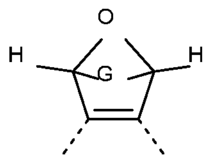

formula (6-B)

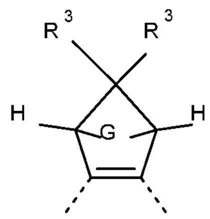

formula (6-C),

where the symbols used have the meanings indicated in Claim 1 and the dashed lines represent the bonds from the two carbon atoms of group Y to the radicals X of the aromatic or heteroaromatic ring in the structure of the formula (1) or formula (2).

**13.** Formulation according to one or more of the preceding Claims 1 to 8, **characterised in that** two adjacent radicals Y in the structure of the formula (1) or formula (2) form a ring structure of one of the following formulae (7-A), (8-A) or (9-A):

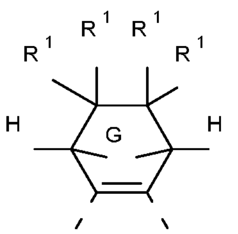

formula (7-A)

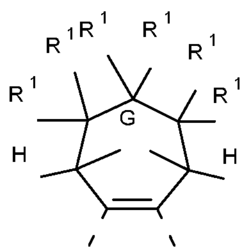

formula (8-A)

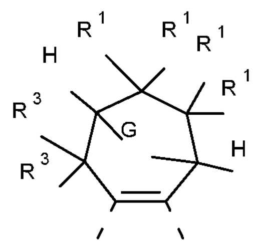

formula (9-A),

where the symbols used have the meanings indicated in Claim 1 or 2 and the dashed lines represent the bonds from the two carbon atoms of group Y to the radicals X of the aromatic or heteroaromatic ring in the structure of the formula (1) or formula (2).

**14.** Formulation according to one or more of the preceding Claims 1 to 9, **characterised in that** the aromatic compound having a structure of the formula (1) or (2) is selected from compounds of the formulae (10), (11) and (12),

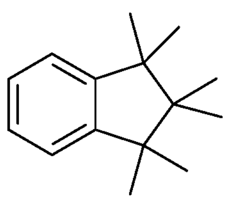

formula (10)

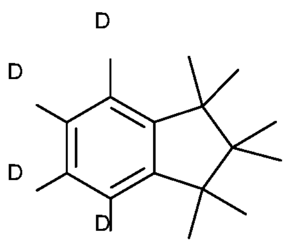

formula (11)

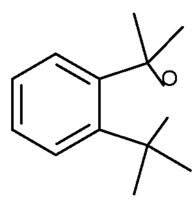

formula (12)

where the compound of the formula (10) is particularly preferred.

**15.** Process for the production of an organic electroluminescent device, comprising the application of a formulation according to one or more of Claims 1 to 14 to a substrate and/or to a layer applied indirectly or directly to a substrate.

**16.** Process according to Claim 15, **characterised in that** the formulation is applied to a substrate or one of the layers applied to the substrate by flood coating, dip coating, spray coating, spin coating, screen printing, relief printing, gravure printing, rotary printing, roller coating, flexographic printing, offset printing or nozzle printing, preferably ink-jet printing.

**Revendications**

**1.** Formulation comprenant au moins un matériau de matrice organique de poids moléculaire faible et au moins un émetteur de poids moléculaire faible, lequel est sélectionné parmi les émetteurs fluorescents et phosphorescents qui présentent un poids moléculaire ≤ 3000 g/mol et qui peuvent être utilisés pour la fabrication de couches d'émission de dispositifs électroluminescents organiques, et au moins un composé aromatique qui présente une structure de la formule (1) ou (2) en tant que solvant,

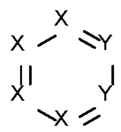

formule (1)

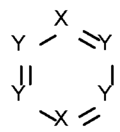

formule (2)

dans lesquelles ce qui suit s'applique aux symboles qui sont utilisés :

X est pour chaque occurrence, de manière identique ou différente, CR ou N, où au total, au plus 2 radicaux X représentent N ;
R est pour chaque occurrence, de manière identique ou différente, H, D, F, $N(R^1)_2$, CN, $NO_2$, $C(=O)N(R^1)_2$, $Si(R^1)_3$, $C(=O)R^1$, un groupe alkyle, alcoxy ou thioalcoxy en chaîne droite qui comporte de 1 à 20 atome(s) de C ou un groupe alkényle ou alkynyle qui comporte de 2 à 20 atomes de C ou un groupe alkyle, alcoxy ou thioalcoxy ramifié ou cyclique qui comporte de 3 à 20 atomes de C, lequel peut dans chaque cas être substitué par un radical ou par plusieurs radicaux $R^1$, où un ou plusieurs groupe(s) $CH_2$ non adjacents peut/peuvent être remplacé(s) par $R^1C=CR^1$, C≡C, $Si(R^1)_2$, C=O, $NR^1$, O, S ou $CONR^1$ et où un ou plusieurs atome(s) de H peut/peuvent être remplacé(s) par D, F, $NO_2$ ou CN, ou un système de cycle aromatique ou hétéroaromatique qui comporte de 5 à 60 atomes de cycle aromatique, lequel peut dans chaque cas être substitué par un radical ou par plusieurs radicaux $R^1$, ou un groupe aryloxy ou hétéroaryloxy qui comporte de 5 à 40 atomes de cycle aromatique, lequel peut être substitué par un radical ou par plusieurs radicaux $R^1$, ou un groupe aralkyle ou hétéroaralkyle qui comporte de 5 à 40 atomes de cycle aromatique, lequel peut être substitué par un radical ou par plusieurs radicaux $R^1$, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux $R^1$ ; deux radicaux R adjacents peuvent également former un système de cycle aliphatique, aromatique ou hétéroaromatique mono- ou polycyclique l'un avec l'autre ;
$R^1$ est pour chaque occurrence, de manière identique ou différente, H, D, F, $N(R^2)_2$, CN, $NO_2$, $Si(R^2)_3$, $C(=O)R^2$, un groupe alkyle, alcoxy ou thioalcoxy en chaîne droite qui comporte de 1 à 20 atome(s) de C ou un groupe alkényle ou alkynyle qui comporte de 2 à 20 atomes de C ou un groupe alkyle, alcoxy ou thioalcoxy ramifié ou cyclique qui comporte de 3 à 20 atomes de C, lequel peut dans chaque cas être substitué par un radical ou par plusieurs radicaux $R^2$, où un ou plusieurs groupe(s) $CH_2$ non adjacents peut/peuvent être remplacé(s) par $R^2C=CR^2$, C≡C, $Si(R^2)_2$, C=O, $NR^2$, O, S ou $CONR^2$ et où un ou plusieurs atome(s) de H peut/peuvent être remplacé(s) par D, F, CN ou $NO_2$, ou un système de cycle aromatique ou hétéroaromatique qui comporte de 5 à 60 atomes de cycle aromatique, lequel peut dans chaque cas être substitué par un radical ou par plusieurs radicaux $R^2$, ou un groupe aryloxy ou hétéroaryloxy qui comporte de 5 à 40 atomes de cycle aromatique, lequel peut être substitué par un radical ou par plusieurs radicaux $R^2$, ou un groupe aralkyle ou hétéroaralkyle qui comporte de 5 à 40 atomes de cycle aromatique, lequel peut être substitué par un radical ou par plusieurs radicaux $R^2$, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux $R^2$ ; deux radicaux $R^1$ adjacents ou plus, l'un avec l'autre ou les uns avec les autres, ou $R^1$ avec R peuvent former un système de cycle aliphatique, aromatique ou hétéroaromatique mono- ou polycyclique ;
$R^2$ est pour chaque occurrence, de manière identique ou différente, H, D, F ou un radical hydrocarbone aliphatique, aromatique et/ou hétéroaromatique qui comporte de 1 à 20 atome(s) de C, où, en outre, un ou plusieurs

atome(s) de H peut/peuvent être remplacé(s) par F ; deux substituants $R^2$ ou plus peuvent également former un système de cycle aliphatique mono- ou polycyclique l'un avec l'autre ou les uns avec les autres ;
Y est pour chaque occurrence, de manière identique ou différente, un groupe CR,

**caractérisée en ce que**
les groupes Y adjacents dans la structure de la formule (1) ou (2) forment en association un cycle de l'une des formules qui suivent (3), (4), (5), (6), (7), (8) et (9):

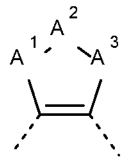

formule (3)

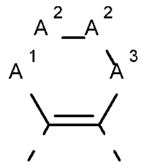

formule (4)

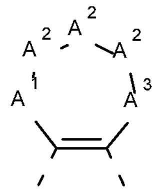

formule (5)

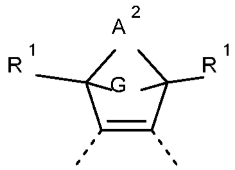

formule (6)

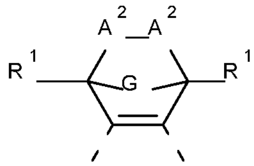

formule (7)

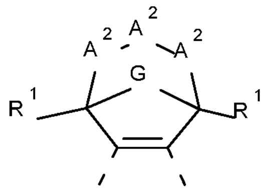

formule (8)

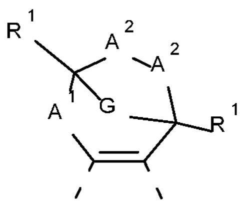

formule (9)

dans lesquelles $R^1$ présente la signification qui a été donnée ci-avant, les lignes en pointillés représentent les liaisons depuis les deux atomes de carbone du groupe Y sur les radicaux X du cycle aromatique ou hétéroaromatique dans la structure de la formule (1) ou de la formule (2), et qui plus est :

$A^1$, $A^3$ sont, de manière identique ou différente pour chaque occurrence, $C(R^3)_2$, O, S, $NR^3$ ou C(=O) ;
$A^2$ est $C(R^1)_2$, O, S, $NR^3$ ou C(=O) ;
G est un groupe alkylène qui comporte 1, 2 ou 3 atome(s) de C, lequel peut être substitué par un radical ou par plusieurs radicaux $R^2$, ou est $-CR^2=CR^{2-}$ ou un groupe arylène ou hétéroarylène ortho-lié qui comporte de 5 à 14 atomes de cycle aromatique, lequel peut être substitué par un radical ou par plusieurs radicaux $R^2$ ;
$R^3$ est pour chaque occurrence, de manière identique ou différente, F, un groupe alkyle ou alcoxy en chaîne droite qui comporte de 1 à 10 atome(s) de C, un groupe alkyle ou alcoxy ramifié ou cyclique qui comporte de 3 à 10 atomes de C, lequel peut dans chaque cas être substitué par un radical ou par plusieurs radicaux $R^2$, où un ou plusieurs groupe(s) $CH_2$ non adjacents peut/peuvent être remplacé(s) par $R^2C=CR^2$, $C\equiv C$, $Si(R^2)_2$, C=O, $NR^2$, O, S ou $CONR^2$ et où un ou plusieurs atome(s) de H peut/ peuvent être remplacé(s) par D ou par F, ou un système de cycle aromatique ou hétéroaromatique qui comporte de 5 à 24 atomes de cycle aromatique, lequel peut dans chaque cas être substitué par un radical ou par plusieurs radicaux $R^2$, ou un groupe aryloxy ou hétéroaryloxy qui comporte de 5 à 24 atomes de cycle aromatique, lequel peut être substitué par un radical ou par plusieurs radicaux $R^2$, ou un groupe aralkyle ou hétéroaralkyle qui comporte de 5 à 24 atomes de cycle aromatique, lequel peut être substitué par un radical ou par plusieurs radicaux $R^2$ ; deux radicaux $R^3$ qui sont

liés au même atome de carbone peuvent former un système de cycle aliphatique ou aromatique l'un avec l'autre et peuvent ainsi former un système spiro ; qui plus est, $R^3$ peut former un système de cycle aliphatique avec un radical R ou $R^1$ adjacent ;

étant entendu que deux hétéroatomes identiques dans les groupes qui ont été mentionnés ci-avant ne sont pas liés directement l'un à l'autre et que deux groupes C=O ne sont pas liés directement l'un à l'autre.

**2.** Formulation selon la revendication 1, **caractérisée en ce que** la proportion du composé aromatique qui présente une structure de la formule (1) ou (2) dans la formulation est d'au moins 0,1 % en poids, de préférence d'au moins 1 % en poids, de façon particulièrement préférable, d'au moins 5 % en poids et de façon tout spécialement préférable, d'au moins 10 % en poids, sur la base de la formulation.

**3.** Formulation selon la revendication 1, **caractérisée en ce que** la proportion du composé aromatique qui présente une structure de la formule (1) ou (2) dans la formulation est d'au moins 20 % en poids, de préférence d'au moins 40 % en poids et de façon particulièrement préférable, d'au moins 80 % en poids, sur la base de la formulation.

**4.** Formulation selon une ou plusieurs des revendications précédentes 1 à 3, **caractérisée en ce que** le composé aromatique qui présente une structure de la formule (1) ou (2) présente une tension de surface d'au plus 40 mN/m, de préférence d'au plus 35 mN/m et de façon particulièrement préférable, d'au plus 30 mN/m.

**5.** Formulation selon une ou plusieurs des revendications précédentes 1 à 4, **caractérisée en ce que** le composé aromatique qui présente une structure de la formule (1) ou (2) présente un point d'ébullition d'au plus 300 °C, de préférence d'au plus 280 °C.

**6.** Formulation selon une ou plusieurs des revendications précédentes 1 à 5, **caractérisée en ce que** le composé aromatique qui présente une structure de la formule (1) ou (2) présente une viscosité d'au moins 3 mPas, de préférence d'au moins 5 mPas.

**7.** Formulation selon une ou plusieurs des revendications précédentes 1 à 6, **caractérisée en ce que**, dans les structures de cycle de l'une des formules (3), (4), (5), (6), (7), (8) et (9), au moins l'un des groupes $A^1$ et $A^3$ représente, de manière identique ou différente, O ou $NR^3$ et $A^2$ représente $C(R^1)_2$.

**8.** Formulation selon une ou plusieurs des revendications précédentes 1 à 6, **caractérisée en ce que**, dans les structures de cycle de l'une des formules (3), (4), (5), (6), (7), (8) et (9), les groupes $A^1$ et $A^3$ représentent, de manière identique ou différente pour chaque occurrence, $C(R^3)_2$ et $A^2$ représente $C(R^1)_2$, de préférence $C(R^3)_2$ et de façon particulièrement préférable, $CH_2$.

**9.** Formulation selon une ou plusieurs des revendications précédentes 1 à 8, **caractérisée en ce que** deux radicaux Y adjacents dans la structure de la formule (1) ou de la formule (2) forment une structure de cycle de l'une des formules qui suivent (3-A) à (3-F) :

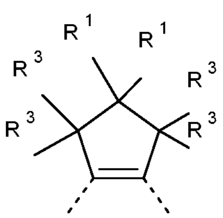

formule (3-A)

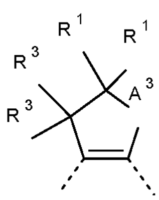

formule (3-B)

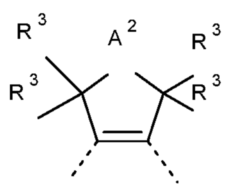

formule (3-C)

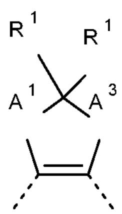

formule (3-D)

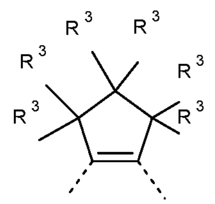

formule (3-E)

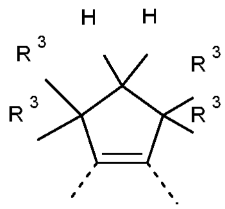

formule (3-F),

dans lesquelles $A^1$, $A^2$ et $A^3$ représentent, de manière identique ou différente pour chaque occurrence, O ou $NR^3$, les lignes en pointillés représentent les liaisons depuis les deux atomes de carbone du groupe Y sur les radicaux X du cycle aromatique ou hétéroaromatique dans la structure de la formule (1) ou de la formule (2), et $R^1$ et $R^3$ présentent la signification qui a été indiquée selon la revendication 1.

**10.** Formulation selon une ou plusieurs des revendications précédentes 1 à 8, **caractérisée en ce que** deux radicaux Y adjacents dans la structure de la formule (1) ou de la formule (2) forment une structure de cycle de l'une des formules qui suivent (4-A) à (4-F) :

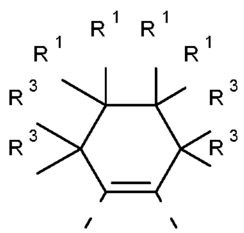

formule (4-A)

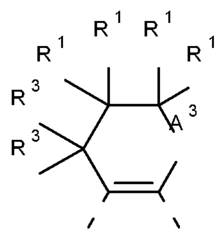

formule (4-B)

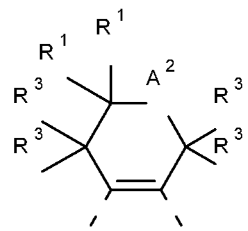

formule (4-C)

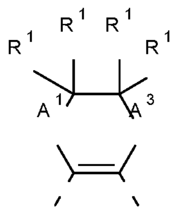

formule (4-D)

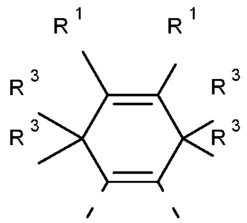

formule (4-E)

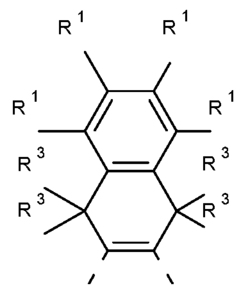

formule (4-F),

dans lesquelles $A^1$, $A^2$ et $A^3$ représentent, de manière identique ou différente pour chaque occurrence, O ou $NR^3$, les lignes en pointillés représentent les liaisons depuis les deux atomes de carbone du groupe Y sur les radicaux X du cycle aromatique ou hétéroaromatique dans la structure de la formule (1) ou de la formule (2), et $R^1$ et $R^3$ présentent la signification qui a été indiquée selon la revendication 1.

**11.** Formulation selon une ou plusieurs des revendications précédentes 1 à 8, **caractérisée en ce que** deux radicaux Y adjacents dans la structure de la formule (1) ou de la formule (2) forment une structure de cycle de l'une des formules qui suivent (5-A) à (5-E) :

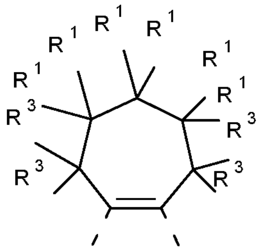

formule (5-A)

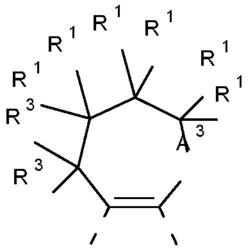

formule (5-B)

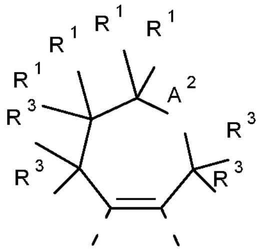

formule (5-C)

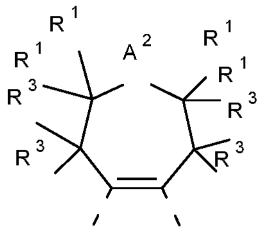

formule (5-D)

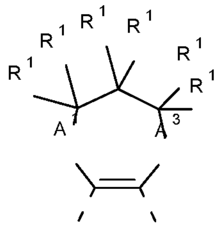

formule (5-E)

dans lesquelles $A^1$, $A^2$ et $A^3$ représentent, de manière identique ou différente pour chaque occurrence, O ou $NR^3$, les lignes en pointillés représentent les liaisons depuis les deux atomes de carbone du groupe Y sur les radicaux X du cycle aromatique ou hétéroaromatique dans la structure de la formule (1) ou de la formule (2), et $R^1$ et $R^3$ présentent la signification qui a été indiquée selon la revendication 1.

**12.** Formulation selon une ou plusieurs des revendications précédentes 1 à 8, **caractérisée en ce que** deux radicaux Y adjacents dans la structure de la formule (1) ou de la formule (2) forment une structure de cycle de l'une des formules qui suivent (6-A) à (6-C) :

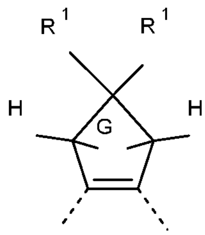

formule (6-A)

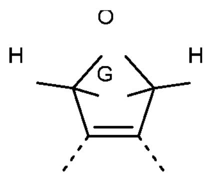

formule (6-B)

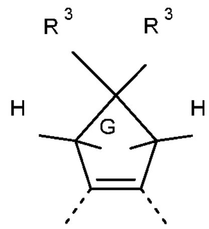

formule (6-C),

dans lesquelles les symboles qui sont utilisés présentent les significations qui ont été données selon la revendication 1 et les lignes en pointillés représentent les liaisons depuis les deux atomes de carbone du groupe Y sur les radicaux X du cycle aromatique ou hétéroaromatique dans la structure de la formule (1) ou de la formule (2).

**13.** Formulation selon une ou plusieurs des revendications précédentes 1 à 8, **caractérisée en ce que** deux radicaux Y adjacents dans la structure de la formule (1) ou de la formule (2) forment une structure de cycle de l'une des formules qui suivent (7-A), (8-A) ou (9-A) :

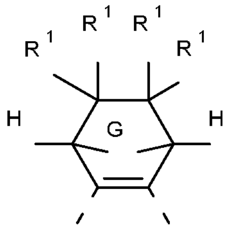

formule (7-A)

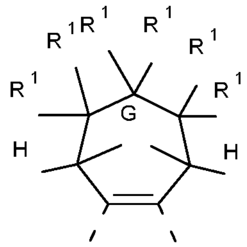

formule (8-A)

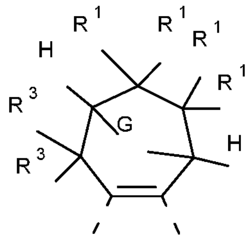

formule (9-A),

dans lesquelles les symboles qui sont utilisés présentent les significations qui ont été indiquées selon la revendication 1 ou 2 et les lignes en pointillés représentent les liaisons depuis deux atomes de carbone du groupe Y sur les radicaux X du cycle aromatique ou hétéroaromatique dans la structure de la formule (1) ou de la formule (2).

**14.** Formulation selon une ou plusieurs des revendications précédentes 1 à 9, **caractérisée en ce que** le composé aromatique qui présente une structure de la formule (1) ou (2) est sélectionné parmi les composés des formules (10), (11) et (12),

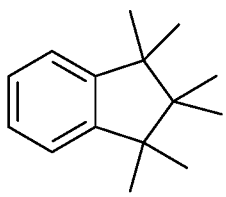

formule (10)

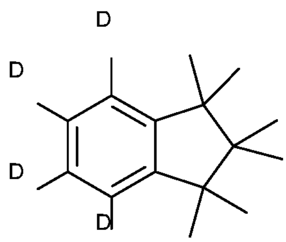

formule (11)

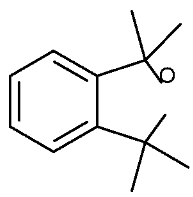

formule (12)

où le composé de la formule (10) est particulièrement préféré.

**15.** Procédé pour la fabrication d'un dispositif électroluminescent organique, comprenant l'application d'une formulation selon une ou plusieurs des revendications 1 à 14 sur un substrat et/ou sur une couche qui est appliquée indirectement ou directement sur un substrat.

**16.** Procédé selon la revendication 15, **caractérisé en ce que** la formulation est appliquée sur un substrat ou sur l'une des couches qui sont appliquées sur le substrat au moyen d'un revêtement par immersion, d'un revêtement par trempage, d'un revêtement par pulvérisation, d'un revêtement par centrifugation, d'une impression par écran, d'une impression en relief, d'une impression par gravure, d'une impression par moyens rotatifs, d'un revêtement au rouleau, d'une impression flexographique, d'une impression offset ou d'une impression par éjecteur(s), de préférence une impression par jet(s) d'encre.

Fig. 1

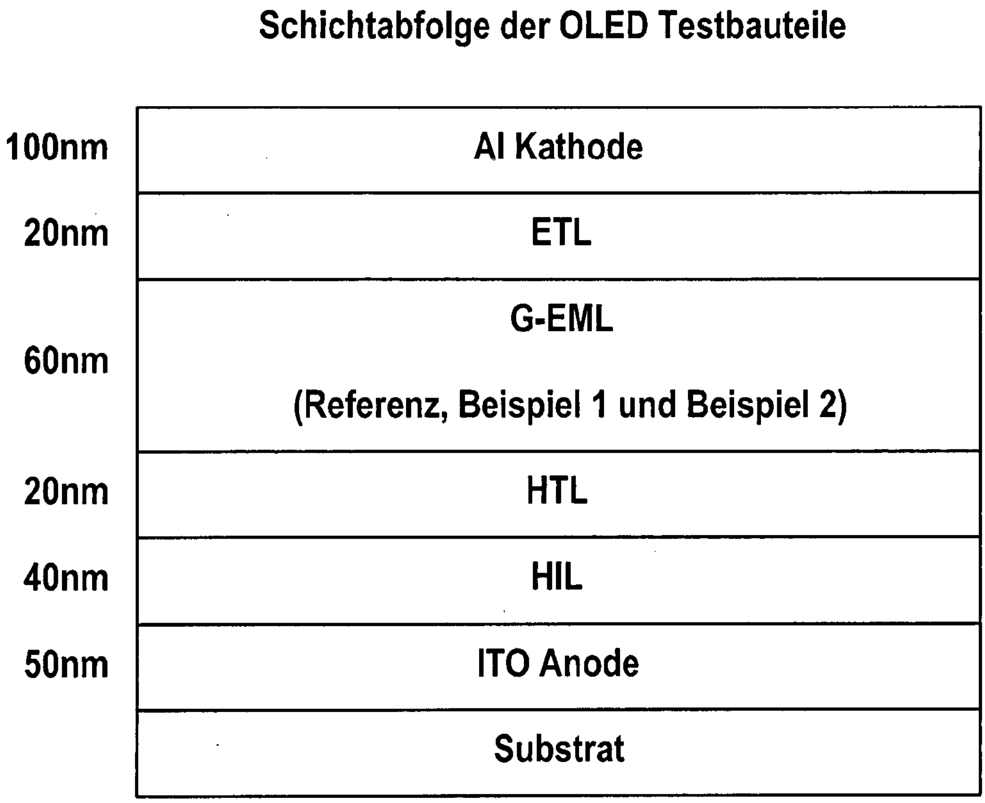
Schichtabfolge der OLED Testbauteile
100nm
Al Kathode
20nm
ETL
60nm
G-EML
(Referenz, Beispiel 1 und Beispiel 2)
20nm
HTL
40nm
HIL
50nm
ITO Anode
Substrat

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 9013148 A1
- WO 2009021107 A1
- WO 2013029733 A1
- EP 3069392 A1
- WO 2010006680 A1
- US 3615404 A
- US 3567450 A
- US 3526501 A
- JP 56046234 A
- EP 1009041 A
- US 3615402 A
- JP 54110837 A
- US 3717462 A
- JP 61210363 A
- US 4950950 A
- JP 2204996 A
- JP 2282263 A
- JP 632956965 A
- US 4720432 A
- US 4127412 A
- US 3180730 A
- US 3658520 A
- US 20080102311 A1
- US 5061569 A
- JP 4308688 A
- US 20070092755 A1
- EP 1162193 B1
- EP 650955 B1
- DE 19646119 A1
- WO 2006122630 A1
- EP 1860097 A1
- EP 1834945 A1
- JP 08053397 A
- US 6251531 B1
- US 20050221124 A
- JP 08292586 A
- US 7399537 B2
- US 20060061265 A1
- EP 1661888 A
- WO 2009041635 A
- EP 0891121 A1
- EP 1029909 A1
- US 20040174116 A1
- US 5529853 A
- US 4356429 A
- US 4539507 A
- US 20070273272 A1
- US 5766779 A
- DE 102008064200
- JP 2003115387 A
- JP 2004311184 A
- JP 2001267080 A
- WO 02043449 A
- EP 1480280 A
- EP 1478032 A
- EP 1469533 A
- US 20070087219 A1
- JP 2004200162 A
- US 20070252517 A1
- US 20070122656 A1
- US 20080193796 A1
- US 2006147747 A
- EP 1551206 A1
- WO 02068435 A1
- WO 02081488 A1
- EP 1239526 A2
- WO 2004026886 A2
- WO 2006122630 A
- WO 2008006449 A
- WO 2007140847 A
- WO 2006000388 A
- WO 2006058737 A
- WO 2006000389 A
- WO 2007065549 A
- WO 2007115610 A
- US 5121029 A
- US 7250532 B2
- DE 102005058557 A1
- CN 1583691 A
- JP 8053397 A
- EP 1957606 A1
- US 20080113101 A1
- US 2006210830 A
- DE 102008035413
- DE 102009005746
- US 4769292 A
- US 6020078 A
- US 20060222886 A1
- US 5130603 A
- US 20070092753 A1
- WO 0070655 A
- WO 0141512 A
- WO 0202714 A
- WO 0215645 A
- EP 1191613 A
- EP 1191612 A
- EP 1191614 A
- WO 2005033244 A

- US 20090061681 A1
- US 20010053462 A1
- US 6824895 B
- US 10729238 B
- US 6835469 B
- US 6830828 B
- US 7378162 B2
- US 6835469 B2
- JP 2003253145 A
- US 7238437 B2
- US 2009008607 A1
- EP 1348711 A
- WO 2011076314 A1
- EP 676461 A
- WO 2009069566 A
- WO 2004081017 A
- WO 2004058911 A
- WO 2005084081 A
- WO 2005084082 A
- WO 2006048268 A
- WO 2006117052 A
- WO 2008145239 A
- US 20030027016 A1
- US 7326371 B2
- US 2006043858 A
- WO 2007114358 A
- JP 3148176 B
- EP 1009044 A
- US 2004018383 A
- WO 2005061656 A1
- EP 0681019 B1
- WO 2004013073 A1
- US 5077142 A
- WO 2007065678 A
- WO 2005039246 A
- US 20050069729 A
- JP 2004288381 A
- EP 1205527 A
- WO 2008086851 A
- EP 1617710 A
- EP 1617711 A
- EP 1731584 A
- JP 2005347160 A
- WO 2004093207 A
- DE 102008033943
- WO 2005003253 A
- WO 2007137725 A
- WO 2005111172 A
- DE 102008017591
- DE 102008036982
- WO 2007063754 A
- WO 2008056746 A
- DE 102009023155
- DE 102009031021
- DE 102009022858
- US 20070134514 A1
- US 20070128467 A1
- US 20050249976 A1
- US 20040209115 A
- US 20040209116 A
- EP 652273 B1
- WO 2010108579 A
- WO 2004070772 A2
- WO 2004113468 A1
- WO 2005040302 A1
- WO 2005086251 A2
- WO 2012175535 A1
- WO 2012175219 A1
- WO 2012168358 A1
- WO 2012031735 A1
- EP 1837926 A1
- WO 2007107306 A1
- EP 2452946 A1
- EP 2463927 A1
- WO 2009000237 A1
- US 2007145355 A1
- EP 0637899 A1
- WO 2005011013 A


**In der Beschreibung aufgeführte Nicht-Patentliteratur**


- *Synth.Metals,* 1997, vol. 91 (1-3), 209
- **Y.A. LEVIN ; M.S. SKOROBOGATOVA.** *Khimiya Geterotsiklicheskikh Soedinenii,* 1967, vol. 2, 339-341
- **C.H.CHEN et al.** Recent developments in organic electroluminescent materials. *Macromol. Symp.,* 1997, vol. 125, 1-48
- Recent progress of molecular organic electroluminescent materials and devices. *Mat. Sci. and Eng. R,* 2002, vol. 39, 143-222
- **BALDO, THOMPSON et al.** *Nature,* 2000, vol. 403, 750-753
- **ADACHI et al.** *Appl. Phys. Lett.,* 2001, vol. 78, 1622-1624
- **J.KIDO et al.** *Appl. Phys. Lett.,* 1994, vol. 65, 2124
- **KIDO et al.** *Chem. Lett.,* 1990, vol. 657
- **JOHNSON et al.** *JACS,* 1983, vol. 105, 1795
- **WRIGHTON.** *JACS,* 1974, vol. 96, 998
- **MA et al.** *Synth. Metals,* 1998, vol. 94, 245
- *Inorg. Chem.,* 2001, vol. 40 (7), 1704-1711
- *JACS,* 2001, vol. 123 (18), 4304-4312
- **H. GILMAN ; E.A. ZUECH.** *Chemistry & Industry,* 1960, 120
- **T. MATSUMOTO ; T. NAKADA ; J. ENDO ; K. MORI ; N. KAWAMURA ; A. YOKOI ; J. KIDO.** Multiphoton Organic EL Device Having Charge Generation Layer. *Charge-Generation Layers, IDMC 2003,* 2003